(19)

**Europäisches Patentamt**
**European Patent Office**
**Office européen des brevets**

(11) **EP 4 768 623 A1**

(12) **EUROPEAN PATENT APPLICATION**

(43) Date of publication:
**01.07.2026 Bulletin 2026/27**

(21) Application number: **25216482.7**

(22) Date of filing: **17.11.2025**

(51) International Patent Classification (IPC):
**C23C 14/04** *(2006.01)*

(52) Cooperative Patent Classification (CPC):
**C23C 14/042; G03F 1/42; H10K 71/00; H10K 71/166**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **23.12.2024 KR 20240194116**

(71) Applicant: **Samsung Display Co., Ltd.**
**Yongin-si, Gyeonggi-do 17113 (KR)**

(72) Inventors:
• **JO, Jun Ho**
  **17113 Yongin-si (KR)**
• **KIM, Jeong Kuk**
  **17113 Yongin-si (KR)**
• **LEE, Duck Jung**
  **17113 Yongin-si (KR)**
• **LEE, Yeon Woo**
  **17113 Yongin-si (KR)**
• **JUNG, Ji Hyun**
  **17113 Yongin-si (KR)**

(74) Representative: **Taor, Simon Edward William**
**Venner Shipley LLP**
**TIDE Bankside**
**8 Emerson Street**
**London SE1 9DU (GB)**

(54) **DEPOSITION MASK, METHOD OF MANUFACTURING THE SAME, DEPOSITION APPARATUS INCLUDING THE SAME, DISPLAY PANEL MANUFACTURED BY USING THE SAME, AND ELECTRONIC DEVICE MANUFACTURED BY USING THE SAME**

(57) A deposition mask may include a mask substrate having a cell opening, a membrane on (e.g., disposed on) the mask substrate and having pixel openings communicating with the cell opening, and a mask alignment key on (e.g., disposed on) the mask substrate. The mask alignment key may include a pattern region and a peripheral region around (e.g., surrounding) the pattern region, and the pattern region may include a surface modified region having a greater surface roughness than the peripheral region.

**Description**

**CROSS-REFERENCE TO RELATED APPLICATION**

The present application claims priority to and the benefit of Korean Patent Application No. 10-2024-0194116, filed on December 23, 2024, in the Korean Intellectual Property Office.

**BACKGROUND**

**1. Field**

The present disclosure relates to a deposition mask, a method of manufacturing the same, a deposition apparatus including the same, a display panel manufactured by utilizing the same, and an electronic device manufactured by utilizing the same.

**2. Description of the Related Art**

Wearable devices in the form of glasses or helmets that focus images at a short distance in front of the user's eyes have been developed. For example, such wearable devices may include head mounted displays (HMDs) and/or augmented reality (AR) glasses. These devices may provide augmented reality (AR) and/or virtual reality (VR) visual experiences to users.

In order for users to comfortably utilize wearable devices such as HMDs or AR glasses for extended periods without experiencing dizziness, display resolutions of approximately (about) 3,000 pixels per inch (PPI) or higher are desired or even required. To meet this demand, organic light emitting diode on silicon (OLEDoS) technology has emerged as a promising solution. OLEDoS involves forming organic light emitting diodes (OLEDs) on a semiconductor substrate that includes complementary metal oxide semiconductor (CMOS) elements..

To manufacture a display panel with a resolution of approximately (about) 3,000 PPI or higher, a high-resolution deposition mask is desired or even required. For example, such a deposition mask may be fabricated by forming a membrane with a plurality of pixel openings on a substrate, such as a silicon wafer, and then partially removing the substrate to form cell openings that expose the pixel openings..

During the deposition process for forming light emitting layers of the display panel, a backplane substrate may be arranged or positioned on the deposition mask. A vapor deposition material from a deposition source may then be deposited onto the backplane substrate through the pixel openings of the deposition mask. A substrate alignment key may be formed on the backplane substrate, and a mask alignment key may be formed on the deposition mask. A camera may be utilized to obtain location information of the substrate and mask alignment keys, and the backplane substrate may be aligned with the deposition mask based on this information..

**SUMMARY**

One or more aspects of the present disclosure are directed towards a deposition mask including a mask alignment key whose recognition rate is improved, a method of manufacturing the same, a deposition apparatus including the same, a display panel manufactured by utilizing the same, and an electronic device manufactured by utilizing the same.

However, one or more embodiments of the present disclosure are not limited to those set forth herein. The one or more embodiments of the present disclosure will become more apparent to one of ordinary skill in the art to which the present disclosure pertains by referencing the detailed description of the present disclosure.

In one or more embodiments of the present disclosure, a deposition mask may include a mask substrate having a cell opening, a membrane arranged on the mask substrate and having pixel openings communicating with the cell opening, and a mask alignment key arranged on the mask substrate. The mask alignment key may include a pattern region and a peripheral region around (e.g., surrounding) the pattern region, and the pattern region may include a surface modified region having a greater surface roughness than the peripheral region.

In one or more embodiments, the pattern region may have a recess formed in a surface portion of the mask substrate, and the surface modified region may be formed in a bottom surface portion of the recess.

In one or more embodiments, the recess may have a width that gradually decreases from a surface of the mask substrate toward the surface modified region.

In one or more embodiments, the deposition mask may further include an intermediate inorganic film arranged between the mask substrate and the membrane. The intermediate inorganic film may have a key opening exposing the pattern region.

In one or more embodiments, the surface roughness of the surface modified region may be in a range of about 50 nm to about 1 $\mu$m.

In accordance with some embodiments, the membrane may include a passivation region arranged on the pattern region.

In one or more embodiments, the deposition mask may further include a passivation film arranged on the mask substrate and the mask alignment key. The membrane may be arranged on the passivation film.

In one or more embodiments, the mask substrate may have a key opening exposing the mask alignment key.

In one or more embodiments, the mask alignment key may include a surface layer of the mask substrate including the pattern region and the peripheral region, and the key opening may be configured to expose the surface layer.

In one or more embodiments, the surface layer may include an etch-stop region having a greater area than the key opening, and the key opening may be configured to expose the etch-stop region.

In one or more embodiments, the etch-stop region may include one or more selected from among Group III impurities.

In one or more embodiments of the present disclosure, the deposition mask may further include an intermediate inorganic film arranged between the mask substrate and the membrane. The pattern region may have a recess formed in a surface portion of the intermediate inorganic film, and the surface modified region may be formed in a bottom surface portion of the recess.

In one or more embodiments, the deposition mask may further include an etch-stop region formed in a surface layer of the mask substrate. The mask substrate may have a key opening exposing the etch-stop region.

In one or more embodiments, the pattern region may have a recess formed in a surface portion of the membrane, and the surface modified region may be formed in a bottom surface portion of the recess.

In one or more embodiments, the deposition mask may further include a passivation film arranged on the membrane and the mask alignment key.

In one or more embodiments, the mask substrate may have a key opening exposing the mask alignment key.

In one or more other embodiments of the present disclosure, a deposition mask may include a mask substrate having a cell opening, a membrane arranged on the mask substrate and having pixel openings communicating with the cell opening, and a mask alignment key arranged on the mask substrate. The mask alignment key may include a pattern region having at least one recess formed in a surface portion of the mask substrate and a peripheral region around (e.g., surrounding) the pattern region, and the at least one recess may be defined by inclined inner side surfaces connected to each other.

In one or more other embodiments of the present disclosure, a method of manufacturing a deposition mask may include forming a mask alignment key on a mask substrate, forming a membrane on the mask substrate, the membrane having pixel openings, and forming cell openings through the mask substrate, the cell openings communicating with the pixel openings. The mask alignment key may include a pattern region and a peripheral region around (e.g., surrounding) the pattern region, and the pattern region may include a surface modified region having a greater surface roughness than the peripheral region.

In one or more embodiments, the forming of the mask alignment key may include forming the pattern region in a surface portion of the mask substrate. The forming of the pattern region may include forming a recess in the surface portion of the mask substrate, and forming the surface modified region in a bottom surface portion of the recess.

In one or more embodiments, the recess and the surface modified region may be formed by a reactive ion etching process.

In one or more embodiments, the reactive ion etching process may include forming a polymer layer by utilizing a passivation gas, partially removing the polymer layer by utilizing a sputtering gas, and removing the surface portion of the mask substrate by utilizing a reactive gas.

In one or more embodiments, the partial removing of the polymer layer may be performed for a shorter time than the forming of the polymer layer and the removing of the surface portion of the mask substrate.

In one or more embodiments, the partial removing of the polymer layer may be performed to partially remain the polymer layer on the pattern region.

In one or more embodiments, the recess and the surface modified region may be formed by a metal-assisted chemical etching process.

In one or more embodiments, the metal-assisted chemical etching process may be performed by utilizing an etchant including metal catalyst particles.

In one or more embodiments, the recess may be formed to have a width that gradually decreases from a surface of the mask substrate toward the surface modified region.

In one or more embodiments, the method may further include forming an intermediate inorganic film on the mask substrate, and forming a key opening by partially removing the intermediate inorganic film, the key opening exposing the pattern region.

In one or more embodiments, the pattern region may have a recess formed in a surface portion of the mask substrate, the surface modified region may be formed in a bottom surface portion of the recess, and the recess and the surface modified region may be formed by a metal-assisted chemical etching process utilizing the intermediate inorganic film as an etching mask.

In one or more embodiments, the membrane may include a passivation region on the mask alignment key.

In one or more embodiments, the method may further include forming a passivation film on the mask substrate and the mask alignment key, and the membrane may be on the passivation film.

In one or more embodiments, the method may further include forming a key opening by partially removing the mask substrate, the key opening exposing the mask alignment key.

In one or more embodiments, the mask alignment key may include a surface layer of the mask substrate including the pattern region and the peripheral region, and the key opening may be formed to expose the surface layer.

In one or more embodiments, the method may further include forming an etch-stop region in the surface layer, the etch-stop region having a greater area than the key opening, and the key opening may be formed to expose the etch-stop region.

In one or more embodiments, the etch-stop region may be formed by an ion implantation process, and may include one or more selected from among Group III impurities.

In one or more embodiments, the method may further include forming an intermediate inorganic film on the mask substrate, and the forming of the mask alignment key may include forming the surface modified region by partially removing the intermediate inorganic film.

In one or more embodiments, the method may further include forming an etch-stop region in a surface layer of the mask substrate, the etch-stop region overlapping the mask alignment key, and forming a key opening by partially removing the mask substrate, the key opening exposing the etch-stop region.

In one or more embodiments, the forming of the mask alignment key may include forming the surface modified region by partially removing the membrane.

In one or more embodiments, the method may further include forming a passivation film on the membrane and the mask alignment key.

In one or more other embodiments of the present disclosure, a method may include forming a mask alignment key on a mask substrate, forming a membrane on the mask substrate, the membrane having pixel openings, and forming cell openings through the mask substrate, the cell openings communicating with the pixel openings. The mask alignment key may include a pattern region having at least one recess formed in a surface portion of the mask substrate and a peripheral region around (e.g., surrounding) the pattern region, and the at least one recess may be defined by inclined inner side surfaces connected to each other. The method may be a method for manufacturing a deposition mask.

In one or more other embodiments of the present disclosure, a deposition apparatus may include a deposition source providing a deposition material, a substrate chuck supporting a substrate to face the deposition source, a mask chuck arranged between the deposition source and the substrate chuck and supporting a deposition mask to face the substrate. The deposition mask may include a mask substrate having a cell opening, a membrane arranged on the mask substrate and having pixel openings communicating with the cell opening, and a mask alignment key arranged on the mask substrate. The mask alignment key may include a pattern region and a peripheral region around (e.g., surrounding) the pattern region, and the pattern region may include a surface modified region having a greater surface roughness than the peripheral region.

In one or more embodiments, the deposition apparatus may further include an illumination portion providing light capable of transmitting the substrate and the deposition mask, and a camera detecting light transmitted through the substrate and the deposition mask.

In one or more embodiments, the deposition apparatus may further include an illumination portion providing light onto the substrate through the deposition mask, and a camera detecting light reflected from the substrate and transmitted through the deposition mask.

In one or more other embodiments of the present disclosure, a display panel may include a substrate, and a plurality of light emitting layers on the substrate by utilizing a deposition mask. The deposition mask may include a mask substrate having a cell opening, a membrane arranged on the mask substrate and having pixel openings communicating with the cell opening, and a mask alignment key arranged on the mask substrate. The mask alignment key may include a pattern region and a peripheral region around (e.g., surrounding) the pattern region, and the pattern region may include a surface modified region having a greater surface roughness than the peripheral region.

In one or more other embodiments of the present disclosure, an electronic device may include a display panel. The display panel may include a substrate and a plurality of light emitting layers on the substrate by utilizing a deposition mask. The deposition mask may include a mask substrate having a cell opening, a membrane arranged on the mask substrate and having pixel openings communicating with the cell opening, and a mask alignment key arranged on the mask substrate. The mask alignment key may include a pattern region and a peripheral region around (e.g., surrounding) the pattern region, and the pattern region may include a surface modified region having a greater surface roughness than the peripheral region.

In one or more embodiments, the electronic device may further include at least one selected from among a processor, a memory, and/or a power module (e.g., a power supply).

According to an aspect, there is provided a deposition mask as set out in claim 1. Additional features are set out in claims 2 to 11. According to an aspect, there is provided a deposition mask as set out in claim 12. According to an aspect, there is provided a method as set out in claim 13. According to an aspect, there is provided an electronic device as set out in claim 14. Additional features are set out in claim 15.

According to one or more embodiments of the present disclosure as described above, a mask alignment key may include a surface modified region formed by an etching process. Light incident on the surface modified region may be scattered and/or refracted by the surface modified region, and accordingly, the surface modified region may be more clearly displayed in an image of the mask alignment key obtained by a camera. As a result, a recognition rate of the mask alignment key may be significantly improved. For example, by forming the surface modified region utilizing a metal assisted chemical etching process in conjunction with an intermediate inorganic film as an etching mask, the resulting surface topology may be precisely controlled to achieve enhance optical scattering characteristics. This enables enhanced contrast between the pattern region and the surrounding peripheral region when imaged under various lighting conditions, such as backlighting and/or reflected illumination. Consequently, the alignment accuracy between the deposition mask and the substrate during the deposition process may be improved, thereby contributing to higher resolution and yield in the fabrication of display panels, e.g., those requiring ultra-fine pixel arrangements such as OLEDoS-based microdisplays.

Other features and embodiments may be apparent from the following detailed description and the drawings.

## BRIEF DESCRIPTION OF THE DRAWINGS

The above and other aspects and features of the present disclosure will become more apparent by describing in more detail embodiments thereof with reference to the attached drawings, in which:

FIG. 1 is a block diagram of an electronic device according to one or more embodiments of the present disclosure;

FIG. 2 is a schematic diagram of an electronic device according to one or more suitable embodiments of the present disclosure;

FIG. 3 is an exploded perspective view illustrating a display device according to one or more embodiments of the present disclosure;

FIG. 4 is a block diagram illustrating the display device shown in FIG. 3;

FIG. 5 is an equivalent circuit diagram illustrating an example of a first sub-pixel shown in FIG. 4;

FIG. 6 is a schematic plan view illustrating an example of a display panel shown in FIG. 3;

FIG. 7 is a schematic enlarged plan view illustrating an example of a display area shown in FIG. 6;

FIG. 8 is a schematic enlarged plan view illustrating another example of the display area shown in FIG. 6;

FIG. 9 is a schematic cross-sectional view illustrating an example of the display panel taken along the line l1-l1' shown in FIG. 7;

FIG. 10 is a schematic cross-sectional view illustrating another example of the display panel taken along the line l1-l1' shown in FIG. 7;

FIG. 11 is a schematic cross-sectional view illustrating still another example of the display panel taken along the line l1-l1' shown in FIG. 7;

FIG. 12 is a schematic perspective view illustrating one example of a head mounted display;

FIG. 13 is a schematic exploded perspective view illustrating the head mounted display shown in FIG. 12;

FIG. 14 is a schematic perspective view illustrating another example of a head mounted display;

FIG. 15 is a schematic view for describing a deposition apparatus according to one or more embodiments of the present disclosure;

FIG. 16 is a schematic bottom view for describing a backplane substrate illustrated in FIG. 15;

FIG. 17 is a schematic plan view for describing a deposition mask illustrated in FIG. 15;

FIG. 18 is a schematic enlarged plan view for describing mask cell regions illustrated in FIG. 17;

FIG. 19 is a schematic cross-sectional view taken along the line l2-l2' illustrated in FIG. 18;

FIG. 20 is a schematic front view for describing a substrate chuck and a mask chuck illustrated in FIG. 15;

FIG. 21 is a schematic bottom view for describing a substrate alignment key illustrated in FIG. 16;

FIG. 22 is a schematic cross-sectional view for describing the mask alignment key illustrated in FIG. 17;

FIG. 23 is a schematic plan view for describing the mask alignment key illustrated in FIG. 17;

FIG. 24 is a schematic cross-sectional view for describing a camera and an illumination portion illustrated in FIG. 15;

FIG. 25 is a schematic view for describing an image obtained by the camera illustrated in FIG. 24;

FIG. 26 is a schematic enlarged cross-sectional view for describing a pattern region illustrated in FIG. 22;

FIGS. 27 - 29 are schematic enlarged cross-sectional views for describing a method of forming a recess and a surface modified region illustrated in FIG. 26;

FIG. 30 is a schematic enlarged cross-sectional view for describing another example of the pattern region illustrated in FIG. 26;

FIG. 31 is a schematic enlarged cross-sectional view for describing another example of the pattern region illustrated in FIG. 26;

FIG. 32 is a schematic enlarged cross-sectional view for describing another example of the pattern region illustrated in FIG. 26;

FIG. 33 is a schematic cross-sectional view for describing another example of the deposition mask illustrated in FIG. 22;

FIG. 34 is a schematic cross-sectional view for describing another example of the deposition mask illustrated in FIG. 22;

FIG. 35 is a schematic cross-sectional view for describing another example of the deposition mask illustrated in FIG. 22;

FIG. 36 is a schematic cross-sectional view for describing another example of the camera and the illumination portion illustrated in FIG. 24;

FIG. 37 is a schematic cross-sectional view for describing another example of the mask alignment key illustrated in FIG. 22;

FIG. 38 is a schematic cross-sectional view for describing another example of the mask alignment key illustrated in FIG. 22; and
FIGS. 39 - 45 are schematic cross-sectional views for describing a method of manufacturing a deposition mask, according to one or more embodiments of the present disclosure.

## DETAILED DESCRIPTION

The present disclosure will now be described more fully hereinafter with reference to the accompanying drawings, in which one or more suitable embodiments of the disclosure are shown. The present disclosure may, however, be embodied in different forms and should not be construed as limited to the one or more embodiments set forth herein. Rather, these embodiments are provided so that the present disclosure will be thorough and complete, and will fully convey the scope of the disclosure to those skilled in the art.

It will also be understood that if (e.g., when) a component (e.g., an element, an area, a layer, a part, a portion, a region, and/or the like) is referred to as being "on," "formed on," "disposed on," "connected to," "connected with," or "coupled to" another component, the component may be directly on, formed on, disposed on, connected to, connected with, or coupled to the other component and/or indirectly on, formed on, disposed on, connected to, connected with, or coupled to the other component with an intervening component therebetween. For example, in the specification, if (e.g., when) a component is electrically connected to another component, the component may be directly electrically connected thereto and/or may be indirectly electrically connected thereto with an intervening component therebetween. However, "directly connected/directly coupled" refers to one component directly connecting or coupling another component without any intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present. The same reference numbers indicate the same components throughout the specification.

It will be understood that, although the terms "first," "second," and/or the like may be used herein to describe one or more suitable elements, these elements should not be limited by these terms. These terms are only used to distinguish one element from another element. For instance, a first element discussed could be termed a second element without departing from the teachings of the disclosure. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both (e.g., simultaneously) the singular and plural, unless the context clearly indicates otherwise. For example, "an element" has the same meaning as "at least one element," unless the context clearly indicates otherwise. "At least one" is not to be construed as limiting "a" or "an." "Or" refers to "and/or." As used herein, the term "and/or" may include any and all combinations of one or more of the associated listed items. It will be further understood that the terms "comprise/include/have," "comprises/includes/has," and/or "comprising/including/having," if (e.g., when) used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the drawings is turned over, elements described as being on the "lower" side of other elements would then be oriented on "upper" sides of the other elements. The term "lower," may therefore, encompasses both (e.g., simultaneously) an orientation of "lower" and "upper," depending on the particular orientation of the drawing. Similarly, if the device in one of the drawings is turned over, elements described as "below" or "beneath" other elements would then be oriented "above" the other elements. The terms "below" or "beneath" may, therefore, encompass both (e.g., simultaneously) an orientation of above and.

Features of each of one or more suitable embodiments of the disclosure may be partially or entirely combined with each other and may technically suitably interwork with each other, and respective embodiments may be implemented independently of each other or may be implemented together in association with each other.

"About" or "approximately" as used herein is inclusive of the stated value and refers to within an acceptable range of deviation for the particular value as determined by one of ordinary skill in the art, considering the measurement in question and the error associated with measurement of the particular quantity (e.g., the limitations of the measurement system). For example, "about" may refer to within one or more standard deviations, or within $\pm$ 30%, 20%, 10% or 5% of the stated value. Also, it should be understood that, even if the terms "about," "approximately," or "substantially" are not expressly recited in a given claim element, the scope of such claim element is intended to include variations that are insubstantial or within the understanding of one of ordinary skill in the art. For example, numerical values and ranges provided herein are intended to include tolerances and measurement uncertainties that would be recognized by those skilled in the art, and the claims should be construed accordingly to encompass such equivalents.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that may be consistent with their meaning in the context of the relevant art and the present disclosure, and will not be interpreted in an idealized or overly formal sense unless expressly so defined herein.

Example embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the drawings are schematic in nature and their shapes are not intended to illustrate the precise shape of a region and are not intended to limit the scope of the present claims and equivalent thereof.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

In this context, "consisting essentially of" indicates that any additional components will not materially affect the chemical, physical, optical or electrical properties of the semiconductor film.

Further, in this specification, the phrase "on a plane," or "plan view," indicates viewing a target portion from the top, and the phrase "on a cross-section" indicates viewing a cross-section formed by vertically cutting a target portion from the side.

In the present disclosure, the term "combination thereof" may refer to a mixture, a stack, a composite, a copolymer, an alloy, a blend, and/or a reaction product.

Hereinafter, embodiments will be described in more detail with reference to the accompanying drawings.

The display device according to one or more embodiments of the present disclosure may be applied to one or more suitable electronic devices. The electronic device according to the one or more embodiments of the present disclosure may include the display device described above, and may further include modules and/or devices having additional functions in addition to the display device.

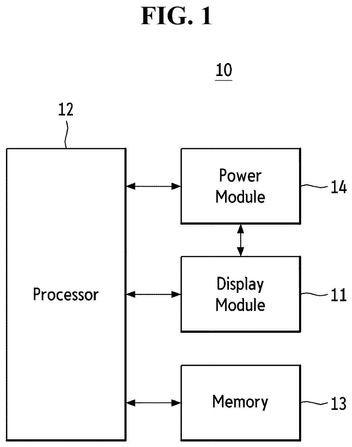

FIG. 1 is a block diagram of an electronic device according to one or more embodiments of the present disclosure.

Referring to FIG. 1, the electronic device 10 according to one or more embodiments of the present disclosure may include a display module 11 (e.g., a display), a processor 12, a memory 13, and a power module 14 (e.g., a power supply).

The processor 12 may include at least one selected from among a central processing unit (CPU), an application processor (AP), a graphic processing unit (GPU), a communication processor (CP), an image signal processor (ISP), and a controller.

The memory 13 may store data information for the operation of the processor 12 or the display module 11 (e.g., data information that may be required for operating the processor 12 or the display module 11). If (e.g., when) the processor 12 executes an application stored in the memory 13, an image data signal and/or an input control signal may be transmitted to the display module 11, and the display module 11 may process the received signal and output image information through a display screen.

The power module 14 may include a power supply device/module such as, for example a power adapter or a battery, and a power conversion device/module that converts the power supplied by the power supply device/module to generate power for the operation of the electronic device 10 (e.g., power that may be required for operating the electronic device 10).

At least one selected from among the components of the electronic device 10 according to the one or more embodiments of the present disclosure may be included in the display device 20 according to the one or more embodiments of the present disclosure. In addition, some devices/modules of the individual devices/-modules functionally included in one device/module may be included in the display device 20, and other devices/-modules may be provided separately from the display device 10. For example, the display device 20 may include the display module 11, and the processor 12, the memory 13, and/or the power module 14 may be provided in the form of other devices within the electronic device 10 other than the display device 20.

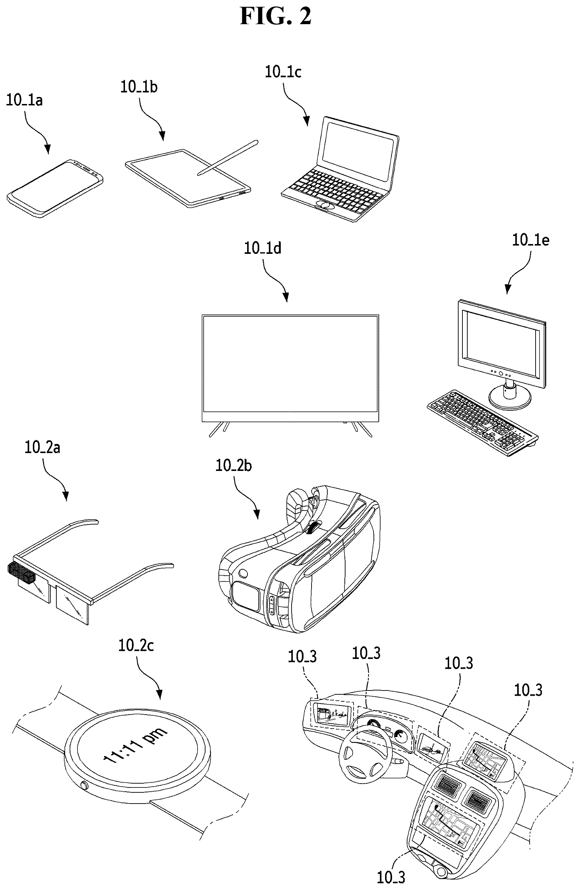

FIG. 2 is a schematic diagram of an electronic device according to one or more suitable embodiments of the present disclosure.

Referring to FIG. 2, one or more suitable electronic devices to which display devices 20 according to one or more embodiments of the present disclosure are applied may include not only image display electronic devices such as a smart phone 10_1a, a tablet PC (personal computer) 10_1b, a laptop 10_1c, a TV 10_1d, and/or a desk monitor 10_1e, but also wearable electronic devices including display devices/modules (circuits) such as, for example smart glasses 10_2a, a head mounted display 10_2b, and a smart watch 10_2c, and/or vehicle electronic devices 10_3 including display devices/modules such as a CID (Center Information Display) and/or a room mirror display arranged on a dashboard, center fascia, and/or dashboard of an automobile.

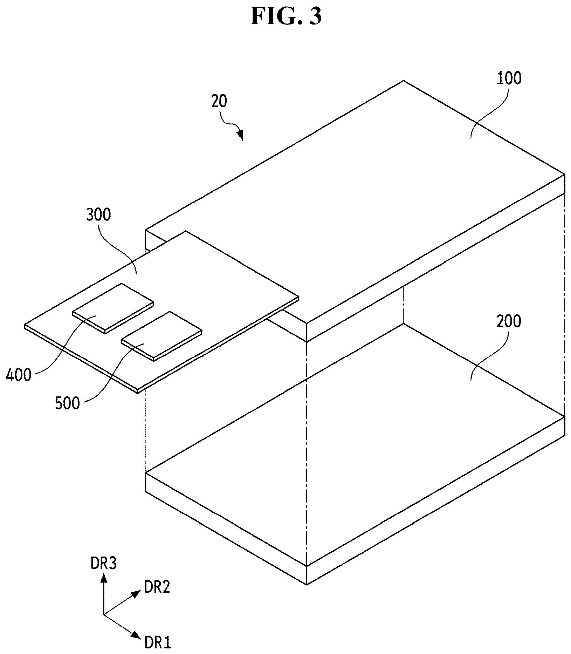

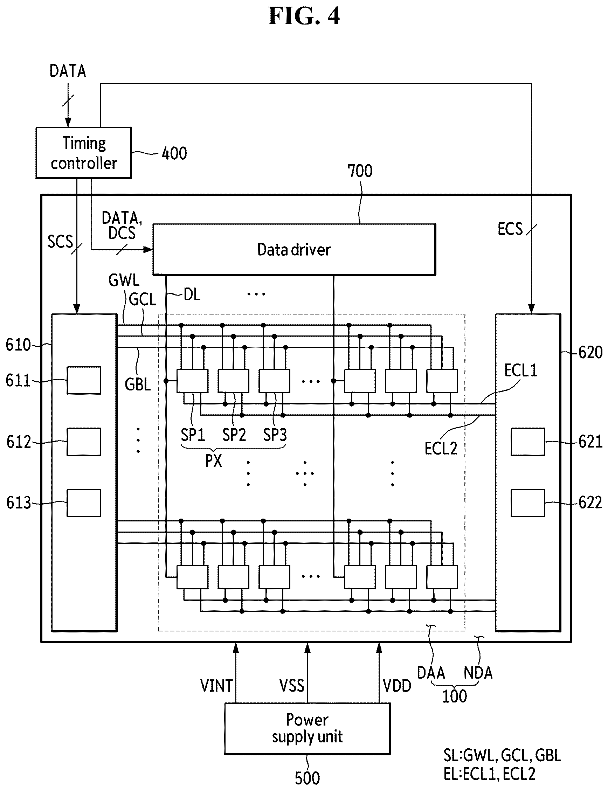

FIG. 3 is an exploded perspective view illustrating a display device according to one or more embodiments of the present disclosure. FIG. 4 is a block diagram illustrating the display device shown in FIG. 3.

Referring to FIGS. 3 and 4, a display device 20 according to one or more embodiments may be a device displaying a moving image and/or a still image. A display device 20 according to one or more embodiments may be utilized as the electronic device 10 or the display module 11 of the electronic device 10. For example, the display device 20 according to one or more embodiments may be applied to portable electronic devices 10 such as a mobile phone, a smartphone, a tablet personal computer, a mobile communication terminal, an electronic organizer, an electronic book, a portable multimedia player (PMP), a navigation system, an ultra mobile PC (UMPC), and/or the like. The display device 20 according to one or more embodiments may be applied as a display module 11 of electronic devices 10 such as a television, a laptop, a monitor, a billboard, or an Internet-of-Things (IoT) terminal, and/or the like. The display device 20 according to one or more embodiments may be applied to electronic devices 10 such as a smart watch, a watch phone, a head mounted display (HMD) for implementing virtual reality and augmented reality, and/or the like.

The display device 20 according to one or more embodiments may include a display panel 100, a heat dissipation layer 200, a circuit board 300, a timing control circuit 400, and/or a power supply circuit 500.

The display panel 100 may have a planar shape similar to a quadrilateral shape. For example, the display panel 100 may have a planar shape similar to a quadrilateral shape, having a short side of a first direction DR1 and a long side of a second direction DR2 intersecting the first direction DR1. In the display panel 100, a corner where a short side in the first direction DR1 and a long side in the second direction DR2 meet may be right-angled or rounded with a set or predetermined curvature. The planar shape of the display panel 100 is not limited to a quadrilateral shape, and may be a shape similar to another polygonal shape, a circular shape, or an elliptical shape. The planar shape of the display device 20 may conform to the planar shape of the display panel 100, but embodiments of the present disclosure are not limited thereto.

The display panel 100 may include a plurality of pixels PX, a plurality of scan lines SL, a plurality of emission control lines EL, a plurality of data lines DL, a scan driver 610, an emission driver 620, and/or a data driver 700. The display panel 100 may be divided into a display area DAA displaying an image and a non-display area NDA not displaying an image as shown in FIG. 4.

The plurality of pixels PX may be arranged in the display area DAA. The plurality of pixels PX may be arranged in a matrix form along the first direction DR1 and the second direction DR2. The plurality of scan lines SL and the plurality of emission control lines EL may be to extend in the first direction DR1, while being arranged in the second direction DR2. The plurality of data lines DL may be to extend in the second direction DR2, while being arranged in the first direction DR1.

The plurality of scan lines SL may include a plurality of write scan lines GWL, a plurality of control scan lines GCL, and/or a plurality of bias scan lines GBL. The plurality of emission control lines EL may include a plurality of first emission control lines ECL1 and/or a plurality of second emission control lines ECL2.

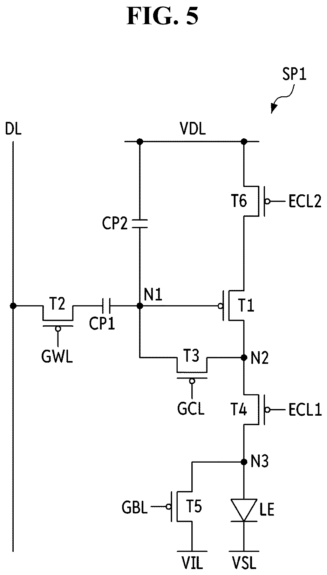

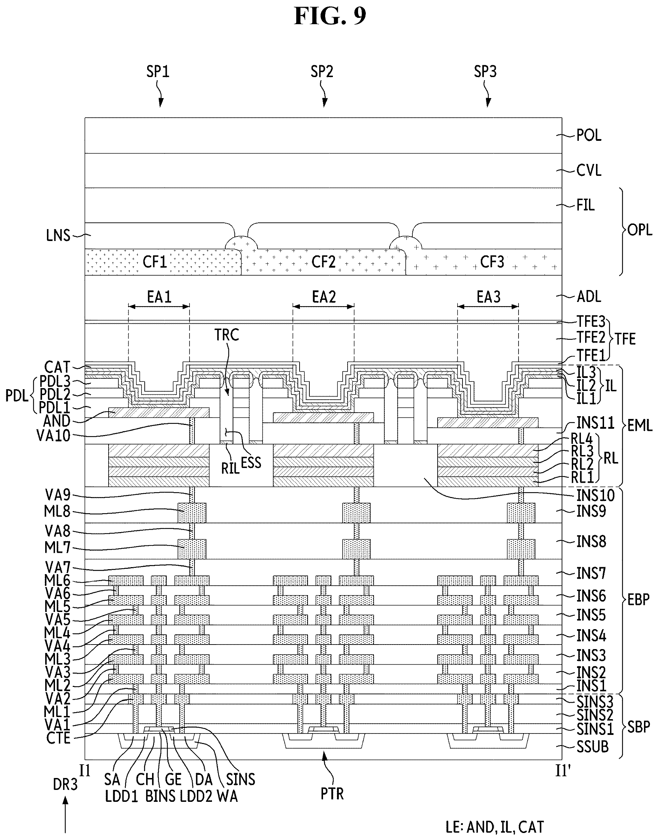

The plurality of pixels PX may include a plurality of sub-pixels SP1, SP2, and SP3. The plurality of sub-pixels SP1, SP2, and SP3 may include a plurality of pixel transistors as shown in FIG. 5, and the plurality of pixel transistors may be formed by a semiconductor process and arranged on a semiconductor substrate SSUB (see FIG. 9). For example, the plurality of pixel transistors of the data driver 700 may include (e.g., be formed of) complementary metal oxide semiconductor (CMOS), but embodiments of the present disclosure are not limited thereto.

Each of the plurality of sub-pixels SP1, SP2, and SP3 may be connected to one write scan line GWL, one control scan line GCL, one bias scan line GBL, one first emission control line ECL1, one second emission control line ECL2, and/or one data line DL. Each of the plurality of sub-pixels SP1, SP2, and SP3 may receive a data voltage of the data line DL in response to a write scan signal of the write scan line GWL, and be to emit light from the light emitting element according to the data voltage.

The scan driver 610, the emission driver 620, and/or the data driver 700 may be arranged in the non-display area NDA.

The scan driver 610 may include a plurality of scan transistors, and the emission driver 620 may include a plurality of light emitting transistors. The plurality of scan transistors and the plurality of light emitting transistors may be on (e.g., formed on) the semiconductor substrate SSUB (see FIG. 9) through a semiconductor process. For example, the plurality of scan transistors and the plurality of light emitting transistors may include (e.g., be formed of) CMOS, but embodiments of the present disclosure are not limited thereto.

The scan driver 610 may include a write scan signal output unit 611, a control scan signal output unit 612, and/or a bias scan signal output unit 613. Each of the write scan signal output unit 611, the control scan signal output unit 612, and/or the bias scan signal output unit 613 may receive a scan timing control signal SCS from the timing control circuit 400. The write scan signal output unit 611 may generate write scan signals according to the scan timing control signal SCS of the timing control circuit 400 and output them sequentially to the write scan lines GWL. The control scan signal output unit 612 may generate control scan signals in response to the scan timing control signal SCS and sequentially output them to the control scan lines GCL. The bias scan signal output unit 613 may generate bias scan signals according to the scan timing control signal SCS and output them sequentially to the bias scan lines GBL.

The emission driver 620 may include a first emission control driver 621 and a second emission control driver 622. Each of the first emission control driver 621 and the second emission control driver 622 may receive an emission timing control signal ECS from the timing control circuit 400. The first emission control driver 621 may generate first emission control signals according to the emission timing control signal ECS and sequentially output them to the first emission control lines ECL1. The second emission control driver 622 may generate second emission control signals according to the emission timing control signal ECS and sequentially output them to the second emission control lines ECL2.

The data driver 700 may include a plurality of data transistors, and the plurality of data transistors may be on (e.g., formed on) the semiconductor substrate SSUB (see FIG. 9) through a semiconductor process. For example, the plurality of data transistors may include (e.g., be formed of) CMOS, but embodiments of the present disclosure are not limited thereto.

The data driver 700 may receive digital video data DATA and a data timing control signal DCS from the timing control circuit 400. The data driver 700 may convert the digital video data DATA into analog data voltages according to the data timing control signal DCS and outputs the analog data voltages to the data lines DL. In this case, the sub-pixels SP1, SP2, and SP3 may be selected by the write scan signal of the scan driver 610, and data voltages may be supplied to the selected sub-pixels SP1, SP2, and SP3.

The heat dissipation layer 200 may overlap the display panel 100 in a third direction DR3, which is a thickness direction of the display panel 100. The heat dissipation layer 200 may be arranged on one surface of the display panel 100, for example, on the rear surface thereof. The heat dissipation layer 200 may be to dissipate or reduce heat generated from the display panel 100. The heat dissipation layer 200 may include a metal layer having high thermal conductivity, such as graphite, silver (Ag), copper (Cu), and/or aluminum (Al).

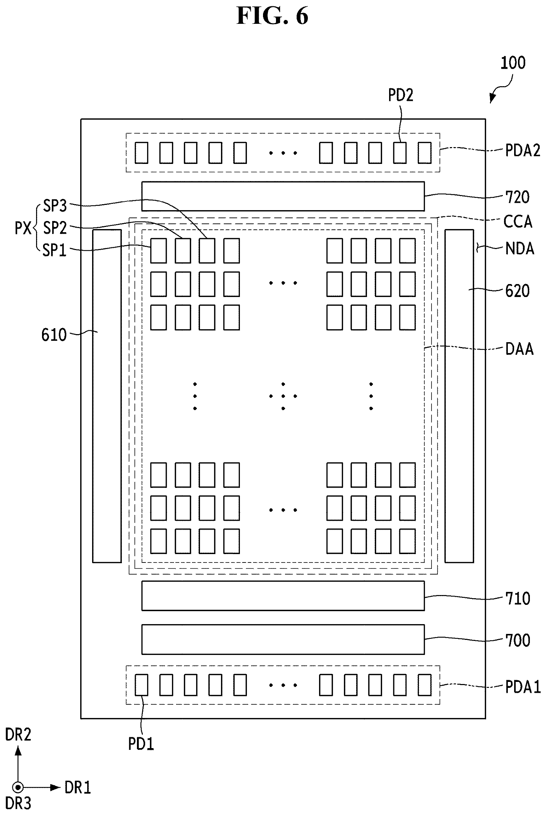

The circuit board 300 may be electrically connected to a plurality of first pads PD1 (see FIG. 6) of a first pad portion PDA1 (see FIG. 6) of the display panel 100 by utilizing a conductive adhesive member such as an anisotropic conductive film. The circuit board 300 may be a flexible printed circuit board with a flexible material, and/or a flexible film. Although the circuit board 300 is illustrated in FIG. 3 as being unfolded, the circuit board 300 may be bent. In this case, one end of the circuit board 300 may be arranged on the rear surface of the display panel 100 and/or the rear surface of the heat dissipation layer 200. The other end of the circuit board 300 may be connected to the plurality of first pads PD1 (see FIG. 6) of the first pad portion PDA1 (see FIG. 6) of the display panel 100 by utilizing a conductive adhesive member. One end of the circuit board 300 may be an opposite end of the other end of the circuit board 300.

The timing control circuit 400 may receive digital video data and timing signals inputted from the outside (e.g., an outside resource). The timing control circuit 400 may be to generate the scan timing control signal SCS, the emission timing control signal ECS, and/or the data timing control signal DCS for controlling the display panel 100 in response to the timing signals. The timing control circuit 400 may be to output the scan timing control signal SCS to the scan driver 610, and output the emission timing control signal ECS to the emission driver 620. The timing control circuit 400 may be to output the digital video data and the data timing control signal DCS to the data driver 700.

The power supply circuit 500 may be to generate a plurality of panel driving voltages according to a power voltage from the outside (e.g., an outside resource). For example, the power supply circuit 500 may be to generate a first driving voltage VSS, a second driving voltage VDD, and/or a third driving voltage VINT and supply them to the display panel 100. The first driving voltage VSS, the second driving voltage VDD, and the third driving voltage VINT will be described later in conjunction with FIG. 5.

Each of the timing control circuit 400 and the power supply circuit 500 may be formed as an integrated circuit (IC) and attached to one surface of the circuit board 300. In this case, the scan timing control signal SCS, the emission timing control signal ECS, the digital video data DATA, and/or the data timing control signal DCS of the timing control circuit 400 may be supplied to the display panel 100 through the circuit board 300. Furthermore, the first driving voltage VSS, the second driving voltage VDD, and/or the third driving voltage VINT of the power supply circuit 500 may be supplied to the display panel 100 through the circuit board 300.

In one or more embodiments, each of the timing control circuit 400 and the power supply circuit 500 may be arranged in the non-display area NDA of the display panel 100, similarly to the scan driver 610, the emission driver 620, and the data driver 700. In this case, the timing control circuit 400 may include a plurality of timing transistors, and each power supply circuit 500 may include a plurality of power transistors. The plurality of timing transistors and the plurality of power transistors may be on (e.g., formed on) the semiconductor substrate SSUB (see FIG. 9) through a semiconductor process. For example, the plurality of timing transistors and the plurality of power transistors may include (e.g., be formed of) CMOS, but embodiments of the present disclosure not limited thereto. Each of the timing control circuit 400 and the power supply circuit 500 may be arranged between the data driver 700 and the first pad portion PDA1 (see FIG. 6).

FIG. 5 is an equivalent circuit diagram illustrating an example of a first sub-pixel shown in FIG. 4.

Referring to FIG. 5, the first sub-pixel SP1 may be connected to the write scan line GWL, the control scan line GCL, the bias scan line GBL, the first emission control line ECL1, the second emission control line ECL2, and/or the data line DL. Furthermore, the first sub-pixel SP1 may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied.

The first sub-pixel SP1 may include a plurality of transistors T1 to T6, a light emitting element LE, a first capacitor CP1, and/or a second capacitor CP2.

The light emitting element LE may be to emit light in response to a driving current flowing through the channel of the first transistor T1. The emission amount of the light emitting element LE may be proportional to the driving current. The first electrode of the light emitting element LE may be an anode electrode, and the second electrode of the light emitting element LE may be a cathode electrode. The light emitting element LE may be an organic light emitting diode including a first electrode, a second electrode, and an organic light emitting layer arranged between the first electrode and the second electrode, but embodiments of the present disclosure are not limited thereto. For example, the light emitting element LE may be an inorganic light emitting element including a first electrode, a second electrode, and an inorganic semiconductor arranged between the first electrode and the second electrode, in which case the light emitting element LE may be a micro light emitting diode.

The first transistor T1 may be a driving transistor that controls a source-drain current (hereinafter referred to as "driving current") flowing between the source electrode and the drain electrode thereof according to a voltage applied to the gate electrode thereof.

A second transistor T2 may be arranged between one electrode of the first capacitor CP1 and the data line DL. The second transistor T2 may be turned on by the write scan signal of the write scan line GWL to connect the one electrode of the first capacitor CP1 to the data line DL. Accordingly, the data voltage of the data line DL may be applied to the one electrode of the first capacitor CP1.

A third transistor T3 may be arranged between the first node N1 and the second node N2. The third transistor T3 may be turned on by the control scan signal of the control scan line GCL to connect the first node N1 to the second node N2. For this reason, if (e.g., when) the gate electrode and the source electrode of the first transistor T1 are connected, the first transistor T1 may be operated like a diode.

The fourth transistor T4 may be connected between the second node N2 and a third node N3. The fourth transistor T4 may be turned on by the first emission control signal of the first emission control line ECL1 to connect the second node N2 to the third node N3. Accordingly, the driving current of the first transistor T1 may be supplied to the light emitting element LE. A fifth transistor T5 may be arranged between the third node N3 and the third driving voltage line VIL. The fifth transistor T5 may be turned on by the bias scan signal of the bias scan line GBL to connect the third node N3 to the third driving voltage line VIL. Accordingly, the third driving voltage VINT of the third driving voltage line VIL may be applied to the first electrode of the light emitting element LE.

The sixth transistor T6 may be arranged between the source electrode of the first transistor T1 and the second driving voltage line VDL. The sixth transistor T6 may be turned on by the second emission control signal of the second emission control line ECL2 to connect the source electrode of the first transistor T1 to the second driving voltage line VDL. Accordingly, the second driving voltage VDD of the second driving voltage line VDL may be applied to the source electrode of the first transistor T1.

The first capacitor CP1 may be formed between the first node N1 and the drain electrode of the second transistor T2. The second capacitor CP2 may be formed between the gate electrode of the first transistor T1 and the second driving voltage line VDL.

Each of the first to sixth transistors T1 to T6 may be a metal-oxide-semiconductor field effect transistor (MOSFET). For example, each of the first to sixth transistors T1 to T6 may be a P-type (kind) MOSFET, but embodiments of the present disclosure are not limited thereto. Each of the first to sixth transistors T1 to T6 may be an N-type (kind) MOSFET. In one or more embodiments, at least some of the first to sixth transistors T1 to T6 may be P-type (kind) MOSFETs, and each of the remaining transistors may be an N-type (kind) MOSFET.

Although it is illustrated in FIG. 5 that the first sub-pixel SP1 may include six transistors T1 to T6 and two capacitors C1 and C2, it should be noted that the equivalent circuit diagram of the first sub-pixel SP1 is not limited to that shown in FIG. 5. For example, the number of transistors and the number of capacitors of the first sub-pixel SP1 are not limited to those shown in FIG. 5.

Furthermore, the equivalent circuit diagram of the second sub-pixel SP2 and the equivalent circuit diagram of the third sub-pixel SP3 may be substantially the same as the equivalent circuit diagram of the first sub-pixel SP1 described in conjunction with FIG. 5. Therefore, the description of the equivalent circuit diagram of the second sub-pixel SP2 and the equivalent circuit diagram of the third sub-pixel SP3 is not repeated in the present disclosure.

FIG. 6 is a schematic plan view illustrating an example of a display panel shown in FIG. 3.

Referring to FIG. 6, the display area DAA of the display panel 100 according to one or more embodiments may include the plurality of pixels PX arranged in a matrix form. The non-display area NDA of the display panel 100 according to one or more embodiments may include the scan driver 610, the emission driver 620, the data driver 700, a first distribution circuit 710, a second distribution circuit 720, the first pad portion PDA1, and/or a second pad portion PDA2.

The scan driver 610 may be arranged on the first side of the display area DAA, and the emission driver 620 may be arranged on the second side of the display area DAA. For example, the scan driver 610 may be arranged on one side of the display area DAA in the first direction DR1, and the emission driver 620 may be arranged on the other side of the display area DAA in the first direction DR1. However, embodiments of the present disclosure are not limited thereto, and the scan driver 610 and the emission driver 620 may be arranged on both (e.g., simultaneously) the first side and the second side of the display area DAA.

The first pad portion PDA1 may include the plurality of first pads PD1 connected to pads or bumps of the circuit board 300 through a conductive adhesive member. The first pad portion PDA1 may be arranged on the third side of the display area DAA. For example, the first pad portion PDA1 may be arranged on one side of the display area DAA in the second direction DR2. The first pad portion PDA1 may be arranged outside the data driver 700 in the second direction DR2.

The second pad portion PDA2 may include a plurality of second pads PD2 corresponding to inspection pads that test whether the display panel 100 operates normally. The plurality of second pads PD2 may be connected to a jig and/or a probe pin during an inspection process, or may be connected to a circuit board for inspection. The circuit board for inspection may be a printed circuit board including (e.g., made of) a rigid material or a flexible printed circuit board including (e.g., made of) a flexible material.

The second pad portion PDA2 may be arranged on the fourth side of the display area DAA. For example, the second pad portion PDA2 may be arranged on the other side of the display area DAA in the second direction DR2. The second pad portion PDA2 may be arranged outside the second distribution circuit 720 in the second direction DR2.

The first distribution circuit 710 may be to distribute data voltages applied through the first pad portion PDA1 to the plurality of data lines DL. For example, the first distribution circuit 710 may distribute the data voltages applied through one first pad PD1 of the first pad portion PDA1 to the P (P is a positive integer of 2 or more) data lines DL, and as a result, the number of the plurality of first pads PD1 may be reduced. The first distribution circuit 710 may be arranged on the third side of the display area DAA of the display panel 100. For example, the first distribution circuit 710 may be arranged on one side of the display area DAA in the second direction DR2.

The second distribution circuit 720 distributes signals applied through the second pad portion PDA2 to the scan driver 610, the emission driver 620, and the data lines DL. The second pad portion PDA2 and the second distribution circuit 720 may be configured to inspect the operation of each of the pixels PX in the display area DAA. The second distribution circuit 720 may be arranged on the fourth side of the display area DAA of the display panel 100. For example, the second distribution circuit 720 may be arranged on the other side of the display area DAA in the second direction DR2.

A cathode connection part CCA may be a region where a second electrode CAT (see FIG. 9) of a display element layer EML (see FIG. 9) is connected to the first driving voltage line VSL of the non-display area NDA. The cathode connection part CCA may be arranged outside at least one side of the display area DAA. For example, the cathode connection part CCA may be arranged outside at least on one side among the left side, the right side, the upper side, and the lower side of the display area DAA. In one or more embodiments, the cathode connection part CCA may be arranged to surround the display area DAA as shown in FIG. 6 to minimize or reduce a deviation in the first driving voltage VSS caused by voltage drop (IR drop) or voltage rise (IR rising) of the second electrode CAT in the display area DAA.

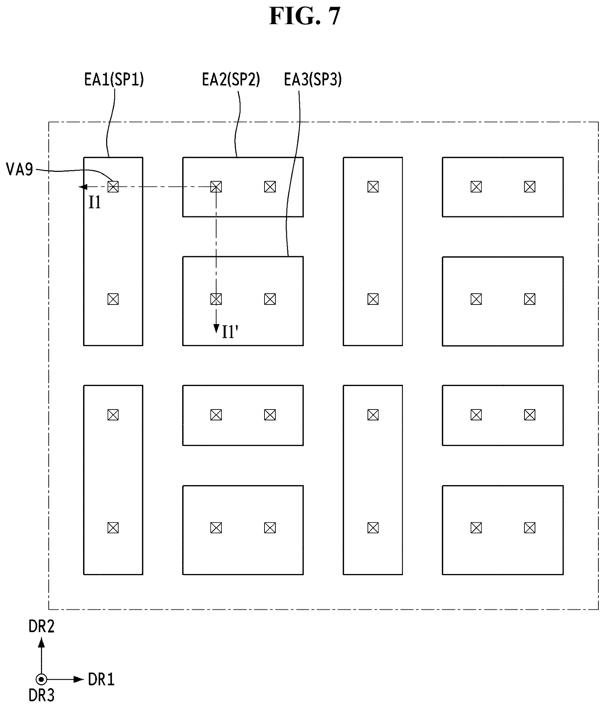

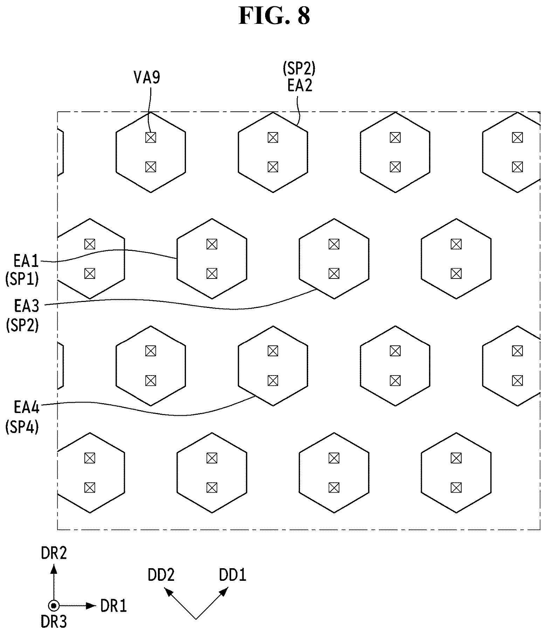

FIG. 7 is a schematic enlarged plan view illustrating an example of a display area shown in FIG. 6. FIG. 8 is a schematic enlarged plan view illustrating another example of the display area shown in FIG. 6.

Referring to FIGS. 7 and 8, each of the pixels PX may include the first emission area EA1 that may be an emission area of the first sub-pixel SP1, the second emission area EA2 that may be an emission area of the second sub-pixel SP2, and the third emission area EA3 that may be an emission area of the third sub-pixel SP3.

The first emission area EA1, the second emission area EA2, and the third emission area EA3 may have, in plan view, a quadrilateral or hexagonal shape as shown in FIGS. 7 and 8, but embodiments of the present disclosure are not limited thereto. The first emission area EA1, the second emission area EA2, and the third emission area EA3 may have a polygonal shape other than a quadrangle or hexagon, a circular shape, an elliptical shape, or an atypical shape in plan view.

As shown in FIG. 7, in each of the plurality of pixels PX, the first emission area EA1 and the second emission area EA2 may be adjacent to each other in the first direction DR1. Furthermore, the first emission area EA1 and the third emission area EA3 may be adjacent to each other in the first direction DR1. In addition, the second emission area EA2 and the third emission area EA3 may be adjacent to each other in the second direction DR2. The area of the first emission area EA1, the area of the second emission area EA2, and the area of the third emission area EA3 may be different.

In one or more embodiments, as shown in FIG. 8, the emission areas EA1, EA2, EA3, and EA4 may have a hexagonal shape in plan view. In this case, the first emission area EA1 and the third emission area EA3 may be adjacent in the first direction DR1, and the second emission area EA2 and the fourth emission area EA4 may be adjacent in the second direction DR2. Additionally, the first emission area EA1 and the second emission area EA2 may be adjacent in a first diagonal direction DD1, and the second emission area EA2 and the third emission area EA3 may be adjacent in a second diagonal direction DD2. Additionally, the first emission area EA1 and the fourth emission area EA4 may be adjacent in the second diagonal direction DD2, and the third emission area EA3 and the fourth emission area EA4 may be adjacent in the first diagonal direction DD1. The first diagonal direction DD1 may be a direction between the first direction DR1 and the second direction DR2, and may refer to a direction inclined by 45 degrees with respect to the first direction DR1 and the second direction DR2, and the second diagonal direction DD2 may be a direction perpendicular to the first diagonal direction DD1.

The first sub-pixel SP1 may be to emit first light, the second sub-pixel SP2 may be to emit second light, and the third sub-pixel SP3 may be to emit third light. Here, the first light may be light of a blue wavelength band, the second light may be light of a green wavelength band, and the third light may be light of a red wavelength band. For example, the blue wavelength band may be a wavelength band of light whose main peak wavelength may be in the range of approximately 370 nm to 460 nm (e.g., the wavelength of the blue wavelength band may be from about 370 nm to about 460 nm), the green wavelength band may be a wavelength band of light whose main peak wavelength may be in the range of approximately 480 nm to 560 nm (e.g., the wavelength of the green wavelength band may be from about 480 nm to about 560 nm), and the red wavelength band may be a wavelength band of light whose main peak wavelength is in the range of approximately 600 nm to 750 nm (e.g., the wavelength of the red wavelength band may be from about 600 nm to about 750 nm).

As shown in FIG. 7, each of the plurality of pixels PX may include three emission areas EA1, EA2, and EA3, or may include four emission areas EA1, EA2, EA3, and EA4 as shown in FIG. 8. In this case, the fourth emission area EA4 may be to emit substantially the same second light as the second emission area EA2, but embodiments of the present disclosure are not limited thereto.

The emission areas of the plurality of pixels PX may be arranged in a stripe structure, in which the emission areas are arranged in the first direction DR1, a PenTile® structure (e.g., an RGBG matrix, RGBG structure, and/or RGBG matrix structure) in which the emission areas EA1, EA2, EA3, and EA4 may be arranged in a rhombic shape as shown in FIG. 8, or a hexagonal structure in which the emission areas are arranged in a hexagonal shape, but embodiments of the present disclosure are not limited thereto. PenTile® is a duly registered trademark of Samsung Display Co., Ltd.

FIG. 9 is a schematic cross-sectional view illustrating an example of the display panel taken along the line I1-I1' shown in FIG. 7.

Referring to FIG. 9, the display panel 100 may include a semiconductor backplane SBP, a light emitting element backplane EBP, the display element layer EML, an encapsulation layer TFE, an optical layer OPL, a cover layer CVL, and a polarizing plate POL.

The semiconductor backplane SBP may include the semiconductor substrate SSUB including a plurality of pixel transistors PTR, a plurality of semiconductor insulating films covering the plurality of pixel transistors PTR, and/or a plurality of contact terminals CTE electrically connected to the plurality of pixel transistors PTR, respectively. The plurality of pixel transistors PTR may be the first to sixth transistors T1 to T6 described with reference to FIG. 5.

The semiconductor substrate SSUB may be a silicon substrate, a germanium substrate, or a silicon-germanium substrate. The semiconductor substrate SSUB may be a substrate doped with a first type (kind) impurity. A plurality of well regions WA may be arranged on the top surface of the semiconductor substrate SSUB. The plurality of well regions WA may be regions doped with a second type (kind) impurity. The second type (kind) impurity may be different from the first type (kind) impurity. For example, if (e.g., when) the first type (kind) impurity is a p-type (kind) impurity, the second type (kind) impurity may be an n-type (kind) impurity. In one or more embodiments, if (e.g., when) the first type (kind) impurity is an n-type (kind) impurity, the second type (kind) impurity may be a p-type (kind) impurity.

Each of the plurality of well regions WA may include a source region SA corresponding to the source electrode of the pixel transistor PTR, a drain region DA corresponding to the drain electrode thereof, and a channel region CH arranged between the source region SA and the drain region DA.

A lower insulating film BINS may be arranged between a gate electrode GE and the well region WA. A side insulating film SINS may be arranged on the side surface of the gate electrode GE. The side insulating film SINS may be arranged on the lower insulating film BINS.

Each of the source region SA and the drain region DA may be a region doped with the first type (kind) impurity. The gate electrode GE of the pixel transistor PTR may overlap the well region WA in the third direction DR3, which is the thickness direction of the semiconductor substrate SSUB. The channel region CH may overlap the gate electrode GE in the third direction DR3. The source region SA may be arranged on one side of the gate electrode GE, and the drain region DA may be arranged on the other side of the gate electrode GE.

Each of the plurality of well regions WA may further include a first low-concentration impurity region LDD1 arranged between the channel region CH and the source region SA, and/or a second low-concentration impurity region LDD2 arranged between the channel region CH and the drain region DA. The first low-concentration impurity region LDD1 may be a region having a lower impurity concentration than the source region SA due to the lower insulating film BINS. The second low-concentration impurity region LDD2 may be a region having a lower impurity concentration than the drain region DA due to the lower insulating film BINS. The distance between the source region SA and the drain region DA may increase due to the first low-concentration impurity region LDD1 and the second low-concentration impurity region LDD2, thereby increasing the length of the channel region CH of each of the pixel transistors PTR.

A first semiconductor insulating film SINS1 may be arranged on the semiconductor substrate SSUB. A second semiconductor insulating film SINS2 may be arranged on the first semiconductor insulating film SINS1.

The plurality of contact terminals CTE may be arranged on the second semiconductor insulating film SINS2. Each of the plurality of contact terminals CTE may be connected to at least one selected from among the gate electrode GE, the source region SA, and the drain region DA of each of the pixel transistors PTR through a hole penetrating the first semiconductor insulating film SINS1 and the second semiconductor insulating film SINS2. The plurality of contact terminals CTE may include (e.g., be formed of) at least one selected from among copper (Cu), aluminum (Al), tungsten (W), molybdenum (Mo), chromium (Cr), gold (Au), titanium (Ti), nickel (Ni), and neodymium (Nd), and/or an alloy including at least one selected from among Cu, Al, W, Mo, Cr, Au, Ti, Ni, and Nd.

A third semiconductor insulating film SINS3 may be arranged on a side surface of each of the plurality of contact terminals CTE. The top surface of each of the plurality of contact terminals CTE may be exposed without being covered by the third semiconductor insulating film SINS3.

Each of the first semiconductor insulating film SINS1, the second semiconductor insulating film SINS2, and the third semiconductor insulating film SINS3 may include (e.g., be formed of) silicon carbonitride (SiCN) and/or a silicon oxide $(SiO_x)$-based inorganic film, but embodiments of the present disclosure are not limited thereto.

The semiconductor substrate SSUB may be replaced with a glass substrate or a polymer resin substrate such as polyimide. In this case, thin film transistors may be arranged on the glass substrate or the polymer resin substrate. The glass substrate may be a rigid substrate that does not bend, and the polymer resin substrate may be a flexible substrate that may be bent or curved.

The light emitting element backplane EBP may include a plurality of conductive layers ML1 to ML8, a plurality of vias VA1 to VA9, and a plurality of interlayer insulating films INS1 to INS9.

The first to ninth interlayer insulating films INS1 to INS9 may be to insulate the first to eighth conductive layers ML1 to ML8. The first to eighth conductive layers ML1 to ML8 may be to connect the plurality of contact terminals CTE exposed from the semiconductor backplane SBP to thereby implement the circuit of the first sub-pixel SP1 shown in FIG. 5.

For example, the first to sixth transistors T1 to T6 are merely formed in the semiconductor backplane SBP, and the connection of the first to sixth transistors T1 to T6 and the first and second capacitors C1 and C2 is accomplished through the first to eighth conductive layers ML1 to ML8. In addition, the connection between the drain region corresponding to the drain electrode of the fourth transistor T4, the source region corresponding to the source electrode of the fifth transistor T5, and a first electrode AND of the light emitting element LE is also accomplished through the first to eighth conductive layers ML1 to ML8.

The first to eighth conductive layers ML1 to ML8 and the first to eighth vias VA1 to VA8 may include (e.g., be formed of) substantially the same material. The first to eighth conductive layers ML1 to ML8 and the first to eighth vias VA1 to VA8 may include (e.g., be formed of) at least one selected from among copper (Cu), aluminum (Al), tungsten (W), molybdenum (Mo), chromium (Cr), gold (Au), titanium (Ti), nickel (Ni), and neodymium (Nd), and/or an alloy including at least one selected from Cu, Al, W, Mo, Cr, Au, Ti, Ni, and Nd. The first to eighth vias VA1 to VA8 may include (e.g., be made of) substantially the same material. First to eighth interlayer insulating films INS1 to INS8 may include (e.g., be formed of) a silicon oxide $(SiO_x)$-based inorganic layer, but embodiments of the present disclosure are not limited thereto.

A ninth interlayer insulating film INS9 may be arranged on the eighth interlayer insulating film INS8 and the eighth conductive layer ML8. The ninth interlayer insulating film INS9 may include (e.g., be formed of) a silicon oxide $(SiO_x)$-based inorganic film, but embodiments of the present disclosure are not limited thereto.

Each of the ninth vias VA9 may penetrate the ninth interlayer insulating film INS9 and be connected to the exposed eighth conductive layer ML8. The ninth vias VA9 may include (e.g., be formed of) at least one selected from among copper (Cu), aluminum (Al), tungsten (W), molybdenum (Mo), chromium (Cr), gold (Au), titanium (Ti), nickel (Ni), and neodymium (Nd), and/or an alloy including at least one selected from among Cu, Al, W, Mo, Cr, Au, Ti, Ni, and Nd.

The display element layer EML may be arranged on the light emitting element backplane EBP. The display element layer EML may include the tenth and eleventh interlayer insulating films INS10 and INS11, reflective electrodes RL, the first electrodes AND, a light emitting stack IL, the second electrode CAT, a pixel defining film PDL, and a plurality of trenches TRC.

The reflective electrodes RL may be arranged on the ninth interlayer insulating film INS9. Each of the reflective electrodes RL may include at least one reflective electrode RL1, RL2, RL3, and RL4. For example, each of the reflective electrodes RL may include the first to fourth reflective electrodes RL1, RL2, RL3, and RL4 as shown in FIG. 9.

The first reflective electrodes RL1 may be arranged on the ninth interlayer insulating film INS9, and may be connected to the ninth via VA9. Each of the second reflective electrodes RL2 may be arranged on the first reflective electrode RL1 corresponding thereto. Each of the third reflective electrodes RL3 may be arranged on the second reflective electrode RL2 corresponding thereto. Each of the fourth reflective electrodes RL4 may be arranged on the third reflective electrode RL3 corresponding thereto.

Because the second reflective electrode RL2 is an electrode that substantially reflects light from the light emitting elements LE, the thickness of the second reflective electrode RL2 may be greater than the thickness of each of the first reflective electrode RL1, the third reflective electrode RL3, and the fourth reflective electrode RL4.

The first reflective electrodes RL1 may include (e.g., be formed of) at least one selected from among copper (Cu), aluminum (Al), tungsten (W), molybdenum (Mo), chromium (Cr), gold (Au), titanium (Ti), nickel (Ni), and neodymium (Nd), and/or an alloy including at least one selected from among Cu, Al, W, Mo, Cr, Au, Ti, Ni, and Nd. For example, the first reflective electrodes RL1 may contain titanium nitride (TiN), the second reflective electrodes RL2 may contain aluminum (Al), the third reflective electrodes RL3 may contain titanium nitride (TiN), and the fourth reflective electrodes RL4 may include titanium (Ti).

The tenth interlayer insulating film INS10 may be arranged on the ninth interlayer insulating film INS9. The tenth interlayer insulating film INS10 may be arranged between the reflective electrodes RL adjacent to each other. The tenth interlayer insulating film INS10 may be a film for flattening a stepped portion caused by the reflective electrodes RL. The eleventh interlayer insulating film INS11 may be arranged on the tenth interlayer insulating film INS10 and the reflective electrodes RL.

The tenth interlayer insulating film INS10 and the eleventh interlayer insulating film INS11 may include (e.g., be formed of) a silicon oxide ($SiO_x$)-based inorganic film, but embodiments of the present disclosure are not limited thereto.

The eleventh interlayer insulating film INS11 may be an optical auxiliary layer for adjusting the resonance distance of light emitted from the light emitting stack IL in at least one selected from among the first sub-pixel SP1, the second sub-pixel SP2, and the third sub-pixel SP3. The thickness of the eleventh interlayer insulating film INS11 may be different in the first sub-pixel SP1, the second sub-pixel SP2, and the third sub-pixel SP3. For example, to adjust a distance from the reflective electrode RL to the second electrode CAT according to a main wavelength of light emitted from each of the first sub-pixel SP1, the second sub-pixel SP2, and the third sub-pixel SP3, the thickness of the eleventh interlayer insulating film INS11 may be set for each of the first sub-pixel SP1, the second sub-pixel SP2, and the third sub-pixel SP3.

For example, as shown in FIG. 9, the thickness of the eleventh interlayer insulating film INS11 in the first sub-pixel SP1 may be greater than the thickness of the eleventh interlayer insulating film INS11 in the second sub-pixel SP2, and the thickness of the eleventh interlayer insulating film INS11 in the second sub-pixel SP2 may be greater than the thickness of the eleventh interlayer insulating film INS11 in the third sub-pixel SP3. In this case, the distance between the first electrode AND and the reflective electrode RL in the first sub-pixel SP1 is greater than the distance between the first electrode AND and the reflective electrode RL in the second sub-pixel SP2. In addition, the distance between the first electrode AND and the reflective electrode RL in the second sub-pixel SP2 is greater than the distance between the first electrode AND and the reflective electrode RL in the third sub-pixel SP3.

Each of the tenth vias VA10 may penetrate the eleventh interlayer insulating film INS11 and be connected to the exposed fourth reflective electrode RL4. The tenth vias VA10 may include (e.g., be formed of) at least one selected from among copper (Cu), aluminum (Al), tungsten (W), molybdenum (Mo), chromium (Cr), gold (Au), titanium (Ti), nickel (Ni), and neodymium (Nd), and/or an alloy including at least one selected from among Cu, Al, W, Mo, Cr, Au, Ti, Ni, and Nd. The thickness of the tenth via VA10 in the first sub-pixel SP1 may be greater than the thickness of the tenth via VA10 in the second sub-pixel SP2, and the thickness of the tenth via VA10 in the second sub-pixel SP2 may be greater than the thickness of the tenth via VA10 in the third sub-pixel SP3.

The first electrode AND of each of the light emitting elements LE may be arranged on the eleventh interlayer insulating film INS11 and connected to the tenth via VA10. The first electrode AND of each of the light emitting elements LE may be connected to the drain region DA or source region SA of the pixel transistor PTR through the tenth via VA10, the reflective electrode RL, the first to ninth vias VA1 to VA9, the first to eighth metal layers ML1 to ML8, and the contact terminal CTE. The first electrode AND of each of the light emitting elements LE may include (e.g., be formed of) at least one selected from among copper (Cu), aluminum (Al), tungsten (W), molybdenum (Mo), chromium (Cr), gold (Au), titanium (Ti), nickel (Ni), and neodymium (Nd), and/or an alloy including at least one selected from among Cu, Al, W, Mo, Cr, Au, Ti, Ni, and Nd. For example, the first electrode AND of each of the light emitting elements LE may be titanium nitride (e.g., TiN).

The pixel defining film PDL may be arranged on a part of the first electrode AND of each of the light emitting elements LE. The pixel defining film PDL may cover the edge of the first electrode AND of each of the light emitting elements LE. The pixel defining film PDL may partition the first emission areas EA1, the second emission areas EA2, and the third emission areas EA3. Each of the first emission area EA1, the second emission area EA2, and the third emission area EA3 may be an area where the light emitting element LE including the first electrode AND, the light emitting stack IL, and the second electrode CAT is arranged.

The first emission area EA1 may be defined as an area in which the first electrode AND, the light emitting stack IL, and the second electrode CAT are sequentially stacked in the first sub-pixel SP1 to emit light. The second emission area EA2 may be defined as an area in which the first electrode AND, the light emitting stack IL, and the second electrode CAT are sequentially stacked in the second sub-pixel SP2 to emit light. The third emission area EA3 may be defined as an area in which the first electrode AND, the light emitting stack IL, and the second electrode CAT are sequentially stacked in the third sub-pixel SP3 to emit light.

The pixel defining film PDL may include first to third pixel defining films PDL1, PDL2, and PDL3. The first pixel defining film PDL1 may be arranged on the edge of the first electrode AND of each of the light emitting elements LE, the second pixel defining film PDL2 may be arranged on the first pixel defining film PDL1, and the third pixel defining film PDL3 may be arranged on the second pixel defining film PDL2. The first pixel defining film PDL1, the second pixel defining film PDL2, and the third pixel defining film PDL3 may include (e.g., be formed of) a silicon oxide ($SiO_x$)-based inorganic film. In one or more embodiments, the first pixel defining film PDL1 and the third pixel defining film PDL3 may include (e.g., be formed of) a silicon nitride ($SiN_x$)-based inorganic film, whereas the second pixel defining film PDL2 may include (e.g., be formed of) a silicon oxide ($SiO_x$)-based inorganic film. The first pixel defining film PDL1, the second pixel defining film PDL2, and the third pixel defining film PDL3 may each have a thickness of about 500 Å.

To reduce or prevent or reduce the likelihood of the first encapsulation inorganic film TFE1 being cut off due to the step coverage, the first pixel defining film PDL1, the second pixel defining film PDL2, and the third pixel defining film PDL3 may have a cross-sectional structure having a stepped portion. Step coverage refers to the ratio of the degree of thin film coated on an inclined portion to the degree of thin film coated on a flat portion. The lower the step coverage, the more likely it is that the thin film will be cut off at inclined portions.

Each of the plurality of trenches TRC may penetrate the first pixel defining film PDL1, the second pixel defining film PDL2, and the third pixel defining film PDL3. The eleventh interlayer insulating film INS11 may be partially recessed at each of the plurality of trenches TRC.

At least one trench TRC may be arranged between the neighboring sub-pixels SP1, SP2, and SP3. Although FIG. 9 illustrates that two trenches TRC are arranged between the neighboring sub-pixels SP1, SP2, and SP3, embodiments of the present disclosure are not limited thereto.

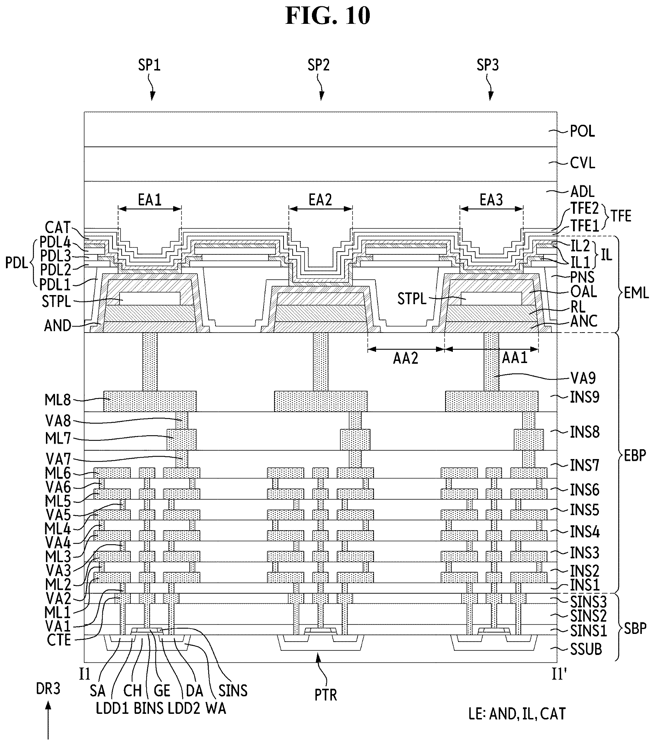

The light emitting stack IL may include a plurality of stack layers IL1, IL2, and IL3. FIG. 9 illustrates that the light emitting stack IL has a three-tandem structure including a first stack layer IL1, a second stack layer IL2, and a third stack layer IL3, but embodiments of the present disclosure are not limited thereto. For example, the light emitting stack IL may have a two-tandem structure including two stack layers as shown in FIG. 10.

In the three-tandem structure, the light emitting stack IL may have a tandem structure including a plurality of intermediate layers IL1, IL2, and IL3 to emit different lights. For example, the light emitting stack IL may include the first stack layer IL1 to emit first light, the second stack layer IL2 to emit second light, and the third stack layer IL3 to emit third light. The first stack layer IL1, the second stack layer IL2, and the third stack layer IL3 may be sequentially stacked.

The first stack layer IL1 may have a structure, in which a first hole transport layer, a first light emitting layer to emit the first light, and a first electron transport layer may be sequentially stacked. The second stack layer IL2 may have a structure, in which a second hole transport layer, a second light emitting layer to emit the second light, and a second electron transport layer may be sequentially stacked. The third stack layer IL3 may have a structure, in which a third hole transport layer, a third light emitting layer to emit the third light, and a third electron transport layer may be sequentially stacked.

A first charge generation layer for supplying charges to the second stack layer IL2 and supplying electrons to the first stack layer IL1 may be arranged between the first stack layer IL1 and the second stack layer IL2. The first charge generation layer may include an N-type (kind) charge generation layer that supplies electrons to the first stack layer IL1 and a P-type (kind) charge generation layer that supplies holes to the second stack layer IL2. The N-type (kind) charge generation layer may include a dopant of a metal material.

A second charge generation layer for supplying charges to the third stack layer IL3 and supplying electrons to the second stack layer IL2 may be arranged between the second stack layer IL2 and the third stack layer IL3. The second charge generation layer may include an N-type (kind) charge generation layer that supplies electrons to the second stack layer IL2 and a P-type (kind) charge generation layer that supplies holes to the third stack layer IL3.

The first stack layer IL1 may be arranged on the first electrodes AND and the pixel defining film PDL, and a residual film RIL arranged on the bottom surface of each trench TRC may be substantially the same material as the first stack layer IL1. Due to the trench TRC, the first stack layer IL1 may be cut off between the neighboring sub-pixels SP1, SP2, and SP3. The second stack layer IL2 may be arranged on the first stack layer IL1. Due to the trench TRC, the second stack layer IL2 may be cut off between the neighboring sub-pixels SP1, SP2, and SP3. A cavity ESS and/or an empty space may be arranged between the residual film IL and the second stack layer IL2 in the trench TRC. The third stack layer IL3 may be arranged on the second stack layer IL2. The third stack layer IL3 may not be cut off by the trench TRC and may be arranged to cover the second stack layer IL2 in each of the trenches TRC.

In the three-tandem structure, each of the plurality of trenches TRC may be a structure for cutting off the first to third hole transport layers, the first charge generation layer, and the second charge generation layer of the first to third stack layers IL1, IL2, and IL3 of the display element layer EML between the neighboring sub-pixels SP1, SP2, and SP3. In addition, in the two-tandem structure, each of the plurality of trenches TRC may be a structure for cutting off the charge generation layer and the lower stack layer arranged between the lower stack layer and the upper stack layer.

To stably cut off the first and second stack layers IL1 and IL2 of the display element layer EML between the neighboring sub-pixels SP1, SP2, and SP3, the height of each of the plurality of trenches TRC may be greater than the height of the pixel defining film PDL. The height of each of the plurality of trenches TRC may refer to the length of each of the plurality of trenches TRC in the third direction DR3. The height of the pixel defining film PDL may refer to the length of the pixel defining film PDL in the third direction DR3. To cut off the charge generation layers and the hole transport layers of the light emitting stack IL of the display element layer EML between the neighboring sub-pixels SP1, SP2, and SP3, a different structure may be present instead of the trench TRC. For example, instead of the trench TRC, a reverse tapered partition wall may be arranged on the pixel defining film PDL.

In addition, FIG. 9 illustrates that the light emitting stack IL to emit light is arranged in the first emission area EA1, the second emission area EA2, and the third emission area EA3, but embodiments of the present disclosure are not limited thereto. For example, instead of the light emitting stack IL, the first light emitting layer may be arranged in the first emission area EA1, and may not be provided from the second emission area EA2 and the third emission area EA3. Furthermore, the second light emitting layer may be arranged in the second emission area EA2 and may not be provided from the first emission area EA1 and the third emission area EA3. Furthermore, the third light emitting layer may be arranged in the third emission area EA3 and may not be provided from the first emission area EA1 and the second emission area EA2. In this case, first to third color filters CF1, CF2, and CF3 of the optical layer OPL may not be provided.

The second electrode CAT may be arranged on the light emitting stack IL. For example, the second electrode CAT may be arranged on the third stack layer IL3. The second electrode CAT may include (e.g., be formed of) a transparent conductive material (TCO) such as ITO and/or IZO that may transmit light or a semi-transmissive conductive material such as magnesium (Mg), silver (Ag), and/or an alloy of Mg and Ag. If (e.g., when) the second electrode CAT includes (e.g., is formed of) a semi-transmissive conductive material, the light emission efficiency may be improved in each of the first to third sub-pixels SP1, SP2, and SP3 due to a micro-cavity effect.

The encapsulation layer TFE may be arranged on the display element layer EML. The encapsulation layer TFE may include at least one inorganic film TFE1 and/or TFE3 to prevent or reduce oxygen or moisture from permeating into the display element layer EML. The first encapsulation inorganic film TFE1 may be arranged on the second electrode CAT, and the second encapsulation inorganic film TFE3 may be arranged above the first encapsulation inorganic film TFE1. The first encapsulation inorganic film TFE1 and the second encapsulation inorganic film TFE3 may include (e.g., be formed of) multiple layers, in which one or more inorganic films including silicon nitride (e.g., $SiN_x$), silicon oxynitride (e.g., SiON), silicon oxide (e.g., $SiO_x$), titanium oxide (e.g., $TiO_x$), and/or aluminum oxide (e.g., $AlO_x$) layers may alternately be stacked.

In addition, the encapsulation layer TFE may include at least one organic film TFE2 to protect the display element layer EML from foreign substances such as dust. The encapsulating organic film TFE2 may be arranged between the first encapsulating inorganic film TFE1 and the second encapsulating inorganic film TFE3. The encapsulation organic film TFE2 may be a monomer. In one or more embodiments, the encapsulation organic film TFE2 may be an organic film such as acryl resin, epoxy resin, phenolic resin, polyamide resin, polyimide resin, and/or the like.

An adhesive layer ADL may be a layer for bonding the encapsulation layer TFE to the optical layer OPL. The adhesive layer ADL may be a double-sided adhesive member. In addition, the adhesive layer ADL may be a transparent adhesive member such as a transparent adhesive and/or a transparent adhesive resin.

The optical layer OPL may include a plurality of color filters CF1, CF2, and CF3, a plurality of lenses LNS, and a filling layer FIL. The plurality of color filters CF1, CF2, and CF3 may include the first to third color filters CF1, CF2, and CF3. The first to third color filters CF1, CF2, and CF3 may be arranged on the adhesive layer ADL.

The first color filter CF1 may overlap the first emission area EA1 of the first sub-pixel SP1. The first color filter CF1 may be to transmit light of the first color, e.g., light of a blue wavelength band. The blue wavelength band may be about 370 nm to about 460 nm. Thus, the first color filter CF1 may be to transmit light of the first color among light emitted from the first emission area EA1.

The second color filter CF2 may overlap the second emission area EA2 of the second sub-pixel SP2. The second color filter CF2 may be to transmit light of the second color, e.g., light of a green wavelength band. The green wavelength band may be about 480 nm to about 560 nm. Thus, the second color filter CF2 may be to transmit light of the second color among light emitted from the second emission area EA2.

The third color filter CF3 may overlap the third emission area EA3 of the third sub-pixel SP3. The third color filter CF3 may be to transmit light of the third color, e.g., light of a red wavelength band. The red wavelength band may be about 600 nm to about 750 nm. Thus, the third color filter CF3 may be to transmit light of the third color among light emitted from the third emission area EA3.

The plurality of lenses LNS may be arranged on the first color filter CF1, the second color filter CF2, and the third color filter CF3, respectively. Each of the plurality of lenses LNS may be a structure for increasing the proportion of light directed to the front of the display device 10. Each of the plurality of lenses LNS may have a cross-sectional shape that may be convex in an upward direction.

The filling layer FIL may be arranged on the plurality of lenses LNS. The filling layer FIL may have a set or predetermined refractive index such that light travels in the third direction DR3 at an interface between the filling layer FIL and the plurality of lenses LNS. Furthermore, the filling layer FIL may be a planarization layer. The filling layer FIL may be an organic film such as acrylic resin, epoxy resin, phenolic resin, polyamide resin, and/or polyimide resin.

The cover layer CVL may be arranged on the filling layer FIL. The cover layer CVL may be a glass substrate and/or a polymer resin. If (e.g., when) the cover layer CVL is a glass substrate, it may be attached onto the filling layer FIL. In this case, the filling layer FIL may be to bond the cover layer CVL. If (e.g., when) the cover layer CVL is a glass substrate, it may serve as an encapsulation substrate. If (e.g., when) the cover layer CVL is a polymer resin, it may be directly applied onto the filling layer FIL.

The polarizing plate may be arranged on one surface of the cover layer CVL. The polarizing plate may be a structure for reducing or preventing visibility degradation caused by reflection of external light. The polarizing plate may include a linear polarizing plate and/or a phase retardation film. For example, the phase retardation film may be a $\lambda/4$ plate (e.g., a quarter-wave plate), but embodiments of the present disclosure are not limited thereto. However, if (e.g., when) visibility degradation caused by reflection of external light may be sufficiently overcome by the first to third color filters CF1, CF2, and CF3, the polarizing plate may not be provided.

FIG. 10 is a schematic cross-sectional view illustrating another example of the display panel taken along the line I1-I1' shown in FIG. 7.

The embodiment of FIG. 10 may be different from the embodiment of FIG. 9 in that the first electrode AND of each of the light emitting elements LE may be in contact with and electrically connected to the side surface of a connection electrode ANC connected to the eighth conductive layer ML8. The embodiment of FIG. 10 may also be different from the embodiment of FIG. 9 in that the trench TRC may not be provided, and instead, the third pixel defining film PDL3 and a fourth pixel defining film PDL4 may have an eave-shaped or mushroom-shaped cross-sectional structure. In the embodiment of FIG. 10, redundant description of parts already described in the embodiment of FIG. 9 will not be provided.

Referring to FIG. 10, the plurality of connection electrodes ANC may be respectively arranged on first portions AA1 of the ninth interlayer insulating film INS9. Each of the plurality of connection electrodes ANC may be arranged on the first portion AA1 of the ninth interlayer insulating film INS9 corresponding thereto. A plurality of connection electrodes ANC may include (e.g., be formed of) at least one selected from among copper (Cu), aluminum (Al), tungsten (W), molybdenum (Mo), chromium (Cr), gold (Au), titanium (Ti), nickel (Ni), and neodymium (Nd), an alloy including at least one selected from among Cu, Al, W, Mo, Cr, Au, Ti, Ni, and Nd, and/or a transparent conductive oxide. For example, the plurality of connection electrodes ANC may include titanium (Ti), titanium nitride (e.g., TiN), indium tin oxide (e.g., ITO), and/or indium zinc oxide (e.g., IZO), but embodiments of the present disclosure are not limited thereto.

A plurality of reflective electrodes RL may be respectively arranged on the plurality of connection electrodes ANC. Each of the plurality of reflective electrodes RL may be arranged on the connection electrode ANC corresponding thereto. The plurality of reflective electrodes RL may include (e.g., be formed of) at least one selected from among copper (Cu), aluminum (Al), tungsten (W), molybdenum (Mo), chromium (Cr), gold (Au), titanium (Ti), nickel (Ni), and neodymium (Nd), and/or an alloy including at least one selected from among Cu, Al, W, Mo, Cr, Au, Ti, Ni, and Nd. For example, each of the plurality of reflective electrodes RL may include aluminum (Al) having high reflectivity.

A plurality of optical auxiliary films OAL may be respectively arranged on the plurality of reflective electrodes RL. Each of the plurality of optical auxiliary films OAL may be arranged on the reflective electrode RL corresponding thereto. The plurality of optical auxiliary films OAL may include (e.g., be formed of) a silicon oxide ($SiO_x$)-based inorganic film, but embodiments of the present disclosure are not limited thereto.

In each of the first emission area EA1 and the third emission area EA3, a step layer STPL may be arranged on the reflective electrode RL, and the optical auxiliary film OAL may be arranged on the step layer STPL. In the second emission area EA2, only the optical auxiliary film OAL may be arranged on the reflective electrode RL. The thicknesses of the optical auxiliary film OAL may be substantially the same in the first emission area EA1, the second emission area EA2, and/or the third emission area EA3.

Due to the step layer STPL, the distance between the reflective electrode RL and the first electrode AND in the first emission area EA1 and the third emission area EA3 may be greater than the distance between the reflective electrode RL and the first electrode AND in the second emission area EA2. The thickness of the step layer STPL and the thickness of the optical auxiliary layer OAL may be set in consideration of the wavelength and resonance distance of light emitted from the first stack layer IL1 of the light emitting stack IL, and the wavelength and resonance distance of light emitted from the second stack layer IL2 thereof.

Each of the light emitting elements LE may include the first electrode AND, a light emitting stack IL, and a second electrode CAT.

The first electrode AND of each of the light emitting elements LE may be arranged on the optical auxiliary film OAL corresponding thereto. Because the connection electrode ANC, the reflective electrode RL, and the optical auxiliary layer OAL are sequentially stacked, the first electrode AND of each of the light emitting elements LE may be arranged on the top surface and the side surface of the optical auxiliary layer OAL, the side surface of the reflective electrode RL, and the side surface of the connection electrode ANC. Accordingly, the first electrode AND of each of the light emitting elements LE may be in contact with and electrically connected to the side surface of the reflective electrode RL and the side surface of the connection electrode ANC. Therefore, compared to if (e.g., when) the first electrode AND of each of the light emitting elements LE is connected to the reflective electrode RL exposed through a through hole penetrating the optical auxiliary film OAL, the number of mask processes may be reduced, thereby lowering manufacturing cost and increasing manufacturing efficiency.

The first electrode AND of each of the light emitting elements LE may be connected to the drain region DA or the source region SA of the pixel transistor PTR through the connection electrode ANC, the first to ninth vias VA1 to VA9, the first to eighth conductive layers ML1 to ML8, and the contact terminal CTE.

The ninth interlayer insulating film INS9 may include the first portion AA1 that overlaps the connection electrode ANC in the third direction DR3 and a second portion AA2 that does not overlap the connection electrode ANC in the third direction DR3. The thickness of the first portion AA1 and the thickness of the second portion AA2 of the ninth interlayer insulating film INS9 may be substantially the same.

In one or more embodiments, the thickness of the first portion AA1 of the ninth interlayer insulating film INS9 may be greater than the thickness of the second portion AA2 thereof. In this case, the side surface of the first portion AA1 of the ninth interlayer insulating film INS9 may be exposed, and the first electrode AND of each of the light emitting elements LE may be arranged on the exposed side surface of the first portion AA1 of the ninth interlayer insulating film INS9.

The first electrode AND of each of the light emitting elements LE may include (e.g., be formed of) at least one selected from among copper (Cu), aluminum (Al), tungsten (W), molybdenum (Mo), chromium (Cr), gold (Au), titanium (Ti), nickel (Ni), and neodymium (Nd), an alloy including at least one selected from among Cu, Al, W, Mo, Cr, Au, Ti, Ni, and Nd, and/or a transparent conductive oxide. For example, the first electrode AND of each of the light emitting elements LE may include titanium (Ti), titanium nitride (e.g., TiN), indium tin oxide (e.g., ITO), and/or indium zinc oxide (e.g., IZO), but embodiments of the present disclosure are not limited thereto.

The pixel defining film PDL may be arranged on a part of the first electrode AND of each of the light emitting elements LE. The pixel defining film PDL may cover the edge of the first electrode AND of each of the light emitting elements LE. The pixel defining film PDL may partition the first emission areas EA1, the second emission areas EA2, and the third emission areas EA3.

The pixel defining film PDL may include first to fourth pixel defining films PDL1, PDL2, PDL3, and PDL4.

The first pixel defining film PDL1 may be arranged on the first electrode AND of each of the light emitting elements LE. For example, the first pixel defining film PDL1 may cover a part of the top surface of the first electrode AND arranged on the optical auxiliary film OAL. Furthermore, the first pixel defining film PDL1 may cover the first electrode AND arranged on the side surface of the connection electrode ANC, the side surface of the reflective electrode RL, and the side surface of the optical auxiliary film OAL. The first pixel defining film PDL1 may be arranged on the top surface of the second portion AA2 of the ninth interlayer insulating film INS9.

A planarization film PNS is a film for flattening the stepped portion caused by the connection electrode ANC, the reflective electrode RL, and the optical auxiliary film OAL.

The planarization film PNS may be arranged on the first pixel defining film PDL1 covering the first electrode AND arranged on the side surface of the connection electrode ANC, the side surface of the reflective electrode RL, and the side surface of the optical auxiliary film OAL. The planarization film PNS may be arranged on the first pixel defining film PDL1 arranged on the second portion AA2 of the ninth interlayer insulating film INS9.

The planarization film PNS may be arranged between the connection electrodes ANC adjacent in the first direction DR1 or the second direction DR2. The planarization film PNS may be arranged between the reflective electrodes RL adjacent in the first direction DR1 or the second direction DR2. The planarization film PNS may be arranged between the optical auxiliary films OAL adjacent in the first direction DR1 or the second direction DR2.

The step layer STPL is not present in the second emission area EA2, whereas the step layer STPL is present in each of the first emission area EA1 and the third emission area EA3. Accordingly, the heights of the connection electrode ANC, the reflective electrode RL, and the optical auxiliary film OAL in the second emission area EA2 may be less than the heights of the connection electrode ANC, the reflective electrode RL, the step layer STPL, and the optical auxiliary film OAL in the first emission area EA1 and the third emission area EA3. Therefore, the planarization film PNS may cover the top surface of the first pixel defining film PDL1 arranged on the top surface of the first electrode AND arranged in the second emission area EA2.

In contrast, the top surface of the planarization film PNS may be flatly connected to the top surface of the first pixel defining film PDL1 arranged on the top surface of the first electrode AND arranged in the first emission area EA1 and the third emission area EA3. For example, the planarization film PNS may not cover the top surface of the first pixel defining film PDL1 arranged on the top surface of the first electrode AND arranged in each of the first emission area EA1 and the third emission area EA3.

The second pixel defining film PDL2 may be arranged on the first pixel defining film PDL1 and the planarization film PNS, the third pixel defining film PDL3 may be arranged on the second pixel defining film PDL2, and the fourth pixel defining film PDL4 may be arranged on the third pixel defining film PDL3. The first pixel defining film PDL1 and the third pixel defining film PDL3 may include (e.g., be formed of) a silicon nitride ($SiN_x$)-based inorganic film, whereas the second pixel defining film PDL2, the fourth pixel defining film PDL4, and the planarization film PNS may include (e.g., be formed of) a silicon oxide ($SiO_x$)-based inorganic film. The first pixel defining film PDL1 may include (e.g., be formed of) a material different from that of the planarization film PNS, and thus may serve as a stopper in a chemical mechanical polishing process for the planarization film PNS.

If (e.g., when) the planarization film PNS and the second pixel defining film PDL2 are both (e.g., simultaneously) formed as a silicon oxide ($SiO_x$)-based inorganic film, the planarization film PNS and the second pixel defining film PDL2 may be formed as a single film.

Because the length of the third pixel defining film PDL3 in one direction is less than the length of the fourth pixel defining film PDL4 in one direction, the bottom surface of the fourth pixel defining film PDL4 may be exposed without being covered by the third pixel defining film PDL3. For example, the third pixel defining film PDL3 and the fourth pixel defining film PDL4 may have an eaves-shaped or mushroom-shaped cross-sectional structure.

The light emitting stack IL may be arranged on the first electrode AND and the pixel defining film PDL. The light emitting stack IL may include the first stack layer IL1 and the second stack layer IL2 that emit different lights. If (e.g., when) the light emitting stack IL has a two-tandem structure, one of the first stack layer IL1 and/or the second stack layer IL2 may be to emit light that may include the wavelength range of at least one selected from among the first light, the second light, and the third light, and the other may be to emit light that may include the wavelength ranges of the other two lights. For example, the first stack layer IL1 may be to emit light that may include the wavelength range of the first light and the wavelength range of the third light, and the second stack layer IL2 may be to emit light that may include the wavelength range of the second light. Here, the first light may be light of a blue wavelength band, the second light may be light of a green wavelength band, and the third light may be light of a red wavelength band.

A charge generation layer for supplying charges to the second stack layer IL2 and supplying electrons to the first stack layer IL1 may be arranged between the first stack layer IL1 and the second stack layer IL2. The charge generation layer may include an n-type (kind) charge generation layer that supplies electrons to the first stack layer IL1 and a p-type (kind) charge generation layer that supplies holes to the second stack layer IL2. The N-type (kind) charge generation layer may include a dopant of a metal material.

The first stack layer IL1 may not be on (e.g., formed on) the bottom surface of the fourth pixel defining film PDL4 that may be exposed without being covered by the third pixel defining film PDL3, and thus may be cut off by the eaves-shaped or mushroom-shaped cross-sectional structure of the third pixel defining film PDL3 and the fourth pixel defining film PDL4. In this case, the first hole transport layer of the first stack layer IL1, and a charge generation layer arranged between the first stack layer IL1 and the second stack layer IL2 may also be cut off. Furthermore, although FIG. 10 illustrates that the second stack layer IL2 is connected without being cut off, the second hole transport layer of the second stack layer IL2 may be cut off, and the second electron transport layer of the second stack layer IL2 may be connected without being cut off. Therefore, it is possible to prevent or reduce a leakage current from flowing through the first hole transport layer of the first stack layer IL1, the second hole transport layer of the second stack layer IL2, and the charge generation layer between the adjacent emission areas EA1, EA2, and EA3. Accordingly, it is possible to prevent or reduce the light emitting stack IL in the adjacent emission areas EA1, EA2, and EA3 from emitting light other than the originally intended light due to the influence of the above current.

Although FIG. 10 illustrates a two-tandem structure in which the light emitting stack IL may include two stack layers IL1 and IL2, embodiments of the present disclosure are not limited thereto. For example, the light emitting stack IL may have a three-tandem structure including three stack layers as shown in FIG. 9. In this case, it may be designed such that the charge generation layer between the first stack layer IL1 and the second stack layer IL2, and the charge generation layer between the second stack layer IL2 and the third stack layer IL3 are cut off by adjusting the height of the third pixel defining film PDL3. In one or more embodiments, as shown in FIG. 9, the trench TRC penetrating the first pixel defining film PDL1, the planarization film PNS, the second pixel defining film PDL2, and the third pixel defining film PDL3 may be added. In this case, the trench TRC may penetrate at least a part of the ninth interlayer insulating film INS9, but embodiments of the present disclosure are not limited thereto.

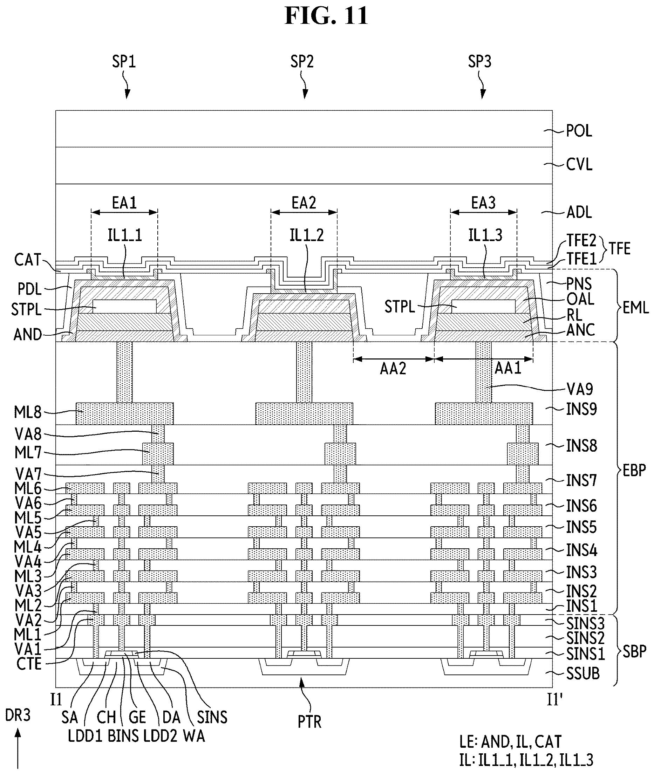

FIG. 11 is a schematic cross-sectional view illustrating still another example of the display panel taken along the line I1-I1' shown in FIG. 7.

The embodiment of FIG. 11 differs from the embodiment of FIG. 10 in that the light emitting elements LE have a single stack structure. In the embodiment of FIG. 11, redundant description of parts already described in the embodiment of FIG. 10 will not be provided.

Referring to FIG. 11, the pixel defining film PDL may be arranged on the ninth interlayer insulating film INS9 and the first electrodes AND, and the planarization film PNS may be arranged on the pixel defining film PDL. The planarization film PNS and the pixel defining film PDL may have openings exposing the first electrodes AND, and light emitting stack IL may be arranged on the first electrodes AND. For example, the pixel defining film PDL may have openings exposing the first electrodes AND in the first light emission area EA1, the second light emission area EA2 and the third light emission area EA3, and the planarization film PNS may have an opening exposing the first electrode AND in the second light emission area EA2. For example, the light emitting stack IL may include a first stack layer IL1_1, a second stack layer IL1_2, and a third stack layer IL1_3.

The first stack layer IL1_1 may be arranged on the first electrode AND exposed by the pixel defining film PDL in the first light emission area EA1. The first stack layer IL1_1 may also be arranged on a portion of the pixel defining film PDL. For example, the first stack layer IL1_1 may include a hole injecting layer, a hole transporting layer, a first light emitting layer, an electron transporting layer, and an electron injecting layer.

The second stack layer IL1_2 may be arranged on the first electrode AND exposed by the planarization film PNS and the pixel defining film PDL in the second light emission area EA2. The second stack layer IL1_2 may also be arranged on a portion of the planarization film PNS. For example, the second stack layer IL1_2 may include the hole injecting layer, the hole transporting layer, a second light emitting layer, the electron transporting layer, and the electron injecting layer.

The third stack layer IL1_3 may be arranged on the first electrode AND exposed by the pixel defining film PDL in the third light emission area EA3. The third stack layer IL1_3 may also be arranged on a portion of the pixel defining film PDL. For example, the third stack layer IL1_3 may include the hole injecting layer, the hole transporting layer, a third light emitting layer, the electron transporting layer, and the electron injecting layer.

The first stack layer IL1_1, the second stack layer IL1_2, and the third stack layer IL1_3 may be spaced and/or apart (e.g., spaced apart or separated) from each other, and thus the second to fourth pixel defining films PDL2, PDL3 and PDL4 utilized to separate the light emitting stack IL in the embodiment of FIG. 10 may not be provided.

The first stack IL1_1 of the first light emission area EA1 may be to emit first light, the second stack layer IL1_2 of the second light emission area EA2 may be to emit second light, and the third stack layer IL1_3 of the third light emission area EA3 may be to emit third light. Accordingly, the first to third color filters CF1, CF2 and CF3 of the optical layer OPL utilized in the embodiment of FIG. 9, the plurality of lenses LNS, and the filling layer FIL may not be provided.

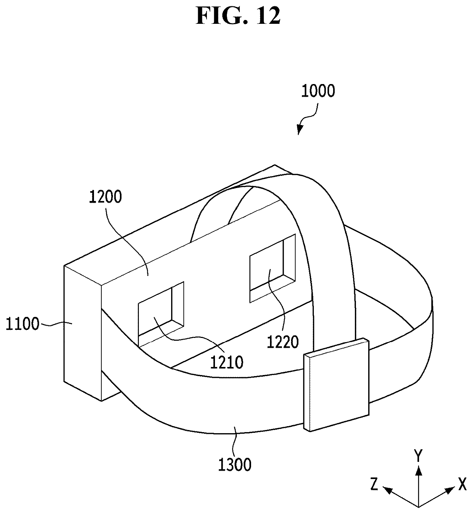

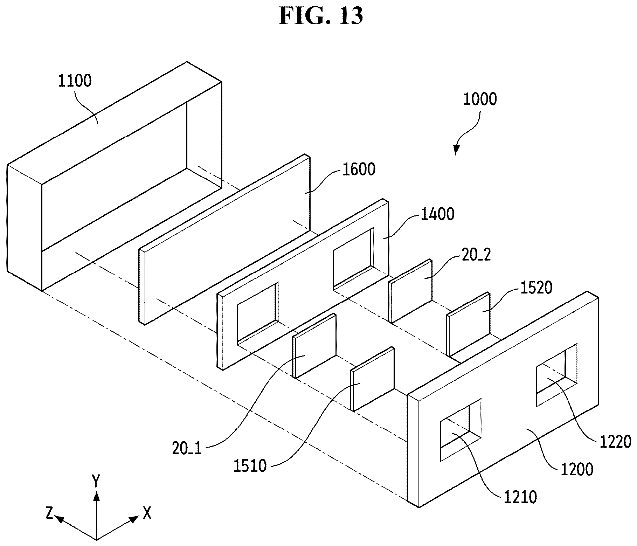

FIG. 12 is a schematic perspective view illustrating one example of a head mounted display. FIG. 13 is a schematic exploded perspective view illustrating the head mounted display shown in FIG. 12.

Referring to FIGS. 12 and 13, a head mounted display 1000 according to one or more embodiments may include a first display device 20_1, a second display device 20_2, a display device housing 1100, a housing cover 1200, a first eyepiece 1210, a second eyepiece 1220, a head mounted band 1300, a middle frame 1400, a first optical member 1510, a second optical member 1520, and a control circuit board 1600.

The first display device 20_1 may provide an image to the user's left eye, and the second display device 20_2 may provide an image to the user's right eye. Because each of the first display device 20_1 and the second display device 20_2 may be substantially the same as the display device 20 described in conjunction with FIGS. 3 to 11, the description of the first display device 20_1 and the second display device 20_2 will not be provided.

The first optical member 1510 may be arranged between the first display device 20_1 and the first eyepiece 1210. The second optical member 1520 may be arranged between the second display device 20_2 and the second eyepiece 1220. Each of the first optical member 1510 and the second optical member 1520 may include at least one convex lens.

The middle frame 1400 may be arranged between the first display device 20_1 and the control circuit board 1600 and between the second display device 20_2 and the control circuit board 1600. The middle frame 1400 may be to support and fix the first display device 20_1, the second display device 20_2, and the control circuit board 1600.

The control circuit board 1600 may be arranged between the middle frame 1400 and the display device housing 1100. The control circuit board 1600 may be connected to the first display device 20_1 and the second display device 20_2 through the connector. The control circuit board 1600 may be to convert an image source inputted from the outside into the digital video data DATA, and transmit the digital video data DATA to the first display device 20_1 and the second display device 20_2 through the connector.

The control circuit board 1600 may be to transmit the digital video data DATA corresponding to a left-eye image improved or optimized for the user's left eye to the first display device 20_1, and may be to transmit the digital video data DATA corresponding to a right-eye image improved or optimized for the user's right eye to the second display device 20_2. In one or more embodiments, the control circuit board 1600 may be to transmit substantially the same digital video data DATA to the first display device 20_1 and the second display device 20_2.

The display device housing 1100 may be to accommodate the first display device 20_1, the second display device 20_2, the middle frame 1400, the first optical member 1510, the second optical member 1520, and the control circuit board 1600. The housing cover 1200 is arranged to cover one open surface of the display device housing 1100. The housing cover 1200 may include the first eyepiece 1210 at which the user's left eye is located and the second eyepiece 1220 at which the user's right eye is located. FIGS. 12 and 13 illustrate that the first eyepiece 1210 and the second eyepiece 1220 are arranged separately, but embodiments of the present disclosure are not limited thereto. The first eyepiece 1210 and the second eyepiece 1220 may be combined into one.

The first eyepiece 1210 may be aligned with the first display device 20_1 and the first optical member 1510, and the second eyepiece 1220 may be aligned with the second display device 20_2 and the second optical member 1520. Therefore, the user may view, through the first eyepiece 1210, the image of the first display device 20_1 magnified as a virtual image by the first optical member 1510, and may view, through the second eyepiece 1220, the image of the second display device 20_2 magnified as a virtual image by the second optical member 1520.

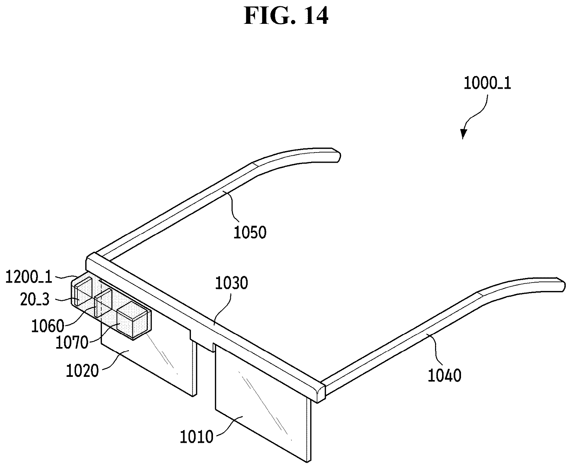

The head mounted band 1300 may be to secure the display device housing 1100 to the user's head such that the first eyepiece 1210 and the second eyepiece 1220 of the housing cover 1200 remain located on the user's left and right eyes, respectively. If (e.g., when) the display device housing 1200 is implemented to be lightweight and compact, the head mounted display 1000 may be provided with, as shown in FIG. 14, an eyeglass frame instead of the head mounted band 1300.

FIG. 14 is a schematic perspective view illustrating another example of a head mounted display.

Referring to FIG. 14, a head mounted display 1000_1 according to one or more embodiments may be an eyeglasses-type (kind) display device in which a display device housing 1200_1 may be implemented in a lightweight and compact manner. The head mounted display 1000_1 according to one or more embodiments may include a display device 20_3, a left eye lens 1010, a right eye lens 1020, a support frame 1030, temples 1040 and 1050, an optical member 1060, an optical path changing member 1070, and the display device housing 1200_1.

The display device housing 1200_1 may include the display device 20_3, the optical member 1060, and the optical path changing member 1070. The image displayed on the display device 20_3 may be magnified by the optical member 1060, and may be provided to the user's right eye through the right eye lens 1020 after the optical path thereof is changed by the optical path changing member 1070. As a result, the user may view an augmented reality image, through the right eye, in which a virtual image displayed on the display device 20_3 and a real image seen through the right eye lens 1020 are combined.

FIG. 14 illustrates that the display device housing 1200_1 is arranged at the right end of the support frame 1030, but embodiments of the present disclosure are not limited thereto. For example, the display device housing 1200_1 may be arranged at the left end of the support frame 1030, and in this case, the image of the display device 20_3 may be provided to the user's left eye. In one or more embodiments, the display device housing 1200_1 may be arranged at both (e.g., simultaneously) the left and right ends of the support frame 1030, and in this case, the user may view the image displayed on the display device 20_3 through both (e.g., simultaneously) the left and right eyes.

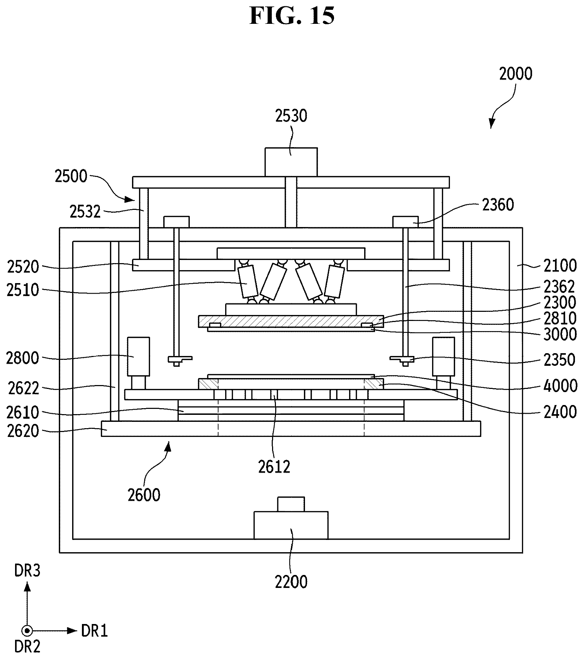

FIG. 15 is a schematic view for describing a deposition apparatus, according to one or more embodiments of the present disclosure.

Referring to FIG. 15, a deposition apparatus 2000 according to one or more embodiments may be utilized to form a deposition material layer on a substrate. For example, the deposition apparatus 2000 according to one or more embodiments may be utilized to form light emitting layers on a backplane substrate 3000 (or the display substrate) in a manufacturing process of the display panel 100 (see FIG. 3). For example, as illustrated in FIG. 11, the semiconductor backplane SBP and the light emitting element backplane EBP may be arranged on the backplane substrate 3000, and the pixel defining film PDL having electrode patterns such as first electrodes AND functioning as anode electrodes and openings exposing the first electrodes AND may be arranged on the light emitting element backplane EBP. As an example, the deposition apparatus 2000 may be to form first light emitting layers on the first electrodes AND of the first emission areas EA1. As another example, the deposition apparatus 2000 may be to form second light emitting layers on the first electrodes AND of the second emission areas EA2. As another example, the deposition apparatus 2000 may be to form third light emitting layers on the first electrodes AND of the third emission areas EA3.

The deposition apparatus 2000 may include a deposition source 2200 providing a vapor deposition material onto the backplane substrate 3000, a substrate chuck 2300 supporting the backplane substrate 3000, so that the backplane substrate 3000 faces the deposition source 2200, and a mask chuck 2400 arranged between the deposition source 2200 and the substrate chuck 2300 and supporting a deposition mask 4000, so that the deposition mask 4000 faces the backplane substrate 3000. The deposition source 2200, the substrate chuck 2300, and the mask chuck 2400 may be arranged in a process chamber 2100 (or an evaporation chamber).

The process chamber 2100 may include an internal space, and a deposition process for forming a deposition material layer on the backplane substrate 3000 may be performed in the internal space of the process chamber 2100. The process chamber 2100 may be connected to a vacuum pump, and a vacuum atmosphere may be created in the internal space of the process chamber 2100 by the vacuum pump. An opening for the entrance and exit of the backplane substrate 3000 and the deposition mask 4000 may be provided in one sidewall of the process chamber 2100, and may be opened and closed by a gate valve.

The deposition source 2200 may be arranged inside the process chamber 2100, and a deposition material may be accommodated inside the deposition source 2200. The deposition source 2200 may be to evaporate a deposition material such as an organic material, an inorganic material, and/or a conductive material toward the backplane substrate 3000, and the evaporated deposition material may be deposited on the backplane substrate 3000 through the deposition mask 4000. For example, the deposition source 2200 may be to evaporate an organic light emitting material for forming the light emitting layers on the backplane substrate 3000, and may include a heater for evaporating the organic light emitting material. The evaporated organic light emitting material may be deposited on the electrode patterns on the backplane substrate 3000 through the deposition mask 4000, and accordingly, the light emitting layers may be on (e.g., formed on) the electrode patterns of the backplane substrate 3000. It has been illustrated in FIG. 15 that the deposition source 2200 may be arranged on a central portion of a bottom surface of the process chamber 2100, but the deposition source 2200 may also be configured to be movable in a horizontal direction by a separate driver.

The substrate chuck 2300 may be arranged above the deposition source 2200, and may be to support the backplane substrate 3000 so that the backplane substrate 3000 faces the deposition source 2200. For example, the substrate chuck 2300 may be an electrostatic chuck gripping a rear surface of the backplane substrate 3000 by utilizing electrostatic force. For example, the electrode patterns such as the first electrodes AND may be arranged on a front surface of the backplane substrate 3000, and the substrate chuck 2300 may be to grip the rear surface of the backplane substrate 2300 so that the front surface of the backplane substrate 3000 faces downward, for example, faces the deposition source 2200.

A plurality of lift fingers 2350 for loading the backplane substrate 3000 onto the substrate chuck 2300 may be arranged in the process chamber 2100. The lift fingers 2350 may be arranged around the substrate chuck 2300 and the mask chuck 2400, and may be moved in a vertical direction by finger drivers 2360, respectively. For example, three or four lift fingers 2350 may be arranged around the substrate chuck 2300 and the mask chuck 2400, and may be moved in the third direction DR3 by the finger drivers 2360.

The backplane substrate 3000 may be carried into the process chamber 2100 by a transfer robot, and may be transferred from the transfer robot onto the lift fingers 2350 under the substrate chuck 2300. In this case, the rear surface of the backplane substrate 3000 may face a lower surface of the substrate chuck 2300, and the lift fingers 2350 may be to support edge portions of the front surface of the backplane substrate 3000. The finger drivers 2360 may be to raise the lift fingers 2350, so that the backplane substrate 3000 may be adjacent to the lower surface of the substrate chuck 2300, and the rear surface of the backplane substrate 3000 may be gripped on the lower surface of the substrate chuck 2300 by the electrostatic force.

The finger drivers 2360 may be arranged on an upper lid of the process chamber 2100, and may be respectively connected to the lift fingers 2350 through drive shafts 2362 extending in the vertical direction through the upper lid of the process chamber 2100. The finger drivers 2360 may be to move the lift fingers 2350 in the vertical direction to load or unload the backplane substrate 3000. In addition, the finger drivers 2360 may be to rotate the lift fingers 2350 based on the drive shafts 2362, respectively. For example, the finger drivers 2360 may be to rotate the lift fingers 2350 so that ends of the lift fingers 2350 do not overlap the substrate chuck 2300 and the mask chuck 2400, and accordingly, the movement of the lift fingers 2350 in the vertical direction may be enabled. In addition, the finger driver 2360 may be to rotate the lift fingers 2350 so that the ends of the lift fingers 2350 overlap the edge portions of the backplane substrate 3000 to support the edge portions of the backplane substrate 3000.

The deposition mask 4000 may be carried into the process chamber 2100 by a transfer robot, and may be transferred onto the lift fingers 2350 above the mask chuck 2400. Edge portions of the deposition mask 4000 may be put on the ends of the lift fingers 2350, and the finger drivers 2360 may be to lower the lift fingers 2350 to load the deposition mask 4000 onto the mask chuck 2400. In this case, edge portions of the mask chuck 2400 may be provided with recesses into which the ends of the lift fingers 2350 may be inserted, and the finger driver 2360 may be to rotate the lift fingers 2350 so that the lift fingers 2350 do not overlap the mask chuck 2400 after the deposition mask 4000 is loaded onto the mask chuck 2400.

The mask chuck 2400 may be to support the edge portion of the deposition mask 4000. For example, the mask chuck 2400 may be an electrostatic chuck gripping the edge portion of the deposition mask 4000 by utilizing electrostatic force. For example, the mask chuck 2400 may have a circular opening so that the deposition mask 4000 is exposed toward the deposition source 2200. For example, the mask chuck 2400 may have a disk shape or a rectangular plate shape (e.g., in a form of plates) having a circular opening.

The deposition apparatus 2000 may include chuck driving units (e.g., chuck drivers) for adjusting locations and postures of the backplane substrate 3000 and the deposition mask 4000. For example, the deposition apparatus 2000 may include a substrate chuck driving unit 2500 (e.g., a substrate chuck driver) moving the substrate chuck 2300 and a mask chuck driving unit 2600 (e.g., a mask chuck driver) moving the mask chuck 2400.

For example, the substrate chuck driving unit 2500 may be to move the substrate chuck 2300 in the first direction DR1, the second direction DR2, and a third direction DR3 to adjust the location of the backplane substrate 3000. In this case, the first direction DR1 may be a first horizontal direction, the second direction DR2 may be a second horizontal direction perpendicular to the first direction DR1, and the third direction DR3 may be a vertical direction. For example, the first direction DR1, the second direction DR2, and the third direction DR3 may be an X-axis direction, a Y-axis direction, and a Z-axis direction, respectively.

The substrate chuck driving unit 2500 may be to rotate the substrate chuck 2300 around a Z axis to adjust an azimuth of the backplane substrate 3000, for example, an angle at which the backplane substrate 3000 may be gripped on the lower surface of the substrate chuck 2300. In addition, the substrate chuck driving unit 2500 may be to rotate the substrate chuck 2300 around an X axis and may be to rotate the substrate chuck 2300 around a Y axis, to adjust a gradient of the backplane substrate 3000. For example, the substrate chuck driving unit 2500 may include a hexapod actuator 2510 providing motion of six degrees of freedom (e.g., X, Y, Z, θx, θy, and θz).

The substrate chuck driving unit 2500 may include a substrate stage 2520 on which the hexapod actuator 2510 may be mounted and a second actuator 2530 connected to the substrate stage 2520. The substrate stage 2520 may be arranged in the horizontal direction within the process chamber 2100, and the second actuator 2530 may be arranged above the process chamber 2100. The second actuator 2530 may be connected to the substrate stage 2520 by a plurality of drive shafts 2532 extending in the third direction DR3, for example, the vertical direction (e.g., a Z-axis direction) through the upper lid of the process chamber 2100, and may be to move the substrate stage 2520 in a central axis direction of the hexapod actuator 2510, for example, the vertical direction. For example, the second actuator 2530 may be configured by utilizing a brushless direct current (DC) motor, a linear motor, a direct drive (DD) motor, and/or the like, and may adjust a height of the substrate chuck 2300 to load or unload the backplane substrate 3000.

The hexapod actuator 2510 may include a first platform connected to the substrate chuck 2300, a second platform mounted on the substrate stage 2520, and six sub-actuators arranged between the first platform and the second platform. For example, the six sub-actuators may be each configured by utilizing a brushless DC motor, a voice coil linear motor, a step motor, a DD motor, a servo motor, and/or the like, and may be to move and rotate the first platform to adjust a location of the backplane substrate 3000 in the horizontal direction, a location of the backplane substrate 3000 in the vertical direction, the azimuth of the backplane substrate 3000, and the gradient of the backplane substrate 3000.

The mask chuck driving unit 2600 may be to move and rotate the mask chuck 2400 to adjust a position of the deposition mask 4000 in the horizontal direction and an azimuth of the deposition mask 4000, for example, an angle at which the deposition mask 4000 may be put on the mask chuck 2400. The mask chuck driving unit 2600 may be to move the mask chuck 2400 in a direction parallel to the deposition mask 4000 and rotate the mask chuck 2400 based on a central axis of the mask chuck 2400. For example, the mask chuck driving unit 2600 may be to move the mask chuck 2400 in the first direction DR1 (e.g., a X-axis direction) and the second direction DR2 (e.g., a Y-axis direction), and may be to rotate the mask chuck 2400 based on the third direction DR3 (e.g., a Z-axis direction).

The mask chuck driving unit 2600 may include, for example, a piezo actuator 2610 providing motion of three degrees of freedom (e.g., X, Y, and θz). The piezo actuator 2610 may have an opening that may communicate with the circular opening of the mask chuck 2400. The mask chuck 2400 may be spaced and/or apart (e.g., spaced apart or separated) from the piezo actuator 2610 in an upward direction by a selected gap. For example, a plurality of support members 2612 may be arranged on the piezo actuator 2610, and the mask chuck 2400 may be arranged on the plurality of support members 2612.

The mask chuck driving unit 2600 may include a mask stage 2620 arranged in the horizontal direction within the process chamber 2100 and supporting the piezo actuator 2610. For example, the mask stage 2620 may have an opening that communicates with the opening of the piezo actuator 2610, and may be supported by a plurality of posts 2622 connected to the upper lid of the process chamber 2100.

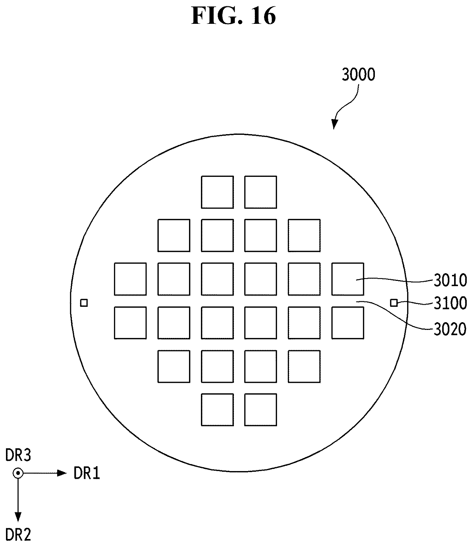

FIG. 16 is a schematic bottom view for describing a backplane substrate illustrated in FIG. 15.

Referring to FIG. 16, the backplane substrate 3000 may include a plurality of display cell regions 3010 and a scribe lane region 3020 arranged between the display cell regions 3010. The display cell regions 3010 may be arranged in a matrix form along the first direction DR1 and the second direction DR2, as illustrated in FIG. 16, and may be individualized into a plurality of display panels 100 (see FIG. 3) through a dicing process after a display manufacturing process is completed. For example, the first direction DR1 may be a first horizontal direction, and the second direction DR2 may be a second horizontal direction perpendicular to the first direction DR1. In addition, each of the display cell regions 3010 may have, for example, a rectangular shape as illustrated in FIG. 16.

For example, each of the display cell regions 3010 may include a semiconductor backplane SBP and a light emitting element backplane EBP arranged on the semiconductor backplane SBP, as illustrated in FIG. 11. In addition, each of the display cell regions 3010 may include a plurality of electrode patterns, such as a plurality of first electrodes AND, arranged on the light emitting element backplane EBP and a pixel defining film PDL arranged on the light emitting element backplane EBP and the first electrodes AND. In this case, the electrode patterns of the display cell regions 3010 may be arranged on the front surface of the backplane substrate 3000, and the substrate chuck 2300 may be to grip the rear surface of the backplane substrate 3000 so that the electrode patterns of the display cell regions 3010 face downward, for example, face the deposition source 2200.

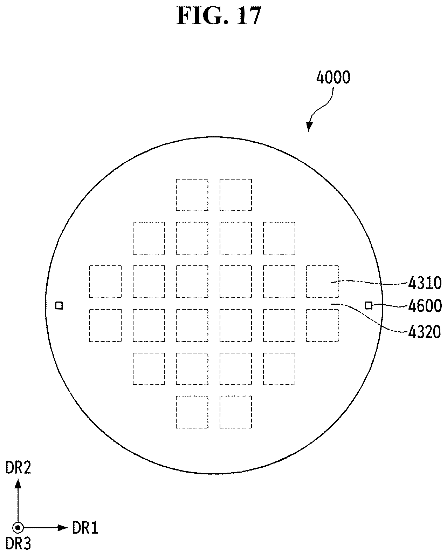

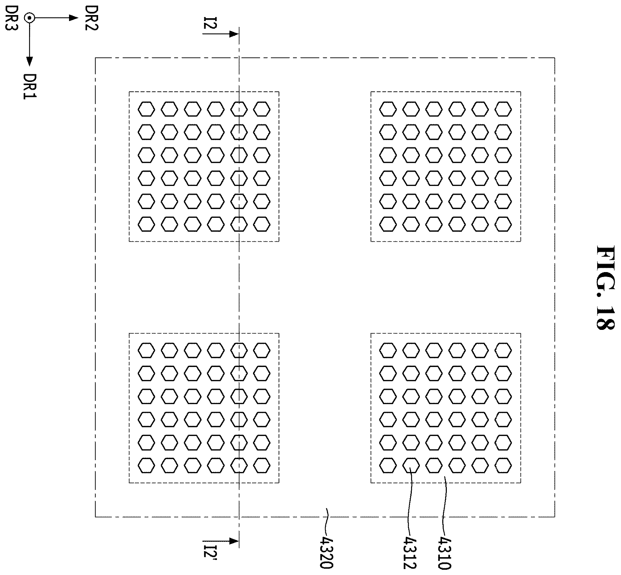

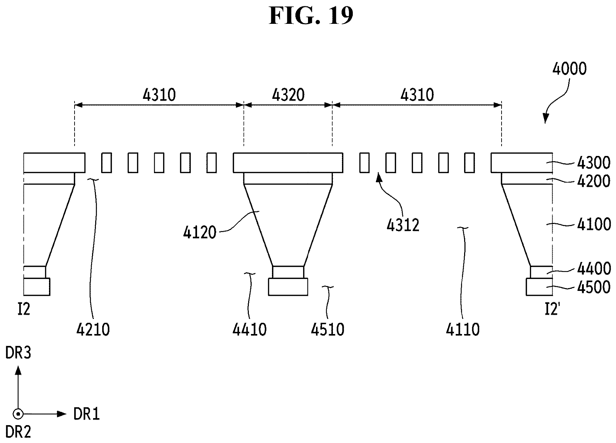

FIG. 17 is a schematic plan view for describing a deposition mask illustrated in FIG. 15. FIG. 18 is a schematic enlarged plan view for describing mask cell regions illustrated in FIG. 17. FIG. 19 is a schematic cross-sectional view taken along the line l2-l2' illustrated in FIG. 18.

Referring to FIGS. 17 to 19, the deposition mask 4000 may include mask cell regions 4310 respectively corresponding to the display cell regions 3010 of the backplane substrate 3000 and a grid region 4320 corresponding to the scribe lane regions 3020 of the backplane substrate 3000. Each of the mask cell regions 4310 may have a plurality of pixel openings 4312 exposing the first electrodes AND of the backplane substrate 300 in a deposition process. For example, the deposition mask 4000 may include a mask substrate 4100, an intermediate inorganic film 4200 arranged on the mask substrate 4100, and a membrane 4300 arranged on the intermediate inorganic film 4200. In this case, the membrane 4300 may include a plurality of mask cell regions 4310 and a grid region 4320 around (e.g., surrounding) the mask cell regions 4310, and each of the mask cell regions 4310 may have a plurality of pixel openings 4312.

The mask substrate 4100 may have cell openings 4110 respectively corresponding to the mask cell regions 4310, and may include a rib region 4120 defining the cell openings 4110. The intermediate membrane 4200 may have intermediate openings 4210 respectively arranged on the cell openings 4110. In this case, the mask cell regions 4310 of the membrane 4300 may be respectively located on the intermediate openings 4210, and the pixel openings 4312 of the membrane 4300 may be connected to the cell openings 4110 through the intermediate openings 4210.

According to one or more embodiments, the mask cell regions 4310 of the membrane 4300 may be exposed toward the deposition source 2200 through the cell openings 4110 of the mask substrate 4100 and the intermediate openings 4210 of the intermediate inorganic film 4200, and the pixel openings 4312 may be formed to penetrate through the mask cell regions 4310. In this case, for a period in which the deposition process is performed, the vapor deposition material provided from the deposition source 2200 may be deposited on the first electrodes AND of the backplane substrate 3000 through the cell openings 4110, the intermediate openings 4210, and the pixel openings 4312.

The mask cell regions 4310 may be arranged in a matrix form along the first direction DR1 and the second direction DR2, as illustrated in FIG. 17. For example, the first direction DR1 may be a first horizontal direction, and the second direction DR2 may be a second horizontal direction perpendicular to the first direction DR1. The mask cell regions 4310 may have, for example, a rectangular shape as illustrated in FIG. 17, and the pixel openings 4312 may be arranged to correspond to the first electrodes AND of at least one selected from among the first emission areas EA1, the second emission areas EA2, and the third emission areas EA3.

According to one or more embodiments, if (e.g., when) the backplane substrate 3000 is positioned on the deposition mask 4000 in the deposition process, the electrode patterns, such as the first electrodes AND, of the backplane substrate 3000 may be located on the pixel openings 4312 of the deposition mask 4000, and accordingly, the electrode patterns of the backplane substrate 3000 may face the deposition source 2200 through the pixel openings 4312. Subsequently, the vapor deposition material may be provided from the deposition source 2200 onto the electrode patterns of the backplane substrate 3000 through the pixel openings 4312 of the deposition mask 4000, and accordingly, deposition material layers may be on (e.g., formed on) the electrode patterns of the backplane substrate 3000.

The mask substrate 4100 may include (e.g., be made of) single crystal silicon. For example, a single crystal silicon substrate having a thickness of about 700 $\mu$m to about 800 $\mu$m, for example, about 775 $\mu$m, may be utilized as the mask substrate 4100.

The intermediate inorganic film 4200 and the membrane 4300 may be arranged on a front surface of the mask substrate 4100, and a second intermediate inorganic film 4400 and a rear inorganic film 4500 may be arranged on a rear surface of the mask substrate 4100. For example, the second intermediate inorganic film 4400 may be arranged on the rear surface of the mask substrate 4100, and the rear inorganic film 4500 may be arranged on the second intermediate inorganic film 4400. The second intermediate inorganic film 4400 and the rear inorganic film 4500 may have respectively second intermediate openings 4410 and rear openings 4510 that may communicate with the cell openings 4110, and the rear inorganic film 4500 may function as an etching mask in an etching process for forming the cell openings 4110. In this case, the mask cell regions 4310 may be exposed toward the deposition source 2200 through the intermediate openings 4210, the cell openings 4110, the second intermediate openings 4410, and the rear openings 4510.

According to one or more embodiments, the membrane 4300 may include (e.g., be made of) a material having an etching selectivity with respect to the intermediate inorganic film 4200 and the mask substrate 4100. For example, the intermediate inorganic film 4200 may include (e.g., be made of) silicon oxide (e.g., $SiO_x$), and the membrane 4300 may include (e.g., be made of) silicon nitride (e.g., $SiN_x$). According to one or more embodiments, the intermediate inorganic film 4200 may include (e.g., be made of) substantially the same material as the second intermediate inorganic film 4400, and the membrane 4300 may include (e.g., be made of) substantially the same material as the rear inorganic film 4500. For example, the intermediate inorganic film 4200 and the second intermediate inorganic film 4400 may be concurrently (e.g., simultaneously) formed through a thermal oxidation process, and the membrane 4300 and the rear inorganic film 4500 may be concurrently (e.g., simultaneously) formed through a chemical vapor deposition (CVD) process.

The pixel openings 4312 of the membrane 4300 may be formed by an anisotropic etching process such as a reactive ion etching (RIE) process. For example, the pixel openings 4312 exposing the intermediate inorganic film 4200 may be formed by forming a photoresist pattern exposing portions where the pixel openings 4312 may be to be formed on the membrane 4300 and then performing an RIE process utilizing the photoresist pattern as an etching mask. In this case, the pixel openings 4312 may be formed to penetrate through the membrane 4300, and the intermediate inorganic film 4200 may function as an etch-stop film in the RIE process.

The second intermediate openings 4410 and the rear openings 4510 may be formed by an anisotropic etching process such as an RIE process. For example, the second intermediate openings 4410 and the rear openings 4510 exposing the rear surface of the mask substrate 4100 may be formed by forming a photoresist pattern exposing portions where the rear openings 4510 may be to be formed on the rear inorganic film 4500 and then performing an RIE process utilizing the photoresist pattern as an etching mask.

The cell openings 4110 of the mask substrate 4100 may be formed so that the intermediate inorganic film 4200 may be exposed, through an anisotropic etching process utilizing the second intermediate inorganic film 4400 and the rear inorganic film 4500 as etching masks. For example, a single crystal silicon substrate may be utilized as the mask substrate 4100, and the cell openings 4110 may be formed through a wet etching process utilizing an etchant such as a tetramethyl ammonium hydroxide (TMAH) solution, a potassium hydroxide (KOH) solution, and/or the like. In this case, a <100> crystal direction of the single crystal silicon substrate utilized as the mask substrate 4100 may be the third direction DR3, and accordingly, each of the cell openings 4110 may have a width that may gradually decrease from the rear surface of the mask substrate 4100 toward the front surface of the mask substrate 4100 through the wet etching process. For example, inner side surfaces of the cell openings 4110 may have an inclination angle of about 54.7° with respect to the rear surface of the mask substrate 4100. In the context of disclosure and unless defined otherwise, the term "gradually" refers to the continuous and uniform narrowing of the cell openings 4110 from the rear surface toward the front surface of the mask substrate 4100. This tapering effect is achieved through a wet anisotropic etching process, such as one utilizing tetramethyl ammonium hydroxide (TMAH) and/or potassium hydroxide (KOH), applied to a single crystal silicon substrate. When the silicon substrate has a <100> crystal orientation, the etching process exploits the differing etch rates of various crystallographic planes-specifically, the slower etching <111> planes relative to the <100> planes. As a result, the inner side surfaces of the cell openings form at an inclination angle of approximately (about) 54.7° with respect to the rear surface of the substrate. This angle corresponds to the geometric relationship between the <100> and <111> planes in the silicon crystal structure. The outcome is a smooth, sloped profile in which the width of each cell opening decreases in a consistent and progressive manner as the etching proceeds from the rear to the front surface, rather than forming abrupt or stepped transitions.

The intermediate openings 4210 of the intermediate inorganic film 4200 may be formed by a wet etching process after the cell openings 4110 of the mask substrate 4100 are formed. For example, if (e.g., when) the intermediate inorganic film 4200 includes (e.g., is made of) silicon oxide (e.g., $SiO_x$), the intermediate openings 4210 may be formed by a wet etching process utilizing an etchant such as a buffered oxide etchant (BOE) or a diluted hydrofluoric acid (diluted HF), and accordingly, the pixel openings 4312 of the membrane 4300 may be connected to the cell openings 4110 of the mask substrate 4100 through the intermediate openings 4210 of the intermediate inorganic film 4200.

As another example, the second intermediate inorganic film 4400 may not be provided. In this case, the rear inorganic film 4500 may be arranged on the rear surface of the mask substrate 4100. In addition, the intermediate inorganic film 4200 may be formed through a thermal oxidation process or a CVD process, and the rear inorganic film 4500 may be formed concurrently (e.g., simultaneously) with the membrane 4300 or formed separately from the membrane 4300. As another example, both (e.g., simultaneously) the intermediate inorganic film 4200 and the second intermediate inorganic film 4400 may not be provided. In this case, the membrane 4300 may be arranged on the front surface of the mask substrate 4100, and the rear inorganic film 4500 may be arranged on the rear surface of the mask substrate 4100. In addition, the rear inorganic film 4500 may be formed concurrently (e.g., simultaneously) with the membrane 4300 or formed separately from the membrane 4300.

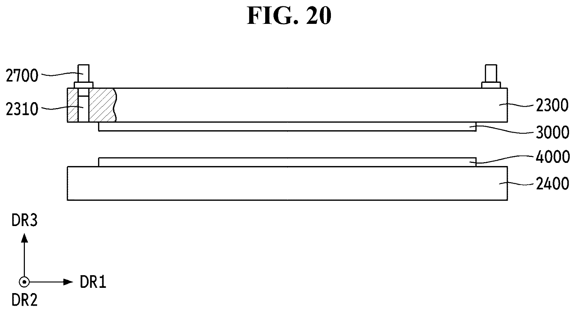

FIG. 20 is a schematic front view for describing a substrate chuck and a mask chuck illustrated in FIG. 15.

Referring to FIG. 20, after the backplane substrate 3000 and the deposition mask 4000 are loaded onto the substrate chuck 2300 and the mask chuck 2400, respectively, the substrate chuck driving unit 2500 may be to locate the backplane substrate 3000 on the deposition mask 4000. For example, the second actuator 2530 may be to lower the substrate chuck 2300 so that the backplane substrate 3000 is adjacent to the deposition mask 4000. The hexapod actuator 2510 may adjust a gap between the backplane substrate 3000 and the deposition mask 4000, and may adjust a gradient of the substrate chuck 2300 to adjust parallelism between the substrate chuck 2300 and the mask chuck 2400.

According to one or more embodiments, the deposition apparatus 2000 may include a plurality of gap sensors 2700 for measuring gaps between the substrate chuck 2300 and the mask chuck 2400. For example, the plurality of gap sensors 2700 for measuring the gaps between the substrate chuck 2300 and the mask chuck 2400 may be arranged on edge portions of the substrate chuck 2300, and may measure distances to the mask chuck 2400 through through holes 2310 penetrating through the edge portions of the substrate chuck 2300.

The hexapod actuator 2510 may adjust the parallelism between the substrate chuck 2300 and the mask chuck 2400 based on measured values of the gap sensors 2700. For example, the hexapod actuator 2510 may adjust a height of the substrate chuck 2300 to a first height, so that the gap between the backplane substrate 3000 and the deposition mask 4000 may be several hundreds of micrometers, for example, about 100 $\mu$m to about 200 $\mu$m, and then adjust the gradient of the substrate chuck 2300 based on the measured values of the gap sensors 2700. For example, capacitive proximity sensors and/or confocal sensors may be utilized as the gap sensors 2700, and the hexapod actuator 2510 may adjust the parallelism between the substrate chuck 2300 and the mask chuck 2400 by adjusting the gradient of the substrate chuck 2300. As a result, the parallelism between the backplane substrate 3000 supported by the substrate chuck 2300 and the deposition mask 4000 supported by the mask chuck 2400 may be adjusted.

According to one or more embodiments, after the parallelism between the substrate chuck 2300 and the mask chuck 2400 is adjusted, the hexapod actuator 2510 may adjust the height of the substrate chuck 2300 to a second height, so that the gap between the backplane substrate 3000 and the deposition mask 4000 may be several tens of micrometers, for example, about 10 $\mu$m to about 50 $\mu$m.

According to one or more embodiments, after the height of the substrate chuck 2300 is adjusted to the second height, the parallelism between the substrate chuck 2300 and the mask chuck 2400 may be secondarily adjusted. For example, although not illustrated in FIG. 20, a plurality of second gap sensors may be arranged on the edge portions of the substrate chuck 2300, and may measure distances to the mask chuck 2400 through the through holes 2310 penetrating through the edge portions of the substrate chuck 2300. The hexapod actuator 2510 may adjust the gradient of the substrate chuck 2300 based on measured values of the second gap sensors, and accordingly, the parallelism between the substrate chuck 2300 and the mask chuck 2400 may be secondarily adjusted. In this case, the second gap sensors may have a higher resolution than the gap sensors 2700. For example, capacitive proximity sensors may be utilized as the gap sensors 2700, and confocal sensors may be utilized as the second gap sensors. By secondarily adjusting the parallelism between the substrate chuck 2300 and the mask chuck 2400 as described above, the parallelism between the backplane substrate 3000 and the deposition mask 4000 may be more precisely adjusted.

After the parallelism between the backplane substrate 3000 and the deposition mask 4000 is adjusted, alignment between the backplane substrate 3000 and the deposition mask 4000 may be performed. According to one or more embodiments, the backplane substrate 3000 may include a substrate alignment key 3100 utilized for alignment with the deposition mask 4000. For example, as illustrated in FIG. 16, a plurality of substrate alignment keys 3100 may be arranged on the edge portions of the backplane substrate 3000. It has been illustrated in FIG. 16 that the backplane substrate 3000 may include two substrate alignment keys 3100, but the number of substrate alignment keys 3100 may be suitably changed, and accordingly, the scope of the present disclosure is not limited by the number of substrate alignment keys 3100.

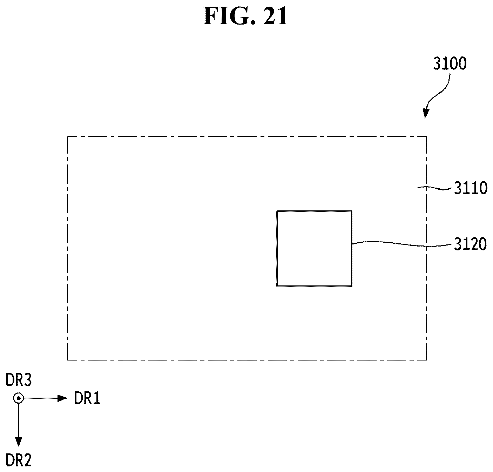

FIG. 21 is a schematic bottom view for describing a substrate alignment key illustrated in FIG. 16.

Referring to FIG. 21, the substrate alignment key 3100 according to one or more embodiments may include a key region 3110 and a key pattern 3120 formed in or on the key region 3110. For example, the pixel defining film PDL may include the key region 3110, and the key pattern 3120 may have an approximately rectangular shape in plan view. In addition, for example, the key pattern 3120 may include a metal such as aluminum (Al), tungsten (W), copper (Cu), molybdenum (Mo), chromium (Cr), gold (Au), titanium (Ti), nickel (Ni), and/or neodymium (Nd).

According to one or more embodiments, the deposition mask 4000 may include a mask alignment key 4600 utilized for alignment with the backplane substrate 3000. For example, as illustrated in FIG. 17, a plurality of mask alignment keys 4600 may be arranged on edge portions of the deposition mask 4000. It has been illustrated in FIG. 17 that the deposition mask 4000 may include two mask alignment keys 4600, but the number of mask alignment keys 4600 may be suitably changed, and accordingly, the scope of the present disclosure is not limited by the number of mask alignment keys 4600.

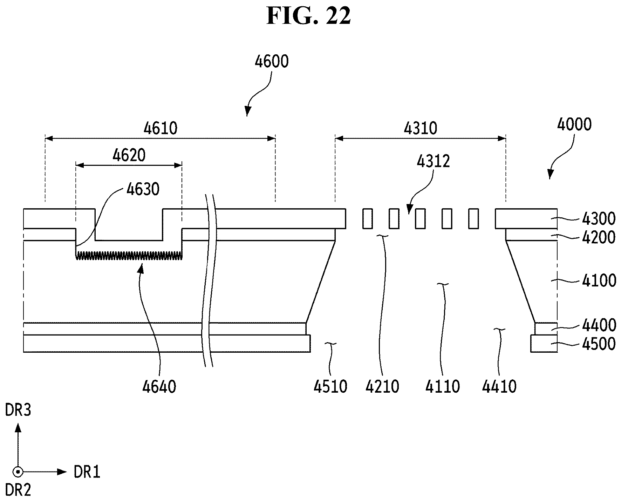

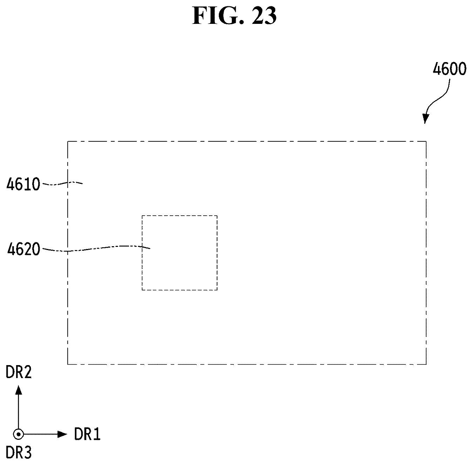

FIG. 22 is a schematic cross-sectional view for describing the mask alignment key illustrated in FIG. 17. FIG. 23 is a schematic plan view for describing the mask alignment key illustrated in FIG. 17.

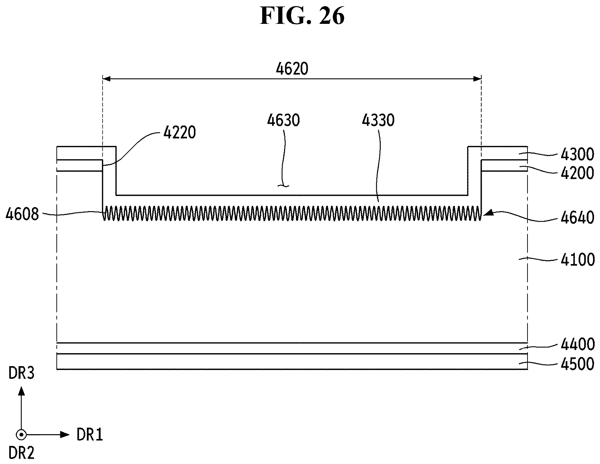

Referring to FIGS. 22 and 23, the mask alignment key 4600 may include a pattern region 4620 and a peripheral region 4610 around (e.g., surrounding) the pattern region 4620, and the pattern region 4620 may include a surface modified region 4640 having a greater surface roughness than the peripheral region 4610. According to one or more embodiments, the pattern region 4620 may be formed at a surface portion, for example, a front surface portion, of the mask substrate 4100. In this case, the surface portion of the mask substrate 4100 around (e.g., surrounding) the pattern region 4620 may be utilized as the peripheral region 4610 of the mask alignment key 4600. For example, the pattern region 4620 may have a recess 4630 (see FIG. 26) formed in the surface portion of the mask substrate 4100, and the surface modified region 4640 may be formed in a bottom surface portion of the recess 4630. In addition, for example, the pattern region 4620 may have an approximately rectangular shape, and the recess 4630 may have a rectangular shape that may be substantially the same as the pattern region 4620 in plan view.

According to one or more embodiments, the pattern region 4620 of the mask alignment key 4600 may be formed by an anisotropic etching process. For example, the pattern region 4620 of the mask alignment key 4600 may be formed by an RIE process such as a Bosch process. For example, a key opening 4220 (see FIG. 26) exposing the surface portion of the mask substrate 4100, for example, a portion where the pattern region 4620 is to be formed, may be formed through the intermediate inorganic film 4200, and the recess 4630 and the surface modified region 4640 may be formed by removing the surface portion of the mask substrate 4100 exposed through the key opening 4220 through an RIE process.

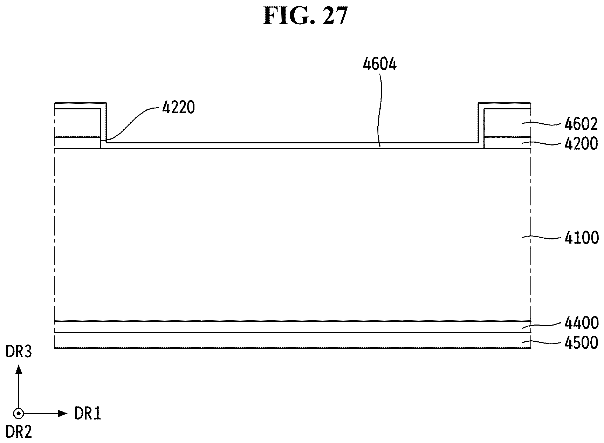

The RIE process for forming the recess 4630 and the surface modified region 4640 may be performed by utilizing a passivation gas for forming a polymer layer 4604 (see FIG. 27), such as $CF_4$, $C_2F_6$, $C_3F_6$, $C_4F_6$, and/or $C_4F_8$, a sputtering gas for anisotropically etching the polymer layer 4604 and the mask substrate 4100, such as Ar, He, Ne, Xe, and/or $O_2$, and a reaction gas for isotropically etching the mask substrate 4100, such as $SF_6$, $CHF_3$, $CH_3F$, $CH_2F_2$, $CBrF_3$, $CCl_4$, $O_2$, and/or $H_2$.

Referring to FIG. 15 again, the deposition apparatus 2000 may include a camera 2800 for detecting the substrate alignment key 3100 and the mask alignment key 4600. For example, the deposition apparatus 2000 may include a plurality of cameras 2800 for detecting the substrate alignment keys 3100 and the mask alignment keys 4600. It has been illustrated in FIG. 15 that the deposition apparatus 2000 may include two cameras 2800, but the number of cameras 2800 may be changed depending on the numbers of substrate alignment keys 3100 and mask alignment keys 4600, and accordingly, the scope of the present disclosure is not limited by the number of cameras 2800.

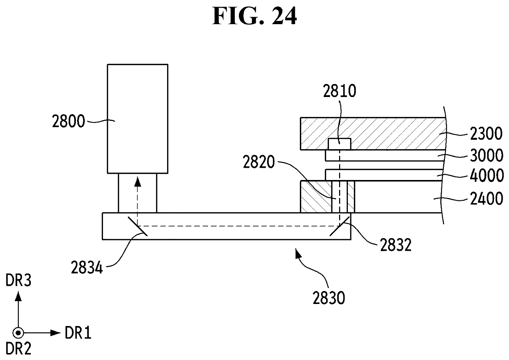

FIG. 24 is a schematic cross-sectional view for describing a camera and an illumination portion illustrated in FIG. 15.

Referring to FIG. 24, the camera 2800 for detecting the substrate alignment key 3100 and the mask alignment key 4600 may be arranged on one side of the mask chuck 2400. According to one or more embodiments, the deposition apparatus 2000 may include an illumination portion 2810 providing light that may be transmitted through the backplane substrate 3000 and the deposition mask 4000, and the camera 2800 may be to detect the light transmitted through the backplane substrate 3000 and the deposition mask 4000. For example, the light provided from the illumination portion 2810 may be transmitted through the substrate alignment key 3100 and the mask alignment key 4600, and the light transmitted through the substrate alignment key 3100 and the mask alignment key 4600 may be detected by the camera 2800.

The illumination portion 2810 may be arranged within an edge portion of the lower surface of the substrate chuck 2300, and may be to provide infrared light that may be transmitted through the backplane substrate 3000 and the deposition mask 4000. For example, the illumination portion 2810 may include an infrared lamp in (e.g., mounted in) the substrate chuck 2300, and a through hole 2820 through which the light transmitted through the backplane substrate 3000 and the deposition mask 4000 passes may be provided at an edge portion of the mask chuck 2400. The infrared lamp may be to provide near infrared (NIR) or shortwave infrared (SWIR) light, and the light transmitted through the backplane substrate 3000 and the deposition mask 4000 may be guided to the camera 2800 via an optical unit 2830 (or a prism unit) arranged under the mask chuck 2400. For example, the infrared lamp may be to provide infrared light having a wavelength of about 1000 nm to about 1200 nm.

The optical unit 2830 may include reflectors 2832 and 2834 for guiding the light transmitted through the backplane substrate 3000 and the deposition mask 4000 to the camera 2800, and the camera 2800 may obtain image information from the light guided through the optical unit 2830. For example, the image information may include location information of the substrate alignment key 3100 and the mask alignment key 4600, and the substrate chuck driving unit 2500 and/or the mask chuck driving unit 2600 may be to move and/or rotate the substrate chuck 2300 and/or the mask chuck 2400 to align the backplane substrate 3000 and the deposition mask 4000 with each other based on the image information obtained by the camera 2800.

According to one or more embodiments, alignment between the backplane substrate 3000 and the deposition mask 4000 may be performed after the adjustment of the parallelism between the substrate chuck 2300 and the mask chuck 2400 is performed. As an example, the camera 2800 may obtain image information including the substrate alignment key 3100 and the mask alignment key 4600, and the hexapod actuator 2510 of the substrate chuck driving unit 2500 may be to move the substrate chuck 2300 in the first direction DR1 and the second direction DR2 and rotate the substrate chuck 2300 based on the third direction DR3, based on the image information. As another example, the piezo actuator 2610 of the mask chuck driving unit 2600 may be to move the mask chuck 2400 in the first direction DR1 and the second direction DR2 and rotate the mask chuck 2400 based on the third direction DR3, based on the image information.

According to one or more embodiments, after the alignment between the backplane substrate 3000 and the deposition mask 4000 is performed, the backplane substrate 3000 may be located on the deposition mask 4000. As an example, the hexapod actuator 2510 may adjust the height of the substrate chuck 2300, so that the gap between the backplane substrate 3000 and the deposition mask 4000 becomes a selected gap, for example, a gap of about several micrometers. As another example, the hexapod actuator 2510 may adjust the height of the substrate chuck 2300, so that the backplane substrate 3000 comes into contact with the deposition mask 4000.

After the backplane substrate 3000 is positioned on the deposition mask 4000, the deposition source 2200 may provide the vapor deposition material onto the backplane substrate 3000 through the deposition mask 4000, and accordingly, the deposition material layer may be on (e.g., formed on) the backplane substrate 3000. For example, the first electrodes AND of the backplane substrate 3000 may be located on the pixel openings 4312 of the deposition mask 4000, respectively, by the alignment between the backplane substrate 3000 and the deposition mask 4000. Subsequently, the deposition source 2200 may be to evaporate an organic material for forming the light emitting layers on the first electrodes AND of the backplane substrate 3000. The evaporated organic material may be provided onto the first electrodes AND of the backplane substrate 3000 through the pixel openings 4312 of the deposition mask 4000, and accordingly, the light emitting layers may be on (e.g., formed on) the first electrodes AND of the backplane substrate 3000.

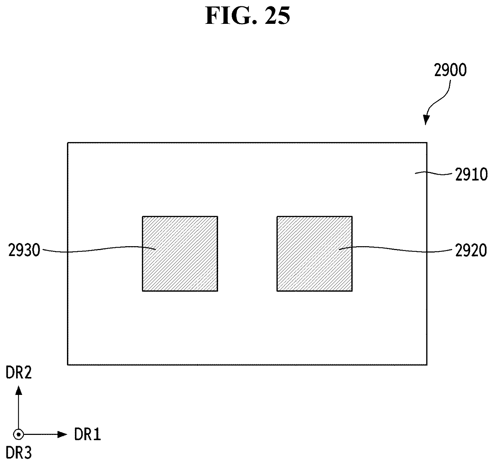

FIG. 25 is a schematic view for describing an image obtained by the camera illustrated in FIG. 24.

Referring to FIG. 25, the camera 2800 may detect the light transmitted through the substrate alignment key 3100 and the mask alignment key 4600. An image 2900 detected by the camera 2800 may include a key pattern image 2920 of the substrate alignment key 3100 and a surface modified region image 2930 of the mask alignment key 4600. In this case, light incident on the key pattern 3120 of the substrate alignment key 3100 may be reflected by the key pattern 3120, and accordingly, the key pattern 3120 of the substrate alignment key 3100 may be displayed relatively very dark in the detected image 2900.

According to one or more embodiments, light incident on the surface modified region 4640 may be scattered and/or refracted by the surface modified region 4640, and accordingly, the surface modified region 4640 of the mask alignment key 4600 may be displayed relatively very dark in the detected image 2900. In addition, light transmitted through the key region 3110 of the substrate alignment key 3100 and the peripheral region 4610 of the mask alignment key 4600 may be detected by the camera 2800, and the key region 3110 of the substrate alignment key 3100 and the peripheral region 4610 of the mask alignment key 4600 may be displayed as a peripheral image 2910 around (e.g., surrounding) the key pattern image 2920 and the surface modified region image 2930 in the detected image 2900. In this case, the peripheral image 2910 may be displayed brighter than the key pattern image 2920 and the surface modified region image 2930.

According to one or more embodiments, to improve a recognition rate of the mask alignment key 4600, for example, a recognition rate of the surface modified region 4640, from the detected image 2900, a contrast (C) between the peripheral image 2910 and the surface modified region image 2930 may be about 0.4 or more. For example, the contrast (C) between the peripheral image 2910 and the surface modified region image 2930 may be calculated by the following Equation.

$$C = \frac{GL_{MAX} - GL_{MIN}}{GL_{MAX} + GL_{MIN}}$$

In the above Equation, $GL_{MAX}$ may refer to a maximum gray level of the peripheral image 2910, and $GL_{MIN}$ refers to a minimum gray level of the surface modified region image 2930. For example, $GL_{MAX}$ may refer to a gray level of the brightest pixel of pixels of the peripheral image 2910, and $GL_{MIN}$ may refer to a gray level of the darkest pixel of pixels of the surface modified region image 2930.

FIG. 26 is a schematic enlarged cross-sectional view for describing a pattern region illustrated in FIG. 22. FIGS. 27 to 29 are schematic enlarged cross-sectional views for describing a method of forming a recess and a surface modified region illustrated in FIG. 26.

Referring to FIG. 26, the key opening 4220 exposing the surface portion of the mask substrate 4100, for example, the portion where the pattern region 4620 may be to be formed, may be formed through the intermediate inorganic film 4200, and the recess 4630 and the surface modified region 4640 may be formed in the surface portion of the mask substrate 4100 exposed by the key opening 4220. According to one or more embodiments, the surface modified region 4640 may have relatively low reflectivity, relatively high absorptivity, and relatively low transmissivity to increase the contrast between the peripheral image 2910 and the surface modified region image 2930. According to one or more embodiments, the surface modified region 4640 may have a greater surface roughness than the peripheral region 4610. For example, the peripheral region 4610 may have an arithmetic average roughness (Ra) of about 10 Å or less, for example, about 1 Å to about 10 Å, and the surface modified region 4640 may have an arithmetic average roughness (Ra) of about 50 nm to about 1 $\mu$m. Accordingly, the surface modified region 4640 may have lower reflectivity, higher absorptivity, and lower transmissivity than the peripheral region 4610. As a result, the contrast between the peripheral image 2910 and the surface modified region image 2930 may be increased, and accordingly, the recognition rate of the pattern region 4620 may be significantly improved. For example, the surface roughness of the peripheral region 4610 and the surface modified region 4640 may be measured by a stylus profilometer, an optical profilometer, an atomic force microscope (AFM), or a scanning electron microscope (SEM).

According to one or more embodiments, the RIE process for forming the surface modified region 4640 may include a first step (e.g., act or task) of forming a polymer layer 4604 (see FIG. 27) by utilizing a passivation gas, a second step (e.g., act or task) of partially removing the polymer layer 4604 by utilizing a sputtering gas and a reaction gas, and a third step (e.g., act or task) of removing the surface portion of the mask substrate 4100 by utilizing a reaction gas, and the first, second, and third steps (e.g., acts or tasks) may be repeatedly performed.

For example, as illustrated in FIG. 27, a photoresist pattern 4602 exposing a portion where the key opening 4220 may be to be formed may be on (e.g., formed on) the intermediate inorganic film 4200, and the key opening 4220 exposing the surface portion of the mask substrate 4100 may be formed by an anisotropic etching process, for example, an RIE process, utilizing the photoresist pattern 4602 as an etching mask. Subsequently, the polymer layer 4604 may be on (e.g., formed on) the surface portion of the mask substrate 4100 by utilizing a passivation gas. A gas including carbon such as $CF_4$, $C_2F_6$, $C_3F_6$, $C_4F_6$, and/or $C_4F_8$, may be utilized as the passivation gas, and the polymer layer 4604 may be formed by, for example, $CF_x$ radicals. Although not illustrated, an etching apparatus for performing the RIE process may include a chuck on which the mask substrate 4100 may be put and a plasma source for forming process gases into a plasma state.

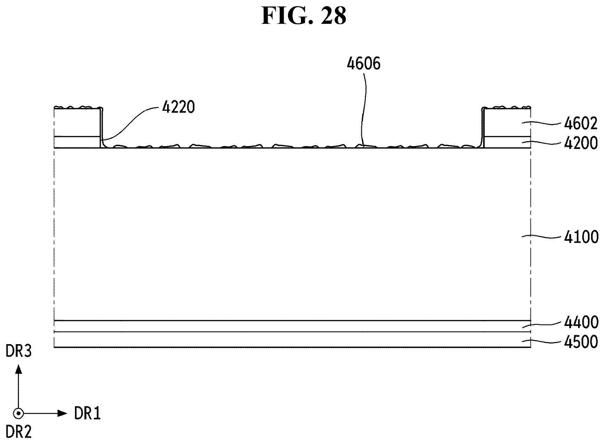

Referring to FIG. 28, the second step (e.g., act or task) may be performed, so that a surface of the mask substrate 4100 and/or a bottom surface of the recess 4630 may be partially exposed. According to one or more embodiments, the polymer layer 4604 may be partially removed by utilizing a sputtering gas such as Ar, He, Ne, Xe, and/or $O_2$, and a reaction gas such as $SF_6$, $CHF_3$, $CH_3F$, $CH_2F_2$, $CBrF_3$, $CCl_4$, $O_2$, and/or $H_2$. For example, the polymer layer 4604 may be irregularly removed by ion bombardment, and accordingly, portions 4606 of the polymer layer 4604 may partially and irregularly remain on the pattern region 4620. The second step (e.g., act or task) may be performed for a shorter time than the first step (e.g., act or task), and bias power may be applied to the chuck on which the mask substrate 4100 may be put. For example, the first step (e.g., act or task) may be performed for about 1.5 seconds to 3.5 seconds, and the second step (e.g., act or task) may be performed for about 0.5 seconds to about 1 second. In addition, the bias power may not be applied to the chuck on which the mask substrate 4100 may be put for a period in which the first step (e.g., act or task) may be performed, and bias power of about 100 W to about 400 W may be applied to the chuck on which the mask substrate 4100 may be put for a period in which the second step (e.g., act or task) is performed.

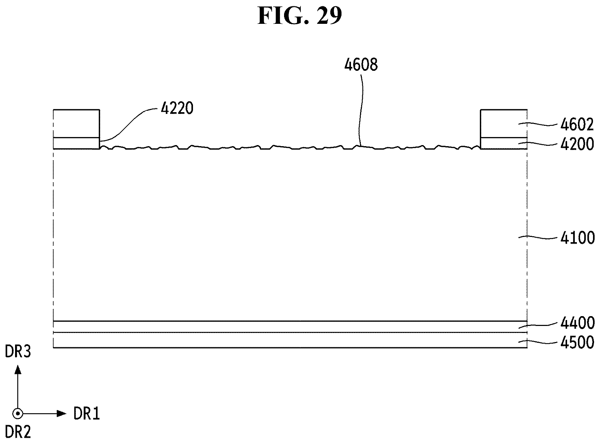

Referring to FIG. 29, surface portions of the mask substrate 4100 may be removed by utilizing a reaction gas. In this case, the remaining portions 4606 of the polymer layer 4604 may function as etch-stop patterns in the third step (e.g., act or task) and may be removed together with the surface portions of the mask substrate 4100. The surface portions of the mask substrate 4100 may be isotropically etched, for example, by fluorine radicals. For example, the third step (e.g., act or task) may be performed for about 3 seconds to about 4 seconds, and bias power of about 10 W to 20 W may be applied to the chuck on which the mask substrate 4100 may be put.

The remaining portions 4606 of the polymer layer 4604 may have irregular shapes, and accordingly, irregular pillars 4608 or projections may be on (e.g., formed on) the pattern region 4620. As a result, for a period in which the first, second, and third steps (e.g., acts or tasks) are repeatedly performed, the recess 4630 may be formed in the pattern region 4620 as illustrated in FIG. 26, and the surface modified region 4640 including the irregular pillars 4608 or projections may be on (e.g.,

formed on) the bottom surface of the recess 4630.

After the recess 4630 and the surface modified region 4640 are formed as described above, the photoresist pattern 4602 may be removed by an ashing and/or stripping process, and the membrane 4300 may be on (e.g., formed on) the intermediate inorganic film 4200 and the pattern region 4620 as illustrated in FIG. 26. In this case, the membrane 4300 may function as a passivation layer for protecting the pattern region 4620. For example, the membrane 4300 may include a passivation region 4330 arranged on the pattern region 4620, e.g., the surface modified region 4640.

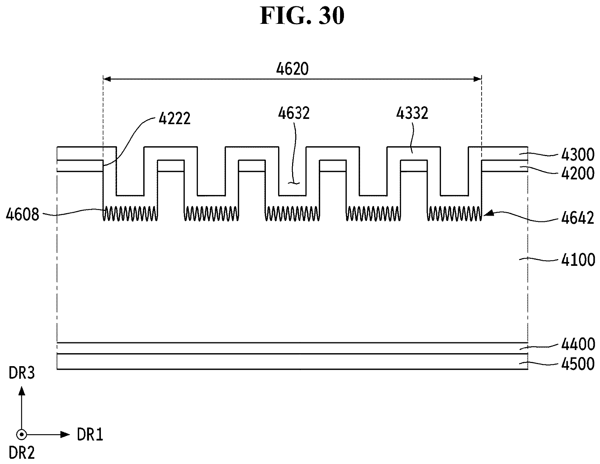

FIG. 30 is a schematic enlarged cross-sectional view for describing another example of the pattern region illustrated in FIG. 26.

Referring to FIG. 30, the pattern region 4620 may have a plurality of recesses 4632 extending in parallel with each other, and may include surface modified regions 4642 arranged on bottom surfaces of the recesses 4632. It has been illustrated in FIG. 30 that five recesses 4632 and five surface modified regions 4642 may be utilized, but the numbers of recesses 4632 and surface modified regions 4642 may be changed, and accordingly, the scope of the present disclosure is limited by the numbers of recesses 4632 and surface modified regions 4642. In addition, it has been illustrated in FIG. 30 that the recesses 4632 may be extended in the second direction, but an extension direction of the recesses 4632 may be changed, and the scope of the present disclosure is not limited by the extension direction of the recesses 4632.

According to one or more embodiments, the recesses 4632 and the surface modified regions 4642 may be formed by an RIE process, and each of the surface modified regions 4642 may include a plurality of irregular pillars 4608 or projections. In addition, the intermediate inorganic film 4200 may have a plurality of key openings 4222, and the membrane 4300 may include a passivation region 4332 arranged on the pattern region 4620. A method of forming the recesses 4632 and the surface modified regions 4642 may be substantially the same as that described above with reference to FIG. 26, and a detailed description thereof may thus not be provided.

According to one or more embodiments, light incident on the surface modified regions 4642 may be scattered and/or refracted by the surface modified regions 4642. Accordingly, the surface modified regions 4642 may be displayed in the form of relatively dark stripes in the image 2900 obtained by the camera 2800.

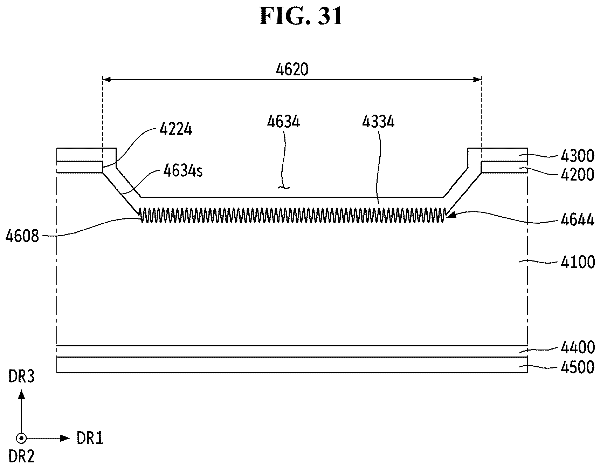

FIG. 31 is a schematic enlarged cross-sectional view for describing another example of the pattern region illustrated in FIG. 26.

Referring to FIG. 31, the pattern region 4620 may have an approximately rectangular shape in plan view, and may have a recess 4634 formed in the surface portion of the mask substrate 4100. In addition, the pattern region 4620 may include a surface modified region 4644 formed in a bottom surface portion of the recess 4634, and the surface modified region 4644 may have an approximately rectangular shape. According to one or more embodiments, the recess 4634 and the surface modified region 4644 may be formed by a wet etching process. For example, the intermediate inorganic film 4200 may have a key opening 4224 exposing the pattern region 4620, and the recess 4634 and the surface modified region 4644 may be formed by a metal assisted chemical etching (MACE) process utilizing the intermediate inorganic film 4200 as an etching mask.

According to one or more embodiments, the recess 4634 and the surface modified region 4644 may be formed by the MACE process utilizing an etchant including metal catalyst particles and a TMAH solution and/or a KOH solution. For example, the metal catalyst particles may include a metal such as gold (Au), platinum (Pt), palladium (Pd), silver (Ag), iron (Fe), nickel (Ni), copper (Cu), and/or aluminum (Al), and the etchant may include about 10 wt% to about 40 wt% of TMAH solution and/or about 10 % to about 40 % of KOH solution, based on a total weight (100 wt%) of the etchant. In addition, for example, if (e.g., when) the TMAH solution is utilized, the MACE process may be performed at a temperature of about 70°C to about 90°C, and if (e.g., when) the KOH solution is utilized, the MACE process may be performed at a temperature of about 50°C to about 80°C.

For a period in which the MACE process is performed, the surface portion of the mask substrate 4100 may be removed by the TMAH solution or the KOH solution. In this case, a <100> crystal direction of the single crystal silicon substrate utilized as the mask substrate 4100 may be the third direction DR3, and accordingly, the recess 4634 may be formed to have a width that gradually decreases from the surface of the mask substrate 4100, for example, the front surface of the mask substrate 4100, toward the surface modified region 4644 by the MACE process. For example, inner side surfaces 4634s of the recess 4634 may have an inclination angle of about 54.7° with respect to the front surface of the mask substrate 4100.

According to one or more embodiments, the metal catalyst particles may have a size of about 5 nm to about 50 nm. For the period in which the MACE process may be performed, the bottom surface portion of the recess 4634 may be irregularly etched by the metal catalyst particles, and accordingly, the surface modified region 4644 including pillars 4608 or projections having irregular shapes may be formed at the bottom surface portion of the recess 4634. In addition, after the recess 4634 and the surface modified region 4644 may be formed, the membrane 4300 may be on (e.g., formed on) the intermediate inorganic film 4200 and the pattern region 4620. In this case, the membrane 4300 may include a passivation region 4334 on the pattern region 4620.

According to one or more embodiments, the pattern region 4620 may include the inner side surfaces 4634s of the recess 4634 and the surface modified region 4644. In this case, light incident on the inner side surfaces 4634s of the recesses 4634 may be refracted by the inner side surfaces 4634s of the recesses 4634, and light incident on the surface modified region 4644 may be scattered and/or refracted by the surface modified region 4644. As a result, the pattern region 4620 may be displayed relatively very dark in the image 2900 obtained by the camera 2800, and accordingly, a recognition rate of the pattern region 4620 may be significantly improved.

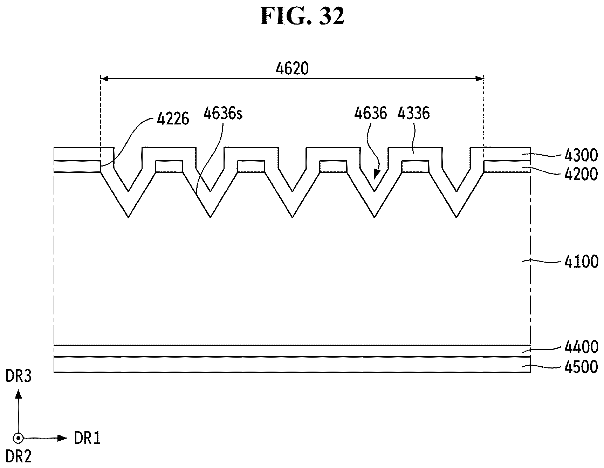

FIG. 32 is a schematic enlarged cross-sectional view for describing another example of the pattern region illustrated in FIG. 26.

Referring to FIG. 32, the pattern region 4620 may have a plurality of recesses 4636 extending in parallel with each other. It has been illustrated in FIG. 32 that the pattern region 4620 may have five recesses 4636, but the number of recesses 4636 may be changed, and thus, the scope of the present disclosure is not limited by the number of recesses 4636. In addition, it has been illustrated in FIG. 32 that the recesses 4636 may be extended in the second direction, but an extension direction of the recesses 4636 may be changed, and the scope of the present disclosure is not limited by the extension direction of the recesses 4636.

According to one or more embodiments, the recesses 4636 may be formed by a wet etching process. For example, the intermediate inorganic film 4200 may have a plurality of key openings 4226 extending in a direction parallel to the recesses 4636, and the recesses 4636 may be formed by a wet etching process utilizing the intermediate inorganic film 4200 as an etching mask. According to one or more embodiments, each of the recesses 4636 may be defined by inclined inner side surfaces 4636s connected to each other, and each of the inclined inner side surfaces 4636s may be extended in the direction parallel to the recesses 4636. For example, the recesses 4636 may be formed by a wet etching process utilizing an etchant such as a TMAH solution and/or a KOH solution. In this case, a <100> crystal direction of the single crystal silicon substrate utilized as the mask substrate 4100 may be the third direction DR3, and accordingly, the inner side surfaces 4636s of the recesses 4636 may be formed by the wet etching process so as to have an inclination angle of about 54.7° with respect to the front surface of the mask substrate 4100 and may be connected to each other at a bottom portion of each of the recesses 4636.

According to one or more embodiments, light incident on the inner side surfaces 4636s of the recesses 4636 may be refracted by the inner side surfaces 4636s of the recesses 4636. Accordingly, the recesses 4636 may be displayed in the form of relatively dark stripes in the image 2900 obtained by the camera 2800. In addition, according to one or more embodiments, the membrane 4300 may be on (e.g., formed on) the intermediate inorganic film 4200 and the pattern region 4620 after the recesses 4636 are formed, and may include a passivation region 4336 arranged on the pattern region 4620.

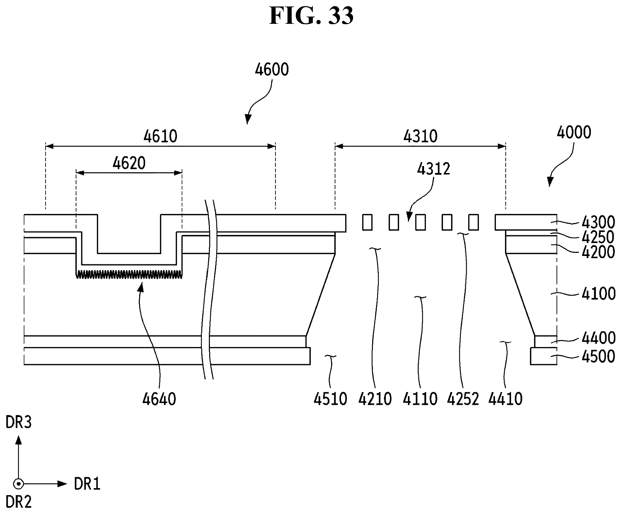

FIG. 33 is a schematic cross-sectional view for describing another example of the deposition mask illustrated in FIG. 22.

Referring to FIG. 33, the deposition mask 4000 may include a mask substrate 4100, a membrane 4300 arranged on the mask substrate 4100, and a mask alignment key 4600 arranged on the mask substrate 4100. The mask alignment key 4600 may include a pattern region 4620 and a peripheral region 4610 around (e.g., surrounding) the pattern region 4620. In addition, the deposition mask 4000 may include an intermediate inorganic film 4200, a second intermediate inorganic film 4400, and/or a rear inorganic film 4500. As an example, the pattern region 4620 may have a recess 4630 as illustrated in FIG. 26, and may include a surface modified region 4640 formed in a bottom surface portion of the recess 4630. As another example, the pattern region 4620 may have recesses 4632 as illustrated in FIG. 30, and may include surface modified regions 4642 formed in bottom surface portions of the recesses 4632. As another example, the pattern region 4620 may have a recess 4634 as illustrated in FIG. 31, and may include a surface modified region 4644 formed in a bottom surface portion of the recess 4634. As another example, the pattern region 4620 may have recesses 4636 as illustrated in FIG. 32.

In one or more embodiments, the mask substrate 4100, the intermediate inorganic film 4200, the membrane 4300, the second intermediate inorganic film 4400, the rear inorganic film 4500, and the mask alignment key 4600 may be substantially the same as those described above with reference to FIGS. 17 to 32, and a detailed description thereof may thus not be provided.

According to one or more embodiments, the deposition mask 4000 may further include a passivation film 4250 arranged on the mask substrate 4100 and the mask alignment key 4600. For example, the deposition mask 4000 may further include a passivation film 4250 arranged on the pattern region 4620 and the intermediate inorganic film 4200. The passivation film 4250 may be utilized to protect the pattern region 4620, and the membrane 4300 may be arranged on the passivation film 4250. For example, the passivation film 4250 may include silicon oxide (e.g., $SiO_x$), and may be formed to have a thickness of about 0.5 $\mu$m to about 1 $\mu$m through a CVD process.

According to one or more embodiments, the passivation film 4250 may have third intermediate openings 4252, so that the mask cell regions 4310 may be exposed toward the deposition source 2200. For example, after the cell openings 4110 are formed, the intermediate inorganic film 4200 and the passivation film 4250 may be partially removed by a wet etching process utilizing an etchant such as a BOE or a diluted hydrofluoric acid, and accordingly, the intermediate openings 4210 and the third intermediate openings 4252 may be formed. The intermediate openings 4210 and the third intermediate openings 4252 may connect the pixel openings 4312 and the cell openings 4110 to each other, and for a period in which the deposition process is performed, the vapor deposition material may be provided onto the backplane substrate 3000 through the rear openings 4510, the second intermediate openings 4410, the cell openings 4110, the intermediate openings 4210, the third intermediate openings 4252, and the pixel openings 4312.

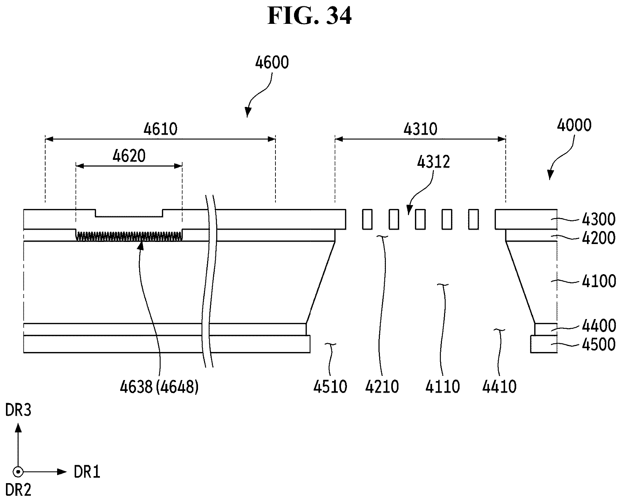

FIG. 34 is a schematic cross-sectional view for describing another example of the deposition mask illustrated in FIG. 22.

Referring to FIG. 34, the deposition mask 4000 may include a mask substrate 4100, a membrane 4300 arranged on the mask substrate 4100, and a mask alignment key 4600 arranged on the mask substrate 4100. The mask alignment key 4600 may include a pattern region 4620 and a peripheral region 4610 around (e.g., surrounding) the pattern region 4620. In addition, the deposition mask 4000 may include an intermediate inorganic film 4200, a second intermediate inorganic film 4400, and a rear inorganic film 4500. In one or more embodiments, the mask substrate 4100, the intermediate inorganic film 4200, the membrane 4300, the second intermediate inorganic film 4400, the rear inorganic film 4500, and the mask alignment key 4600 may be substantially the same as those described above with reference to FIGS. 17 to 32, and a detailed description thereof may thus not be provided.

According to one or more embodiments, the pattern region 4620 may be formed at a surface portion of the intermediate inorganic film 4200. In this case, a portion of the intermediate inorganic film 4200 around (e.g., surrounding) the pattern region 4620 may be utilized as the peripheral region 4610 of the mask alignment key 4600. For example, the pattern region 4620 may have a recess 4638 formed in the surface portion of the intermediate inorganic film 4200, and a surface modified region 4648 may be formed in a bottom surface portion of the recess 4638. The recess 4638 and the surface modified region 4648 may be formed through an anisotropic etching process, for example, an RIE process. For example, the RIE process may be performed by utilizing a passivation gas for forming the polymer layer, such as $CF_4$, $C_2F_6$, $C_3F_6$, $C_4F_6$, and/or $C_4F_8$, a sputtering gas for anisotropically etching the polymer layer and the intermediate inorganic film 4200, such as Ar, He, Ne, Xe, and/or $O_2$, and a reaction gas for isotropically etching the intermediate inorganic film 4200, such as $SF_6$, $CHF_3$, $CH_3F$, $CH_2F_2$, and/or $O_2$. In one or more embodiments, a method of forming the recess 4638 and the surface modified region 4648 may be substantially the same as that described above with reference to FIGS. 26 to 29, and a detailed description thereof may thus not be provided.

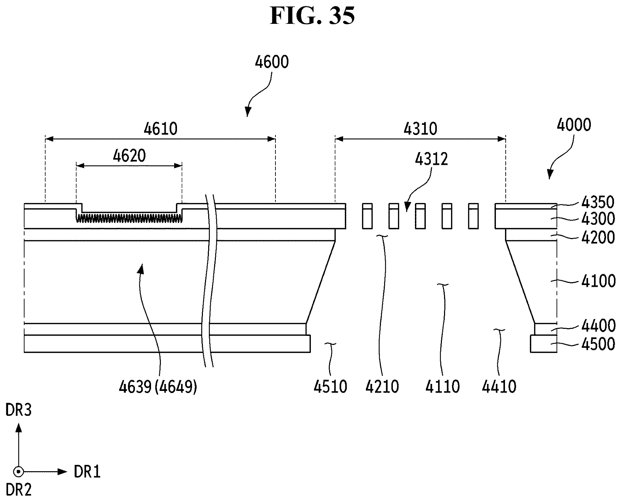

FIG. 35 is a schematic cross-sectional view for describing another example of the deposition mask illustrated in FIG. 22.

Referring to FIG. 35, the deposition mask 4000 may include a mask substrate 4100, a membrane 4300 arranged on the mask substrate 4100, and a mask alignment key 4600 arranged on the mask substrate 4100. The mask alignment key 4600 may include a pattern region 4620 and a peripheral region 4610 around (e.g., surrounding) the pattern region 4620. In addition, the deposition mask 4000 may include an intermediate inorganic film 4200, a second intermediate inorganic film 4400, and a rear inorganic film 4500. In one or more embodiments, the mask substrate 4100, the intermediate inorganic film 4200, the membrane 4300, the second intermediate inorganic film 4400, the rear inorganic film 4500, and the mask alignment key 4600 may be substantially the same as those described above with reference to FIGS. 17 to 32, and a detailed description thereof may thus not be provided.

According to one or more embodiments, the pattern region 4620 may be formed at a surface portion of the membrane 4300. In this case, a portion of the membrane 4300 around (e.g., surrounding) the pattern region 4620 may be utilized as the peripheral region 4610 of the mask alignment key 4600. For example, the pattern region 4620 may have a recess 4639 formed in the surface portion of the membrane 4300, and a surface modified region 4649 may be formed in a bottom surface portion of the recess 4639. The recess 4639 and the surface modified region 4649 may be formed through an anisotropic etching process, for example, an RIE process. For example, the RIE process may be performed by utilizing a passivation gas for forming the polymer layer, such as $CF_4$, $C_2F_6$, $C_3F_6$, $C_4F_6$, and/or $C_4F_8$, a sputtering gas for anisotropically etching the polymer layer and the membrane 4300, such as Ar, He, Ne, Xe, and/or $O_2$, and a reaction gas for isotropically etching the membrane 4300, such as $SF_6$, $CHF_3$, $CH_3F$, $CH_2F_2$, and/or $O_2$. In one or more embodiments, a method of forming the recess 4639 and the surface modified region 4649 may be substantially the same as that described above with reference to FIGS. 26 to 29, and a detailed description thereof may thus not be provided.

According to one or more embodiments, a passivation film 4350 may be arranged on the membrane 4300 and the mask alignment key 4600. The passivation film 4350 may be utilized to protect the pattern region 4620 of the mask alignment key 4600. For example, the passivation film 4350 may include silicon oxide (e.g., $SiO_x$) and/or silicon nitride (e.g., $SiN_x$), and may be formed by a CVD process. If (e.g., when) the passivation film 4350 includes (e.g., is made of) silicon oxide (e.g., $SiO_x$), the passivation film 4350 may be on (e.g., formed on) the membrane 4300 and the mask alignment key 4600 after the cell openings 4110 may be formed. As another example, if (e.g., when) the passivation film 4350 includes (e.g., is made of) silicon nitride (e.g., $SiN_x$), the passivation film 4350 may be on (e.g., formed on) the membrane 4300, and the mask alignment key 4600 after the recess 4639 and the surface modified region 4649 may be formed.

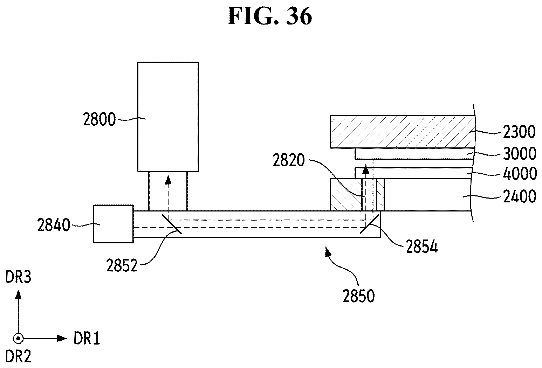

FIG. 36 is a schematic cross-sectional view for describing another example of the camera and the illumination portion illustrated in FIG. 24.

Referring to FIG. 36, an illumination portion 2840 may provide light onto the backplane substrate 3000 through the deposition mask 4000, and a camera 2800 may be to detect light reflected from the backplane substrate 3000 and transmitted through the deposition mask 4000. For example, a through hole 2820 through which the light provided from the illumination portion 2840 and the light reflected from the backplane substrate 3000 pass may be provided at the edge portion of the mask chuck 2400, and an optical unit 2850 (or a prism unit) guiding the light provided from the illumination portion 2840 onto the backplane substrate 3000 and guiding the light reflected from the backplane substrate 3000 to the camera 2800 may be arranged beneath (e.g., below) the mask chuck 2400.

The light provided from the illumination portion 2840 may be transmitted through the deposition mask 4000 and provided onto the backplane substrate 3000, and the light reflected from the backplane substrate 3000 may be transmitted through the deposition mask 4000 and guided to the camera 2800. For example, the illumination portion 2840 may include a light emitting diode (LED) lamp for providing visible light. As an example, the illumination portion 2840 may provide visible light having a wavelength of about 413 nm or about 530 nm, and the optical unit 2850 may include a beam splitter 2852 and a reflector 2854. The beam splitter 2852 may be to transmit some of the light provided from the illumination portion 2840, and may reflect some of the light reflected from the backplane substrate 3000 toward the camera 2800. The reflector 2854 may reflect the light transmitted through the beam splitter 2852 toward the backplane substrate 3000, and may reflect the light reflected from the backplane substrate 3000 toward the beam splitter 2852.

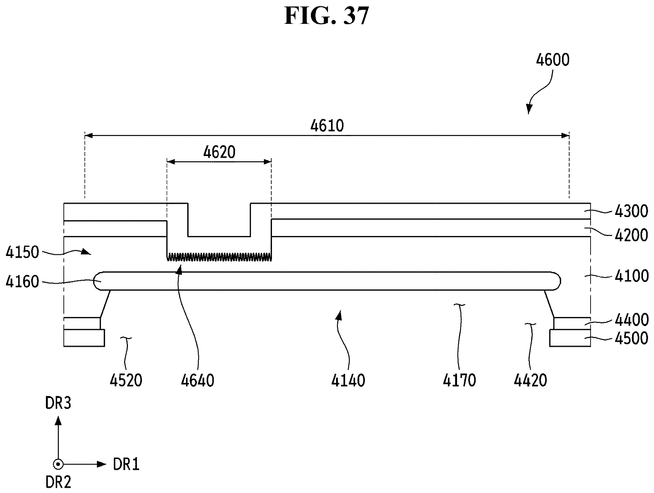

FIG. 37 is a schematic cross-sectional view for describing another example of the mask alignment key illustrated in FIG. 22.

Referring to FIG. 37, the mask alignment key 4600 may include a pattern region 4620 and a peripheral region 4610 around (e.g., surrounding) the pattern region 4620. In addition, the mask alignment key 4600 may include a surface layer 4150 of the mask substrate 4100, and the mask substrate 4100 may have a second key opening 4140 exposing the mask alignment key 4600. For example, the second key opening 4140 may be to expose the surface layer 4150 of the mask substrate 4100.

According to one or more embodiments, the surface layer 4150 of the mask substrate 4100 may have a thickness small enough to pass the visible light provided from the illumination portion 2840. For example, the surface layer 4150 of the mask substrate 4100 may have a thickness of about 5 $\mu$m to about 50 $\mu$m. The pattern region 4620 may be on (e.g., formed on) the surface layer 4150 of the mask substrate 4100.

As an example, the pattern region 4620 may have a recess 4630 as illustrated in FIG. 26, and may include a surface modified region 4640 formed in a bottom surface portion of the recess 4630. As another example, the pattern region 4620 may have recesses 4632 as illustrated in FIG. 30, and may include surface modified regions 4642 formed in bottom surface portions of the recesses 4632. As another example, the pattern region 4620 may have a recess 4634 as illustrated in FIG. 31, and may include a surface modified region 4644 formed in a bottom surface portion of the recess 4634. As another example, the pattern region 4620 may have recesses 4636 as illustrated in FIG. 32.

According to one or more embodiments, the second key opening 4140 may be formed by a wet etching process utilizing an etchant such as a TMAH solution and/or a KOH solution. For example, the deposition mask 4000 may include an etch-stop region 4160 for preventing or reducing etching of the mask alignment key 4600 for a period in which the wet etching process may be performed. According to one or more embodiments, the etch-stop region 4160 may be formed in the surface layer 4150 of the mask substrate 4100, and may include one or more selected from among Group III impurities. For example, the etch-stop region 4160 may be formed under the surface modified region 4640, and may have a greater area than the second key opening 4140. For example, the etch-stop region 4160 may include one or more selected from among Group III impurities such as boron (B) and/or gallium (Ga), and the one or more selected from among Group III impurities may be implanted into the surface layer 4150 of the mask substrate 4100 by an ion implantation process.

For example, after the intermediate inorganic film 4200 is formed on the mask substrate 4100, a photoresist pattern may be on (e.g., formed on) the intermediate inorganic film 4200, and the ion implantation process may be performed by utilizing the photoresist pattern as an ion implantation mask. In addition, a heat treatment process for recovering lattice damage of the mask substrate 4100 caused by the ion implantation process may be performed. For example, the heat treatment process may be performed at a temperature of about 800°C to about 1000°C.

The one or more selected from among Group III impurities may increase etch resistance against an etchant such as a TMAH solution and/or a KOH solution, and accordingly, may prevent or reduce the etching of the mask alignment key 4600 in the wet etching process for forming the second key opening 4140. For example, the etch-stop region 4160 may have an impurity concentration of about 2E19 atoms/cm$^3$ to about 3E20 atoms/cm$^3$.

For example, the second key opening 4140 may include a third key opening 4520 penetrating through the rear inorganic film 4500, a fourth key opening 4420 penetrating through the second intermediate inorganic film 4400, and a fifth key opening 4170 exposing the etch-stop region 4160 through the mask substrate 4100. For example, the third key opening 4520 and the fourth key opening 4420 may be formed concurrently (e.g., simultaneously) with the rear openings 4510 and the second intermediate openings 4410, respectively, and the fifth key opening 4170 may be formed concurrently (e.g., simultaneously) with the cell openings 4110. In this case, a wet etching process for forming the cell openings 4110 and the fifth key opening 4170 may be performed until the intermediate inorganic film 4200 is exposed, and the mask alignment key 4600 may be protected by the etch-stop region 4160.

According to one or more embodiments, the visible light provided from the illumination portion 2840 may be irradiated onto the mask alignment key 4600 through the second key opening 4140, and light incident on the surface modified region 4640 may be scattered and/or refracted by the surface modified region 4640. Light transmitted through the peripheral region 4610 of the mask alignment key 4600 may be reflected by the backplane substrate 3000. The light reflected by the backplane substrate 3000 may pass through the peripheral region 4610 of the mask alignment key 4600 and be then detected by the camera 2800.

According to one or more embodiments, although not illustrated in FIG. 37, the deposition mask 4000 may further include a passivation film 4250 as illustrated in FIG. 33.

In addition, according to one or more embodiments, the pattern region 4620 may have a recess 4638 formed in the surface portion of the intermediate inorganic film 4200 as illustrated in FIG. 34, and may include a surface modified region 4648 formed in the bottom surface portion of the recess 4638. In this case, the etch-stop region 4160 may be formed in the surface layer 4150 of the mask substrate 4100 so as to overlap the pattern region 4620 formed at the surface portion of the intermediate inorganic film 4200 and the peripheral region 4610, and the second key opening 4140 may be formed to expose the etch-stop region 4160. For example, the etch-stop region 4160 may be formed in the surface portion of the mask substrate 4100, and the mask alignment key 4600 formed at the intermediate inorganic film 4200 may be arranged on the etch-stop region 4160.

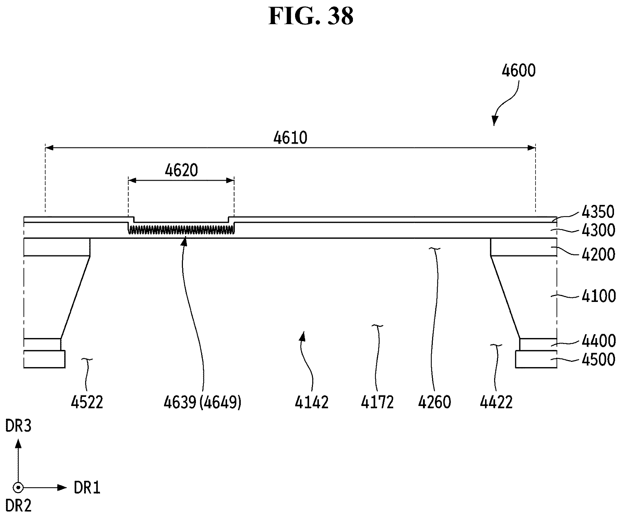

FIG. 38 is a schematic cross-sectional view for describing another example of the mask alignment key illustrated in FIG. 22.

Referring to FIG. 38, the mask alignment key 4600 may include a pattern region 4620 and a peripheral region 4610 around (e.g., surrounding) the pattern region 4620. According to one or more embodiments, the pattern region 4620 may have a recess 4639 (see FIG. 35) formed in the surface portion of the membrane 4300, and may include a surface modified region 4649 (see FIG. 35) in a bottom surface portion of the recess 4639. According to one or more embodiments, a passivation film 4350 may be arranged on the membrane 4300 and the mask alignment key 4620. In one or more embodiments, the recess 4639, the surface modified region 4649, and the passivation film 4350 may be substantially the same as those described above with reference to FIG. 35, and a detailed description thereof may thus not be provided.

According to one or more embodiments, the mask substrate 4100 may have a second key opening 4142 exposing the mask alignment key 4600. For example, the second key opening 4142 may include a third key opening 4522 penetrating through the rear inorganic film 4500, a fourth key opening 4422 penetrating through the second intermediate inorganic film 4400, a fifth key opening 4172 penetrating through the mask substrate 4100, and a sixth key opening 4260 penetrating through the intermediate inorganic film 4200. For example, the third and fourth key openings 4522 and 4422 may be formed concurrently (e.g., simultaneously) with the rear openings 4510 and the second intermediate openings 4410, respectively, the fifth key opening 4172 may be formed concurrently (e.g., simultaneously) with the cell openings 4110, and the sixth key opening 4260 may be formed concurrently (e.g., simultaneously) with the intermediate openings 4210.

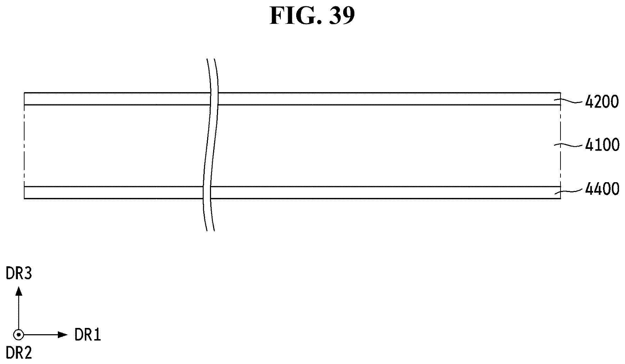

FIGS. 39 to 45 are schematic cross-sectional views for describing a method of manufacturing a deposition mask according to one or more embodiments of the present disclosure.

Referring to FIG. 39, an intermediate inorganic film 4200 may be on (e.g., formed on) a mask substrate 4100. The mask substrate 4100 may include (e.g., be made of) single crystal silicon. For example, a single crystal silicon substrate having a thickness of about 700 $\mu$m to about 800 $\mu$m, for example, about 775 $\mu$m, may be utilized as the mask substrate 4100.

The intermediate inorganic film 4200 may include (e.g., be made of), for example, silicon oxide (e.g., $SiO_x$), and may be on (e.g., formed on) the front surface of the mask substrate 4100 so as to have a thickness of about 0.3 $\mu$m to about 2 $\mu$m through a thermal oxidation process. In addition, a second intermediate inorganic film 4400 may be on (e.g., formed on) the rear surface of the mask substrate 4100. For example, the second intermediate inorganic film 4400 may be formed concurrently (e.g., simultaneously) with the intermediate inorganic film 4200 through a thermal oxidation process. Accordingly, the second intermediate inorganic film 4400 may include (e.g., be made of) substantially the same material as the intermediate inorganic film 4200, and may have substantially the same thickness as the intermediate inorganic film 4200.

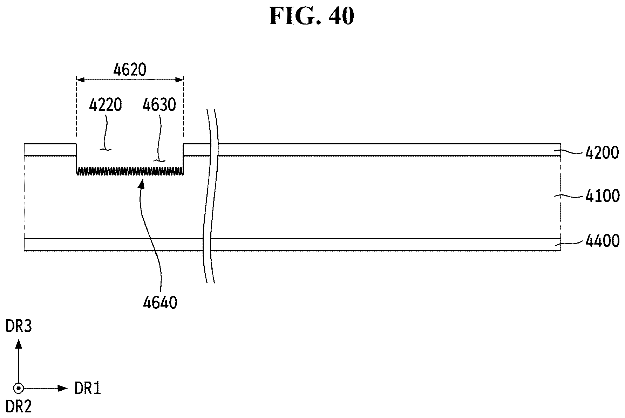

Referring to FIG. 40, a mask alignment key 4600 (see FIGS. 22 and 23) may be on (e.g., formed on) the mask substrate 4100. According to one or more embodiments, the mask alignment key 4600 may include a pattern region 4620 and a peripheral region 4610 around (e.g., surrounding) the pattern region 4620. The pattern region 4620 may have a recess 4630 formed in a surface portion of the mask substrate 4100, and may include a surface modified region 4640 formed in a bottom surface portion of the recess 4630. According to one or more embodiments, the surface modified region 4640 of the pattern region 4620 may have a greater surface roughness than the peripheral region 4610.

According to one or more embodiments, the recess 4630 and the surface modified region 4640 may be formed by an RIE process. For example, the recess 4630 may be formed in the surface portion of the mask substrate 4100 by an RIE process, and the surface modified region 4640 may be formed in the bottom surface portion of the recess 4630 by the RIE process. For example, as described above with reference to FIGS. 27 to 29, the photoresist pattern 4602 partially exposing the intermediate inorganic film 4200 may be on (e.g., formed on) the intermediate inorganic film 4200, and a key opening 4220 penetrating through the intermediate inorganic film 4200 may be formed by an anisotropic etching process utilizing the photoresist pattern 4602 as an etching mask. Subsequently, the surface portion of the mask substrate 4100 exposed by the key opening 4220 may be etched by the RIE process, and accordingly, the recess 4630 and the surface modified region 4640 may be formed. In one or more embodiments, a method of forming the key opening 4220, the recess 4630, and the surface modified region 4640 may be substantially the same as that described above with reference to FIGS. 27 to 29, and a detailed description thereof may thus not be provided.

As another example, as illustrated in FIG. 30, the pattern region 4620 may have a plurality of recesses 4632, and surface modified regions 4642 may be formed in bottom surface portions of the recesses 4632. The recesses 4632 and the surface modified regions 4642 may be formed by the RIE process described above with reference to FIGS. 27 to 29.

As another example, as illustrated in FIG. 31, the recess 4634 and the surface modified region 4644 may be formed by the MACE process. For example, the MACE process may be performed by utilizing an etchant including metal catalyst particles and a THAH solution and/or a KOH solution, and accordingly, the inner side surfaces 4634s of the recess 4634 may be formed to have an inclination angle of about 54.7° with respect to the front surface of the mask substrate 4100. For example, the recess 4634 may be formed to have a width that gradually decreases from the front surface of the mask substrate 4100 toward the surface modified region 4644. A method of forming the recess 4634 and the surface modified region 4644 by utilizing the MACE process may be substantially the same as that described above with reference to FIG. 31, and a detailed description thereof may thus not be provided.

As another example, as illustrated in FIG. 32, the pattern region 4620 may have a plurality of recesses 4636, and the recesses 4636 may be defined by inclined inner side surfaces 4636s connected to each other.

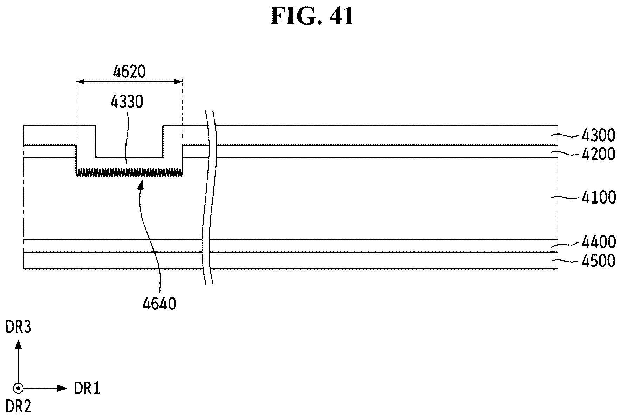

Referring to FIG. 41, a membrane 4300 may be on (e.g., formed on) the intermediate inorganic film 4200 and the pattern region 4620. In this case, a portion of the membrane 4300 on (e.g., formed on) the pattern region 4620 may function as a passivation region 4330 for protecting the pattern region 4620. For example, the membrane 4300 may include silicon nitride (e.g., $SiN_x$), and may be formed by a CVD process. For example, a silicon source gas such as monosilane (e.g., $SiH_4$), disilane (e.g., $Si_2H_6$), and/or dichlorosilane (DCS) (e.g., $SiH_2Cl_2$) and a nitrogen source gas such as $N_2$ and/or $NH_3$ may be supplied onto the intermediate inorganic film 4200, and the membrane 4300 may be formed to have a thickness of about 0.3 μm to about 3 μm by a reaction between the silicon source gas and the nitrogen source gas.

A rear inorganic film 4500 may be on (e.g., formed on) the second intermediate inorganic film 4400. The rear inorganic film 4500 may include (e.g., be made of) silicon nitride (e.g., $SiN_x$), and may be formed by a CVD process. For example, the membrane 4300 and the rear inorganic film 4500 may be formed concurrently (e.g., simultaneously) by a CVD process. Accordingly, the rear inorganic film 4500 may include (e.g., be made of) substantially the same material as the membrane 4300, and may have substantially the same thickness as the membrane 4300.

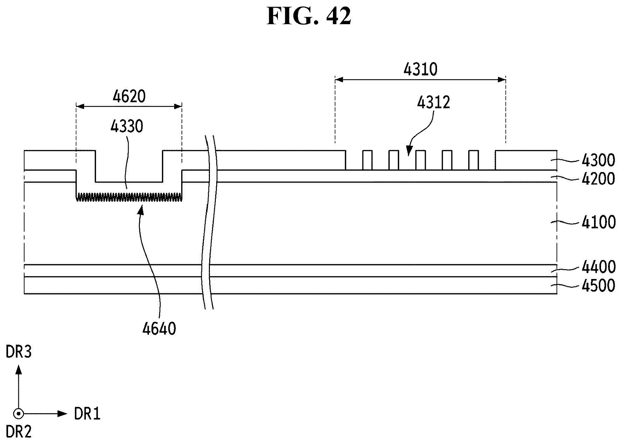

Referring to FIG. 42, pixel openings 4312 may be formed by patterning the membrane 4300. For example, a photoresist pattern exposing portions where the pixel openings 4312 are to be formed may be on (e.g., formed on) the membrane 4300, and the pixel openings 4312 penetrating through the membrane 4300 may be formed by performing an anisotropic etching process, for example, an RIE process, utilizing the photoresist pattern as an etching mask. The RIE process may be performed until the intermediate inorganic film 4200 is exposed by the pixel openings 4312, and the intermediate inorganic film 4200 may function as an etch-stop film. For example, if (e.g., when) the membrane 4300 includes (e.g., is made of) silicon nitride (e.g., $SiN_x$), the RIE process may be performed until the intermediate inorganic film 4200 is exposed by utilizing a first reaction gas including fluorine, such as $CF_4$, $C_2F_6$, $C_3F_6$, $C_4F_6$, $C_4F_8$, $CHF_3$, $CH_3F$, $CH_2F_2$, $NF_3$, and/or $SF_6$, a second reaction gas including oxygen, such as $O_2$, $NO$, and/or $NO_2$, and a sputtering gas such as He, Ne, Ar, and/or Xe.

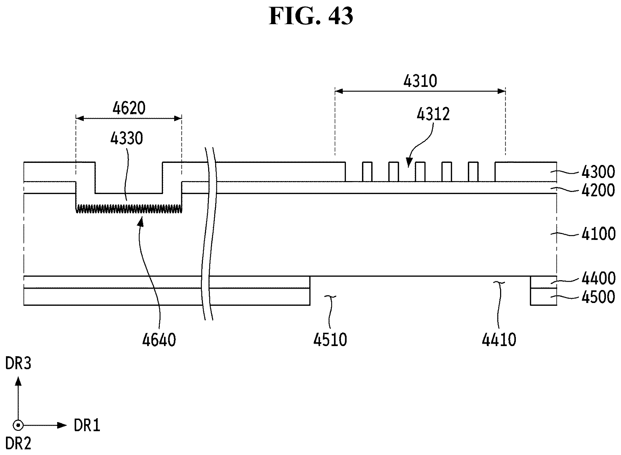

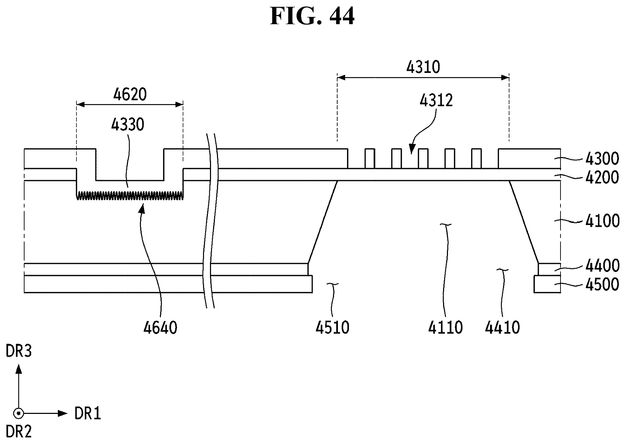

Referring to FIGS. 43 and 44, cell openings 4110 may be formed by patterning the mask substrate 4100. According to one or more embodiments, second intermediate openings 4410 and rear openings 4510 that may be to expose rear surface portions of the mask substrate 4100 where the cell openings 4110 are to be formed may be formed. For example, as illustrated in FIG. 43, a photoresist pattern exposing portions where the rear openings 4510 are to be formed may be on (e.g., formed on) the rear inorganic film 4500, and an anisotropic etching process, for example, an RIE process, utilizing the photoresist pattern as an etching mask may be performed. The above anisotropic etching process may be performed until the rear surface portions of the mask substrate 4100, for example, portions where the cell openings 4110 are to be formed, may be exposed, and accordingly, the second intermediate openings 4410 and the rear openings 4510 penetrating through the second intermediate inorganic film 4400 and the rear inorganic film 4500, respectively, may be formed.

The cell openings 4110 may be formed by a wet etching process. For example, as illustrated in FIG. 44, the mask substrate 4100 may be partially removed, so that the intermediate inorganic film 4200 may be exposed through a wet etching process utilizing the second intermediate inorganic film 4400 and the rear inorganic film 4500 as etching masks, and accordingly, the cell openings 4110 penetrating through the mask substrate 4100 may be formed. For example, the wet etching process for forming the cell openings 4110 may be performed by utilizing an etchant such as a TMAH solution and/or a KOH solution. In this case, the cell openings 4110 may be formed to have a width that may gradually decrease from the rear surface of the mask substrate 4100 toward the front surface of the mask substrate 4100.

In the wet etching process for forming the cell openings 4110, the intermediate inorganic film 4200 may function as an etch-stop film. For example, if (e.g., when) the intermediate inorganic film 4200 is not provided, the etchant may be provided onto the front surface of the mask substrate 4100 through the pixel openings 4312, and hydrogen bubbles may be generated in the pixel openings 4312 by a reaction between the etchant and the mask substrate 4100. In this case, the mask cell regions 4310 of the membrane 4300 may be damaged by the hydrogen bubbles, and the intermediate inorganic film 4200 may be utilized to prevent or reduce the etchant from being provided onto the front surface of the mask substrate 4100 through the pixel openings 4312.

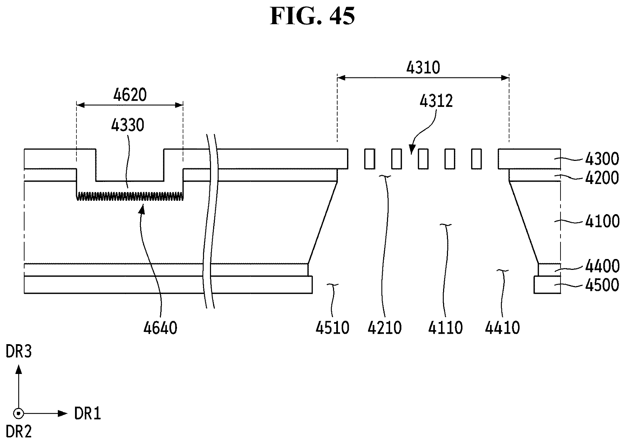

Referring to FIG. 45, intermediate openings 4210 connecting the pixel openings 4312 and the cell openings 4110 to each other may be formed by patterning the intermediate inorganic film 4200. The intermediate openings 4210 may be formed, so that the mask cell regions 4310 of the membrane 4300 may be exposed through the cell openings 4110. The intermediate openings 4210 may be formed by a wet etching process. For example, if (e.g., when) the intermediate inorganic film 4200 includes (e.g., is made of) silicon oxide (e.g., $SiO_x$), the intermediate openings 4210 may be formed by a wet etching process utilizing a BOE and/or a diluted hydrofluoric acid.

According to one or more embodiments, the passivation film 4250 (see FIG. 33) may be on (e.g., formed on) the mask substrate 4100 and the mask alignment key 4600. For example, after the pattern region 4620 is formed, the passivation film 4250 may be on (e.g., formed on) the pattern region 4620 and the intermediate inorganic film 4200, as illustrated in FIG. 33. In this case, the membrane 4300 may be on (e.g., formed on) the passivation film 4250. For example, the passivation film 4250 may include silicon oxide (e.g., $SiO_x$), and may be formed to have a thickness of about 0.5 μm to about 1 μm through a CVD process.

According to one or more embodiments, after the pixel openings 4312 of the membrane 4300 are formed, the second key opening 4140 (see FIG. 37) exposing the mask alignment key 4600 may be formed by partially removing the mask substrate 4100. For example, as illustrated in FIG. 37, the mask alignment key 4600 may include a surface layer 4150 of the mask substrate 4100, and the second key opening 4140 may be to expose the surface layer 4150 of the mask substrate 4100. In this case, the mask alignment key 4600 may include an etch-stop region 4160, and the second key opening 4140 may be to expose the etch-stop region 4160. A method of forming the etch-stop region 4160 and the second key opening 4140 may be substantially the same as that described above with reference to FIG. 37, and a detailed description thereof may thus not be provided.

According to one or more embodiments, after the intermediate inorganic film 4200 is formed, the pattern region 4620 may be formed at the surface portion of the intermediate inorganic film 4200. For example, by forming a photoresist pattern exposing a portion where the pattern region 4620 is to be formed on the intermediate inorganic film 4200 and then performing an RIE process utilizing the photoresist pattern as an etching mask, the recess 4638 and the surface modified region 4648 may be formed in the surface portion of the intermediate inorganic film 4200, as illustrated in FIG. 34. A method of forming the recess 4638 and the surface modified region 4648 may be substantially the same as that described above with reference to FIG. 34, and a detailed description thereof may thus not be provided.

According to one or more embodiments, although not illustrated, if (e.g., when) the pattern region 4620 is formed at the surface portion of the intermediate inorganic film 4200, the etch-stop region 4160 (see FIG. 37) overlapping the mask alignment key 4600 may be formed in the surface layer 4150 of the mask substrate 4100 (see FIG. 37), and the second key opening 4140 exposing the etch-stop region 4160 through the rear inorganic film 4500, the second intermediate inorganic film 4400, and the mask substrate 4100 may be formed.

According to one or more embodiments, after the membrane 4300 is formed, the pattern region 4620 may be formed at the surface portion of the membrane 4300. For example, by forming a photoresist pattern exposing a portion where the pattern region 4620 is to be formed on the membrane 4300 and then performing an RIE process utilizing the photoresist pattern as an etching mask, the recess 4639 and the surface modified region 4649 may be formed in the surface portion of the membrane 4300, as illustrated in FIG. 35. In addition, according to one or more embodiments, the passivation film 4350 may be on (e.g., formed on) the membrane 4300 and the pattern region 4620, as illustrated in FIG.

35. A method of forming the recess 4639, the surface modified region 4649, and the passivation film 4350 may be substantially the same as that described above with reference to FIG. 35, and a detailed description thereof may thus not be provided.

In addition, according to one or more embodiments, the second key opening 4142 (see FIG. 38) exposing the mask alignment key 4600 formed at the surface portion of the membrane 4300 may be formed. For example, the second key opening 4142 may be formed concurrently (e.g., simultaneously) with the rear openings 4510, the second intermediate openings 4410, the cell openings 4110, and the intermediate openings 4210. A method of forming the second key opening 4142 may be substantially the same as that described above with reference to FIG. 38, and a detailed description thereof may thus not be provided.

As discussed, embodiments may provide a deposition mask comprising: a mask substrate having a cell opening; a membrane on the mask substrate and having pixel openings communicating with the cell opening; and a mask alignment key on the mask substrate, wherein the mask alignment key comprises a pattern region and a peripheral region around the pattern region, and wherein the pattern region comprises a surface modified region having a greater surface roughness than the peripheral region.

The surface modified region may formed by a reactive ion etching process or a metal assisted chemical etching process.

Light incident on the surface modified region may be scattered and/or refracted by the surface modified region, and accordingly, the surface modified region may be more clearly displayed in an image of the mask alignment key obtained by a camera.

The pattern region may have a recess in a surface portion of the mask substrate. In some embodiments, the surface modified region is in a bottom surface portion of the recess. The surface modified region may be all or part of the bottom surface of the recess.

The surface roughness of the surface modified region is in a range of 50 nm to 1 $\mu$m. This may be an arithmetic average roughness (Ra).

Embodiments may provide a deposition mask comprising: a mask substrate having a cell opening; a membrane on the mask substrate and having pixel openings communicating with the cell opening; and a mask alignment key on the mask substrate, wherein the mask alignment key comprises a pattern region having at least one recess in a surface portion of the mask substrate and a peripheral region around the pattern region, and wherein the at least one recess is defined by inclined inner side surfaces connected to each other.

Embodiments may provide a method comprising: forming a mask alignment key on a mask substrate; forming a membrane on the mask substrate, the membrane having pixel openings; and forming cell openings through the mask substrate, the cell openings communicating with the pixel openings, wherein the mask alignment key comprises a pattern region and a peripheral region around the pattern region, wherein the pattern region comprises a surface modified region having a greater surface roughness than the peripheral region, and wherein the method is a method for manufacturing a deposition mask.

Embodiments may provide a display panel comprising: a substrate; and a plurality of light emitting layers formed on the substrate by using the deposition mask of any one of the above mentioned embodiments.

The deposition mask, a manufacturing apparatus/device thereof, a method for manufacturing the deposition mask, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

The present disclosure should not be construed as being limited to the one or more embodiments set forth herein. Rather, these embodiments are provided so that this disclosure will be thorough and complete and will fully convey the concept of the disclosure to those skilled in the art.

While the present disclosure has been particularly shown and described with reference to one or more embodiments thereof, it will be understood by those of ordinary skill in the art that one or more suitable changes in form and details may be made therein without departing from the r scope of the disclosure as defined by the following claims and equivalents thereof.

**Claims**

1. A deposition mask comprising:

   a mask substrate having a cell opening;
   a membrane on the mask substrate and having pixel openings communicating with the cell opening; and
   a mask alignment key on the mask substrate, wherein the mask alignment key comprises a pattern region and a peripheral region around the pattern region, and
   wherein the pattern region comprises a surface modified region having a greater surface roughness than the peripheral region.

2. The deposition mask of claim 1, wherein:

   the pattern region has a recess in a surface portion of the mask substrate, and
   the surface modified region is in a bottom surface portion of the recess.

3. The deposition mask of claim 2, wherein the recess has a width that gradually decreases from a surface of the mask substrate toward the surface modified region.

4. The deposition mask of any one of claims 1 to 3, further comprising an intermediate inorganic film between the mask substrate and the membrane, wherein the intermediate inorganic film has a key opening exposing the pattern region.

5. The deposition mask of any one of claims 1 to 4, wherein the surface roughness of the surface modified region is in a range of 50 nm to 1 $\mu$m.

6. The deposition mask of any one of claims 1 to 5, wherein the membrane comprises a passivation region on the pattern region.

7. The deposition mask of any one of claims 1 to 6, further comprising a passivation film on the mask substrate and the mask alignment key, wherein the membrane is on the passivation film.

8. The deposition mask of any one of claims 1 to 7, wherein the mask substrate has a key opening exposing the mask alignment key.

9. The deposition mask of claim 8, wherein:

   the mask alignment key comprises a surface layer of the mask substrate comprising the pattern region and the peripheral region, and
   the key opening exposes the surface layer;
   optionally wherein: the surface layer comprises an etch-stop region having a greater area than the key opening, and the key opening exposes the etch-stop region;
further optionally wherein the etch-stop region comprises one or more selected from among Group **III** impurities.

10. The deposition mask of any one of claims 1 to 9, further comprising an intermediate inorganic film between the mask substrate and the membrane, wherein:

    the pattern region has a recess in a surface portion of the intermediate inorganic film, and
    the surface modified region is in a bottom surface portion of the recess;
    optionally further comprising an etch-stop region in a surface layer of the mask substrate, wherein the mask substrate has a key opening exposing the etch-stop region.

11. The deposition mask of any one of claims 1 to 10, wherein:

    the pattern region has a recess in a surface portion of the membrane, and
    the surface modified region is in a bottom surface portion of the recess;
    optionally further comprising a passivation film on the membrane and the mask alignment key;
    optionally wherein the mask substrate has a key opening exposing the mask alignment key.

12. A deposition mask comprising:

    a mask substrate having a cell opening;
    a membrane on the mask substrate and having pixel openings communicating with the cell opening; and
    a mask alignment key on the mask substrate, wherein the mask alignment key comprises a pattern region having at least one recess in a surface portion of the mask substrate and a peripheral region around the pattern region, and
    wherein the at least one recess is defined by inclined inner side surfaces connected to each other.

13. A method comprising:

    forming a mask alignment key on a mask substrate;
    forming a membrane on the mask substrate, the membrane having pixel openings; and
    forming cell openings through the mask substrate, the cell openings communicating with the pixel openings,
    wherein the mask alignment key comprises a pattern region and a peripheral region around the pattern region,

wherein the pattern region comprises a surface modified region having a greater surface roughness than the peripheral region, and

wherein the method is a method for manufacturing a deposition mask.

14. A display panel comprising:

a substrate; and
a plurality of light emitting layers formed on the substrate by using the deposition mask of any one of claims 1 to 12.

15. An electronic device comprising the display panel of claim 14.

# FIG. 1

10

12

Processor

Power
Module — 14

Display
Module — 11

Memory — 13

# FIG. 2

10_1a

10_1b

10_1c

10_1d

10_1e

10_2a

10_2b

10_2c

11:11 pm

10_3    10_3    10_3    10_3

10_3

# FIG. 3

# FIG. 4

# FIG. 5

# FIG. 6

# FIG. 7

# FIG. 8

EP 4 768 623 A1

# FIG. 9

SP1    SP2    SP3

POL
CVL
FIL
OPL
LNS
CF1    CF2    CF3
ADL
EA1    EA2    EA3
TFE3
TFE2  TFE
TRC    TFE1
CAT    IL3
PDL3   IL2  IL
PDL    PDL2   IL1
PDL1
AND    INS11  EML
VA10   RL4
RL3
RIL ESS    RL2  RL
RL1
VA9    INS10
ML8    INS9
VA8    INS8
ML7    INS8
VA7    INS7
ML6
VA6    INS6
ML5    INS5  EBP
VA5
ML4    INS4
VA4    INS3
ML3    INS2
VA3    INS1
ML2
VA2    SINS3
ML1    SINS2
VA1    SINS1  SBP
CTE    SSUB

I1    I1'
DR3   SA  CH  GE  DA  SINS
LDD1  BINS LDD2 WA    PTR

LE: AND, IL, CAT

48

# FIG. 10

# FIG. 11

SP1  SP2  SP3

POL
CVL
ADL

EA1  EA2  EA3

IL1_1  IL1_2  IL1_3

TFE2 ⎫TFE
TFE1 ⎭

CAT

PDL — PNS
STPL — OAL ⎫EML
AND — RL
ANC

STPL

AA2  AA1

VA9
ML8 — INS9
VA8
ML7 — INS8
VA7 — INS7
ML6 — INS6
VA6
ML5 — INS5
VA5
ML4 — INS4
VA4 — INS3
ML3
VA3 — INS2
ML2 — INS1
VA2 — SINS3
ML1 — SINS2
VA1 — SINS1 ⎫SBP
CTE — SSUB

EBP

I1  I1'

DR3  SA  CH  GE  DA  SINS  PTR
LDD1 BINS LDD2 WA

LE: AND, IL, CAT
IL: IL1_1, IL1_2, IL1_3

# FIG. 12

# FIG. 13

# FIG. 14

# FIG. 15

# FIG. 16

# FIG. 17

# FIG. 18

4310

4312

4320

I2

I2'

DR2

DR1

DR3

# FIG. 19

# FIG. 20

# FIG. 21

3100

3110

3120

DR3

DR1

DR2

# FIG. 22

# FIG. 23

## FIG. 24

**FIG. 25**

# FIG. 26

# FIG. 27

## FIG. 28

**FIG. 29**

# FIG. 30

# FIG. 31

# FIG. 32

# FIG. 33

# FIG. 34

# FIG. 35

## FIG. 36

# FIG. 37

# FIG. 38

# FIG. 39

# FIG. 40

# FIG. 41

# FIG. 42

# FIG. 43

# FIG. 44

FIG. 45

DR3

DR2 → DR1

Europäisches
Patentamt
European
Patent Office
Office européen
des brevets

**EUROPEAN SEARCH REPORT**

Application Number

EP 25 21 6482

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 692 896 A1 (SAMSUNG DISPLAY CO LTD [KR]) 5 February 2014 (2014-02-05) * paragraphs [0124], [0173] - [0211], [0239], [0101], [0304]; figures 2,3 * ----- | 1-15 | INV. C23C14/04 |
| A | EP 4 474 522 A1 (DAINIPPON PRINTING CO LTD [JP]) 11 December 2024 (2024-12-11) * the whole document * ----- | 1-15 | |

**TECHNICAL FIELDS SEARCHED (IPC)**

C23C
H10K
G03F

The present search report has been drawn up for all claims

| Place of search | Date of completion of the search | Examiner |
|---|---|---|
| The Hague | 20 May 2026 | Schafranek, Robert |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...........................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 21 6482

This annex lists the patent family members relating to the patent documents cited in the above-mentioned European search report.
The members are as contained in the European Patent Office EDP file on
The European Patent Office is in no way liable for these particulars which are merely given for the purpose of information.

20-05-2026

| Patent document cited in search report | | Publication date | Patent family member(s) | | Publication date |
|---|---|---|---|---|---|
| EP 2692896 | A1 | 05-02-2014 | CN | 103572246 A | 12-02-2014 |
| | | | CN | 203440443 U | 19-02-2014 |
| | | | EP | 2692896 A1 | 05-02-2014 |
| | | | JP | 6502555 B2 | 17-04-2019 |
| | | | JP | 2014031582 A | 20-02-2014 |
| | | | JP | 2018138701 A | 06-09-2018 |
| | | | KR | 20140017767 A | 12-02-2014 |
| | | | TW | 201410891 A | 16-03-2014 |
| | | | US | 2014033974 A1 | 06-02-2014 |
| EP 4474522 | A1 | 11-12-2024 | CN | 118647753 A | 13-09-2024 |
| | | | EP | 4474522 A1 | 11-12-2024 |
| | | | JP | WO2023145950 A1 | 03-08-2023 |
| | | | KR | 20240144233 A | 02-10-2024 |
| | | | TW | 202346618 A | 01-12-2023 |
| | | | US | 2025154639 A1 | 15-05-2025 |
| | | | WO | 2023145950 A1 | 03-08-2023 |

EPO FORM P0459

For more details about this annex : see Official Journal of the European Patent Office, No. 12/82

**EP 4 768 623 A1**

**Patent documents cited in the description**

- KR 1020240194116